# EUROPEAN PATENT APPLICATION

(11) **EP 4 528 378 A1**
(43) Date of publication of application: **26.03.2025**
(21) Application number: 24195180.5
(22) Date of filing: 19.08.2024
(51) Int. Cl.: G03F 7/09

(54) **COMPOSITION FOR FORMING ORGANIC FILM, METHOD FOR FORMING ORGANIC FILM, AND PATTERNING PROCESS**

(30) Priority: 19.09.2023 JP 2023151659
(71) Applicant: SHIN-ETSU CHEMICAL CO., LTD., Tokyo 1000005 (JP)
(72) Inventor: Niida, Keisuke, Niigata (JP); Yamamoto, Yasuyuki, Niigata (JP)
(74) Representative: Sonnenhauser, Thomas Martin

(57) **Abstract**

The present invention is a composition for forming an organic film, containing: (A) a polymer having a repeating unit represented by the following general formula (1); (B) a resin for forming an organic film; and (C) a solvent, where R₁ represents a divalent organic group having 2 to 30 carbon atoms including an aliphatic moiety or an aromatic moiety, each R₂ independently represents a hydrogen atom, an alkyl group having 1 to 6 carbon atoms, a hydroxy group, an alkoxy group having 1 to 6 carbon atoms, a halogen atom other than a fluorine atom, a cyano group, an amino group, or a nitro group, and "a" represents 0 or 1, "b" representing 1 to 4 and "c" representing 0 to 3 when "a" is 0, or "b" representing 1 to 6 and "c" representing 0 to 5 when "a" is 1. This can provide a composition for forming an organic film having excellent film-formability on a substrate and excellent filling property, and being excellent in hump-suppression at the time of an EBR process.

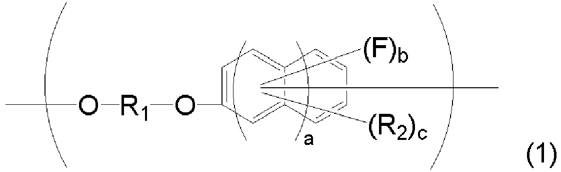

## Description

### TECHNICAL FIELD

The present invention relates to: a composition for forming an organic film; a method for forming an organic film by using the composition; and a patterning process using the composition.

### BACKGROUND ART

Recently, along with advancements toward higher integration and higher processing speed of semiconductor devices, a finer pattern rule has been required. In this situation, various techniques have been developed in regard to how patterning process can be performed more finely and precisely depending on light sources used in lithography with light exposure, which is a commonly-employed technique at present.

As the light source for lithography employed in resist pattern formation, light exposure using a g-line (436 nm) or an i-line (365 nm) of a mercury lamp is widely adopted for portions where the degree of integration is low. Meanwhile, for portions where the degree of integration is high and finer patterning is required, lithography using a KrF excimer laser (248 nm) or an ArF excimer laser (193 nm) with shorter wavelengths has also been practically used. Moreover, for the most-advanced generation requiring further finer patterning, lithography with extreme ultraviolet ray (EUV, 13.5 nm) is about to be put to practical use.

It is well known that in a monolayer resist method, which is employed as a typical resist patterning process, as the thinning of resist patterns progresses as described above, the ratio of a pattern height to a pattern line width (aspect ratio) is increased, and pattern collapse occurs due to the surface tension of a developer during development. It is known that, in this situation, a multilayer resist method, in which a pattern is formed by laminating films having different dry etching properties, is excellent in forming a pattern with a high aspect ratio on an uneven substrate. There have been developed: a two-layer resist method in which a photoresist layer (resist upper layer film) made of a silicon-containing photosensitive polymer is combined with a resist underlayer film made of an organic polymer containing carbon, hydrogen, and oxygen as main constituent elements, for example, a novolak polymer (Patent Document 1); and a three-layer resist method in which a photoresist layer made of an organic photosensitive polymer used in a monolayer resist method is combined with a resist middle layer film made of a silicon-based polymer or a silicon-based CVD film, and a resist underlayer film made of an organic polymer (Patent Document 2).

In the three-layer resist method, for example, an organic film made of a novolak or the like is formed uniformly as a resist underlayer film on a substrate to be processed; a silicon-containing resist middle layer film is formed thereon as a resist middle layer film; and an ordinary organic photoresist film is formed thereon as a resist upper layer film. In dry etching using a fluorine-based gas plasma, an organic resist upper layer film has favorable etching selectivity to a silicon-containing resist middle layer film, and therefore, a resist pattern is transferred to the silicon-containing resist middle layer film by dry etching using a fluorine-based gas plasma. According to this method, the pattern can be transferred to the silicon-containing resist middle layer film even when using a resist composition that causes difficulties in forming a pattern having a sufficient film thickness for directly processing the substrate to be processed or when using a resist composition that does not have sufficient dry etching resistance for processing the substrate. In addition, by subsequently transferring the pattern by dry etching with an oxygen-based gas plasma, it is possible to obtain a pattern in an organic film (e.g. a resist underlayer film such as a novolak film) having sufficient dry etching resistance for processing.

Many techniques are already known (e.g. Patent Document 3) regarding organic films like the organic film described above. However, in association with recent progress in miniaturization, the need for excellent filling property in addition to dry etching property is rising. There is a demand for an organic film material that enables uniform film formation even on an underlying substrate to be processed having a complex form or any material, and that has a filling property that allows a required pattern to be filled without gaps.

When a semiconductor substrate or the like is manufactured, the above-described organic film is formed using a coater/developer that can perform treatments such as spin-coating process, EBR process, and baking process. An EBR (Edge Bead Removal) process is a process of removing, after forming a film on a substrate (wafer) by spin-coating, the film on the edge of the substrate with a remover for the purpose of preventing the contamination of a substrate-conveying arm of the coater/developer. For example, a mixed solution of propylene glycol monomethyl ether acetate and propylene glycol monomethyl ether (30 mass%:70 mass%) is a remover used in EBR processes, and such removers are widely used in EBR processes of resist upper layer films, silicon-containing resist middle layer films, and organic films.

Due to the effect of a remover in an EBR process, a state where a peripheral portion of an organic film has a thick film thickness (a hump) occurs in some cases. In the above-described dry etching step at the time of substrate processing, a hump causes defects, and therefore, an organic film in which a hump is suppressed is desired.

### CITATION LIST

### PATENT LITERATURE

Patent Document 1: JP H06-118651 A
Patent Document 2: JP 2005-128509 A
Patent Document 3: JP 2004-205685 A
Patent Document 4: JP 2000-256550 A
Patent Document 5: JP 2023-87852 A

### NON PATENT LITERATURE

Non Patent Document 1: Diana J. Gerbi et al., "The effect of water on the formation of polyarylethers via phase-transfer-catalyzed nucleophilic aromatic substitution", Journal of Polymer Science: Polymer Letters Edition, Vol. 23, 551-556 (1985)

### SUMMARY OF INVENTION

### TECHNICAL PROBLEM

The present invention has been made in view of the above-described circumstances. An object of the present invention is to provide: a composition for forming an organic film which is excellent in film-formability (in-plane uniformity) on a substrate (wafer) and filling property and is excellent in suppressing humps in an EBR process; a method for forming an organic film, using the composition; and a patterning process.

### SOLUTION TO PROBLEM

To achieve the object, the present invention provides a composition for forming an organic film, comprising:
(A) a polymer having a repeating unit represented by the following general formula (1);
(B) a resin for forming an organic film; and
(C) a solvent, 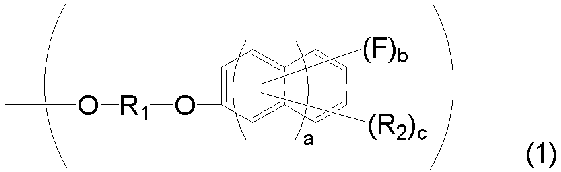
wherein R₁ represents a divalent organic group having 2 to 30 carbon atoms including an aliphatic moiety or an aromatic moiety, each R₂ independently represents a hydrogen atom, an alkyl group having 1 to 6 carbon atoms, a hydroxy group, an alkoxy group having 1 to 6 carbon atoms, a halogen atom other than a fluorine atom, a cyano group, an amino group, or a nitro group, and "a" represents 0 or 1, "b" representing 1 to 4 and "c" representing 0 to 3 when "a" is 0, or "b" representing 1 to 6 and "c" representing 0 to 5 when "a" is 1.

Such a composition for forming an organic film makes it possible to form an organic film that is excellent in-plane uniformity and filling property and that can suppress the formation of a hump due to the effect of a remover in an EBR process.

In the present invention, the polymer (A) preferably contains one or more compounds represented by any of the following general formulae (2) to (4), 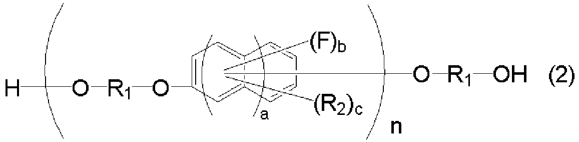 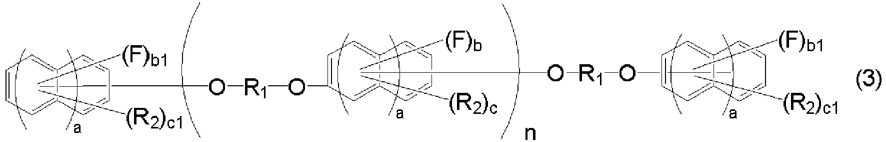 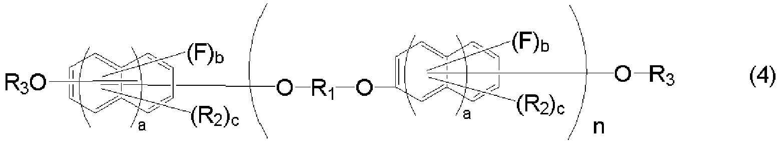 wherein R₁ and R₂ are as defined above; R₃ represents a monovalent organic group having 1 to 30 carbon atoms; "a" represents 0 or 1; "b" representing 1 to 4, "b1" representing 1 to 5, "c" representing 0 to 3, and "c1" representing 0 to 4 when "a" is 0, or "b" representing 1 to 6, "b1" representing 1 to 7, "c" representing 0 to 5, and "c1" representing 0 to 6 when "a" is 1; and "n" represents an average repeating unit number of 3 to 2,000.

A composition for forming an organic film containing such a polymer makes it possible to form an organic film having better in-plane uniformity, and is therefore preferable.

In the present invention, the polymer (A) is preferably contained in an amount of 0.01 parts by mass to 5 parts by mass based on 100 parts by mass of the resin (B) for forming an organic film.

A composition for forming an organic film containing the polymer (A) in such an amount makes it possible to form an organic film having better in-plane uniformity, and is therefore preferable.

The present invention also provides a method for forming an organic film to be used in a manufacturing process of a semiconductor device, the method comprising:
spin-coating a substrate to be processed with the inventive composition for forming an organic film to obtain a coating film; and
forming an organic film by heating the coating film at a temperature of 100°C or higher and 600°C or lower for 10 to 600 seconds to cure the coating film.

According to the inventive method for forming an organic film, a pattern having a complicated shape on a substrate to be processed can be filled by spin-coating, and an organic film that exhibits excellent in-plane uniformity can be formed. In addition, an organic film formed by the inventive method for forming an organic film allows an edge portion to be removed while suppressing the formation of a hump in an EBR process, and therefore, is particularly useful when an EBR process is to be performed.

The present invention also provides a patterning process comprising:
forming an organic film on a body to be processed by using the inventive composition for forming an organic film;
forming a silicon-containing resist middle layer film on the organic film by using a silicon-containing resist middle layer film material;
forming a resist upper layer film on the silicon-containing resist middle layer film by using a resist upper layer film material comprising a photoresist composition;
forming a circuit pattern in the resist upper layer film;
transferring the pattern to the silicon-containing resist middle layer film by etching while using the resist upper layer film having the formed circuit pattern as a mask;
transferring the pattern to the organic film by etching while using the silicon-containing resist middle layer film having the transferred pattern as a mask; and
further forming the pattern in the body to be processed by etching while using the organic film having the transferred pattern as a mask.

The present invention also provides a patterning process comprising:
forming an organic film on a body to be processed by using the inventive composition for forming an organic film;
forming a silicon-containing resist middle layer film on the organic film by using a silicon-containing resist middle layer film material;
forming an organic antireflective film or an adhesive film on the silicon-containing resist middle layer film;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and to the silicon-containing resist middle layer film by etching while using the resist upper layer film having the formed circuit pattern as a mask;
transferring the pattern to the organic film by etching while using the silicon-containing resist middle layer film having the transferred pattern as a mask; and
further forming the pattern in the body to be processed by etching while using the organic film having the transferred pattern as a mask.

The present invention also provides a patterning process comprising:
forming an organic film on a body to be processed by using the inventive composition for forming an organic film;
forming an inorganic hard mask middle layer film selected from the group consisting of a silicon oxide film, a silicon nitride film, and a silicon oxynitride film on the organic film;
forming a resist upper layer film on the inorganic hard mask middle layer film by using a resist upper layer film material comprising a photoresist composition;
forming a circuit pattern in the resist upper layer film;
transferring the pattern to the inorganic hard mask middle layer film by etching while using the resist upper layer film having the formed circuit pattern as a mask;
transferring the pattern to the organic film by etching while using the inorganic hard mask middle layer film having the transferred pattern as a mask; and
further forming the pattern in the body to be processed by etching while using the organic film having the transferred pattern as a mask.

The present invention also provides a patterning process comprising:
forming an organic film on a body to be processed by using the inventive composition for forming an organic film;
forming an inorganic hard mask middle layer film selected from the group consisting of a silicon oxide film, a silicon nitride film, and a silicon oxynitride film on the organic film;
forming an organic antireflective film or an adhesive film on the inorganic hard mask middle layer film;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and to the inorganic hard mask middle layer film by etching while using the resist upper layer film having the formed circuit pattern as a mask;
transferring the pattern to the organic film by etching while using the inorganic hard mask middle layer film having the transferred pattern as a mask; and
further forming the pattern in the body to be processed by etching while using the organic film having the transferred pattern as a mask.

As described, the inventive composition for forming an organic film can be used suitably in various patterning processes such as a three-layer resist process using a silicon-containing resist middle layer film or an inorganic hard mask middle layer film and a four-layer resist process additionally using an organic antireflective film or an adhesive film. According to such patterning processes of the present invention, it is possible to transfer and form a circuit pattern of a resist upper layer film in a body to be processed with high accuracy.

In this event, the inorganic hard mask middle layer film is preferably formed by a CVD method or an ALD method.

In the inventive patterning process, the inorganic hard mask middle layer film can be formed by such methods, for example.

In the present invention, the circuit pattern is preferably formed by a lithography using light having a wavelength of 10 nm or more and 300 nm or less, a direct writing with electron beam, nanoimprinting, or a combination thereof.

In the present invention, the circuit pattern is preferably developed with an alkaline development or an organic solvent.

In the inventive patterning process, such means of forming and developing the circuit pattern can be used suitably, for example.

In the present invention, the body to be processed is preferably a semiconductor device substrate or the semiconductor device substrate coated with any of a metal film, a metal carbide film, a metal oxide film, a metal nitride film, a metal oxycarbide film, and a metal oxynitride film.

In this case, the metal constituting the body to be processed preferably contains silicon, titanium, tungsten, hafnium, zirconium, chromium, germanium, copper, silver, gold, aluminum, indium, gallium, arsenic, palladium, iron, tantalum, iridium, molybdenum, or an alloy thereof.

According to the inventive patterning process, such a body to be processed can be processed to form a pattern.

### ADVANTAGEOUS EFFECTS OF INVENTION

As described above, according to the present invention, it is possible to provide a composition for forming an organic film having excellent film-formability (in-plane uniformity) on a substrate (wafer) and excellent filling property, and being excellent in hump-suppression at the time of an EBR process.

Furthermore, according to the inventive method for forming an organic film, it is possible to form an organic film that can suppress the formation of humps, and therefore, it is possible to manufacture semiconductor devices etc. efficiently.

Furthermore, such a composition of the present invention for forming an organic film has excellent film-formability, an excellent filling property, and an excellent property of suppressing humps that are generated during an EBR process, and therefore, is extremely useful as: for example, a material for forming an organic film used in multilayer resist processes, such as a two-layer resist process, a three-layer resist process using a silicon-containing resist middle layer film or an inorganic hard mask middle layer film, or a four-layer resist process using a silicon-containing resist middle layer film or inorganic hard mask middle layer film and an organic antireflective film or adhesive film; or a material for forming an organic film for manufacturing a semiconductor device.

### BRIEF DESCRIPTION OF DRAWINGS

FIG. 1 is an explanatory diagram of an example of the inventive patterning process according to a three-layer resist process.
FIG. 2 is an example of a graph on measuring the height of a hump by using a stylus profiler in each of Example 1 and Comparative Example 1.
FIG. 3 is another example of a graph on measuring the height of a hump by using a stylus profiler in Comparative Example 1.
FIG. 4 is an explanatory diagram of a filling property evaluation method in the Examples.

### DESCRIPTION OF EMBODIMENTS

As described above, there has been required the development of: a composition for forming an organic film with which it is possible to form an organic film having excellent film-formability (in-plane uniformity) on a substrate (wafer) and excellent filling property and which can suppress the formation of humps during an EBR process; a method for forming an organic film, using the composition; and a patterning process, using the composition.

Usually, when an organic film is to be formed, a resin for forming an organic film and additives are dissolved in an organic solvent to form a composition, the composition is applied with a coater and a developer onto a substrate on which a structure, a circuit, etc. is formed, the composition is spread by the substrate rotating, the composition on the edge is removed in an EBR process, and then the composition is baked to form an organic film.

It is thought that if the flowability of the composition is insufficient, gaps are generated when a hole or trench having a very high aspect ratio is filled, and in addition, a hump is generated in the periphery of the organic film if the resin for forming an organic film or the additives have poor solubility in the remover used in the EBR process.

The present inventors have studied earnestly further and found out that when a polymer having a particular repeating unit is contained in a composition for forming an organic film, the composition has excellent film-formability and high filling property and allows excellent hump suppression property during an EBR process. Thus, the present invention has been completed.

That is, the present invention is a composition for forming an organic film, comprising:
(A) a polymer having a repeating unit represented by the following general formula (1);
(B) a resin for forming an organic film; and
(C) a solvent, 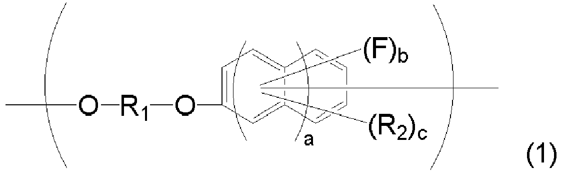
wherein R₁ represents a divalent organic group having 2 to 30 carbon atoms including an aliphatic moiety or an aromatic moiety, each R₂ independently represents a hydrogen atom, an alkyl group having 1 to 6 carbon atoms, a hydroxy group, an alkoxy group having 1 to 6 carbon atoms, a halogen atom other than a fluorine atom, a cyano group, an amino group, or a nitro group, and "a" represents 0 or 1, "b" representing 1 to 4 and "c" representing 0 to 3 when "a" is 0, or "b" representing 1 to 6 and "c" representing 0 to 5 when "a" is 1.

It should be noted that, although Patent Documents 4 and 5 and Non Patent Document 1 disclose a polymer or resin containing an ether structure in a repeating unit, there is no description or suggestion in these documents of a composition for forming an organic film containing (A) a polymer having a repeating unit represented by the general formula (1), (B) a resin for forming an organic film, and (C) a solvent.

Hereinafter, the present invention will be described in detail, but the present invention is not limited thereto.

### [Composition for Forming Organic Film]

The inventive composition for forming an organic film contains: (A) a polymer having a repeating unit represented by the following general formula (1); (B) a resin for forming an organic film; and (C) a solvent.

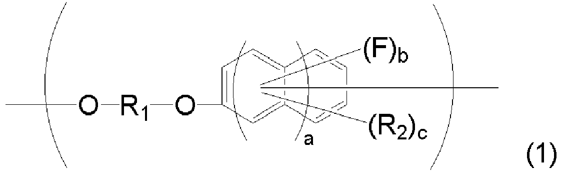

In the general formula (1), R₁ represents a divalent organic group having 2 to 30 carbon atoms including an aliphatic moiety or an aromatic moiety, each R₂ independently represents a hydrogen atom, an alkyl group having 1 to 6 carbon atoms, a hydroxy group, an alkoxy group having 1 to 6 carbon atoms, a halogen atom other than a fluorine atom, a cyano group, an amino group, or a nitro group, and "a" represents 0 or 1, "b" representing 1 to 4 and "c" representing 0 to 3 when "a" is 0, or "b" representing 1 to 6 and "c" representing 0 to 5 when "a" is 1.

Note that in the inventive composition for forming an organic film, as the polymer (A), the resin (B) for forming an organic film, and the solvent (C), one kind of compound of each may be contained or a combination of two or more kinds may be contained.

Here, an "organic group" in the present invention means a "group containing at least one carbon atom", and the group may further contain a hydrogen atom and may also contain a nitrogen atom, an oxygen atom, a sulfur atom, a silicon atom, a halogen atom, etc.

In the following, each of the polymer (A), the resin (B) for forming an organic film, and the solvent (C), which are essential components of the inventive composition for forming an organic film, will be described in detail.

### [(A) Polymer]

The polymer (A) contained in the inventive composition for forming an organic film has a repeating unit represented by the general formula (1).

In the general formula (1), R₁ represents a divalent organic group having 2 to 30 carbon atoms including an aliphatic moiety or an aromatic moiety. In the polymer (A), R₁ may be of a single kind or multiple kinds of R₁ may be present in mixture. Examples of the R₁ include the following.

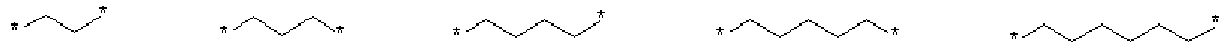

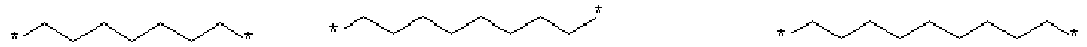

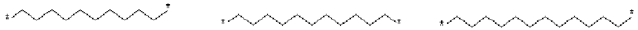

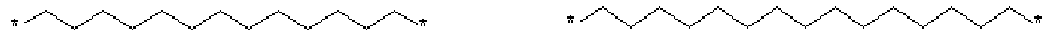

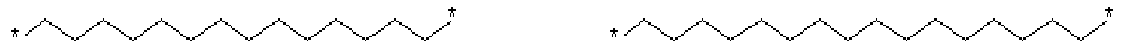

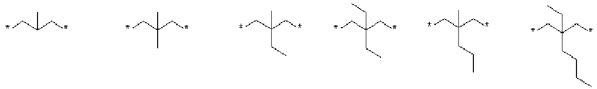

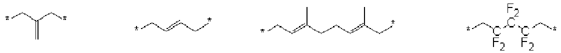

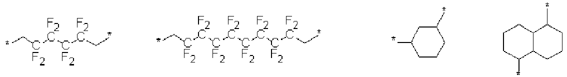

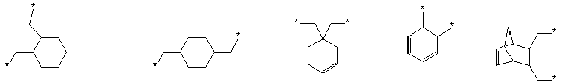

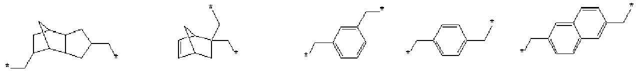

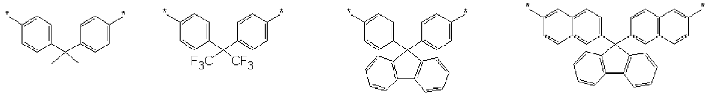

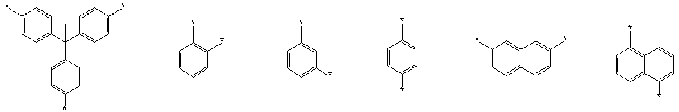

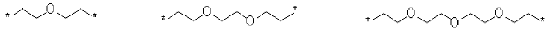

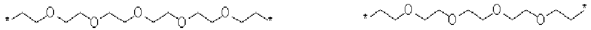

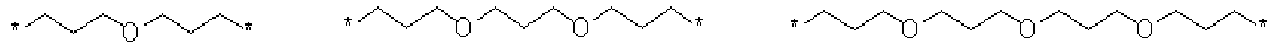

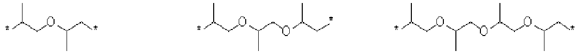

In the formulae, "*" represents an attachment point to the oxygen atom.

In the general formula (1), each R₂ independently represents a hydrogen atom, an alkyl group having 1 to 6 carbon atoms, a hydroxy group, an alkoxy group having 1 to 6 carbon atoms, a halogen atom other than a fluorine atom (preferably a chlorine atom, a bromine atom, or an iodine atom), a cyano group, an amino group, or a nitro group. In the polymer (A), R₂ may be of a single kind or multiple kinds of R₂ may be present in mixture.

In the general formula (1), "a" represents 0 or 1. That is, the repeating unit that the polymer (A) has contains a benzene ring moiety or a naphthalene ring moiety. When "a" is 0, "b" represents 1 to 4 and "c" represents 0 to 3. When "a" is 1, "b" represents 1 to 6 and "c" represents 0 to 5. As described, regardless of the value of "a", "b" is 1 or greater. That is, the repeating unit contained in the polymer (A) contains fluorine.

From another aspect, it can also be said that the repeating unit represented by the general formula (1) contains a moiety represented by -O-R₁-O- and a fluorine-containing benzene ring moiety or a fluorine-containing naphthalene ring moiety.

The inventive composition for forming an organic film, which contains such a polymer (A) containing the repeating unit represented by the general formula (1) together with the resin (B) for forming an organic film and the solvent (C), makes it possible to adjust the surface tension of the composition for forming an organic film and can also enhance the compatibility of the polymer (A) to the solvent. In this way, the inventive composition for forming an organic film makes it possible to form, by spin-coating, an organic film excellent in in-plane uniformity and also excellent in filling property. Furthermore, the inventive composition for forming an organic film can suppress the formation of humps at the time of an EBR process.

Furthermore, the polymer (A) preferably contains one or more compounds (polymers) represented by any of the following general formulae (2) to (4).

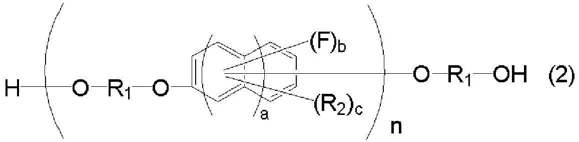

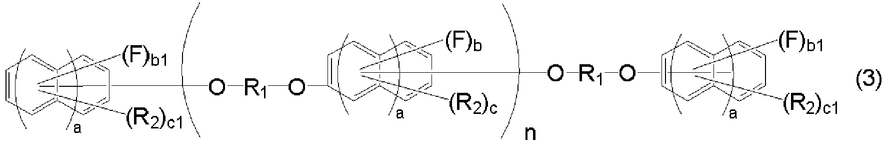

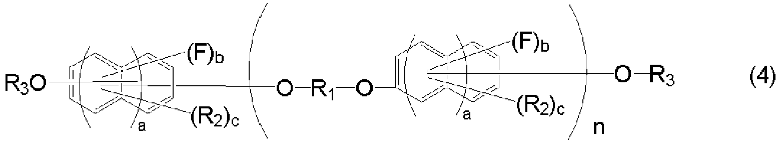

In the formulae, R₁ and R₂ are as defined above; R₃ represents a monovalent organic group having 1 to 30 carbon atoms; "a" represents 0 or 1; "b" representing 1 to 4, "b1" representing 1 to 5, "c" representing 0 to 3, and "c1" representing 0 to 4 when "a" is 0, or "b" representing 1 to 6, "b1" representing 1 to 7, "c" representing 0 to 5, and "c1" representing 0 to 6 when "a" is 1; and "n" represents an average repeating unit number of 3 to 2,000.

The R₁ in the general formulae (2) to (4) represents a divalent organic group having 2 to 30 carbon atoms including an aliphatic moiety or an aromatic moiety, may be saturated or unsaturated, and may have an ether bond. R₁ may be of one kind or multiple kinds thereof may coexist, and examples include the following. In particular, those having a glyme chain are preferable from the viewpoint of surface tension control.

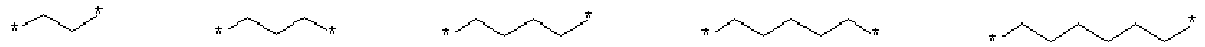

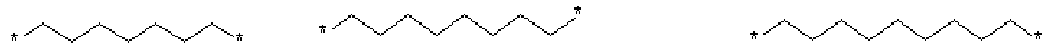

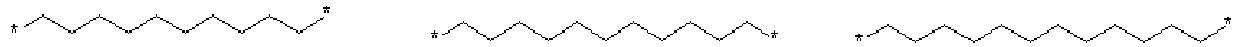

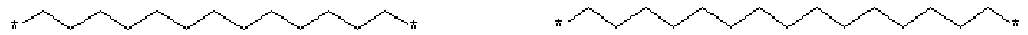

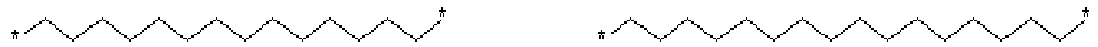

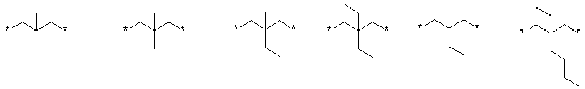

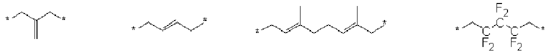

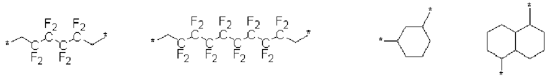

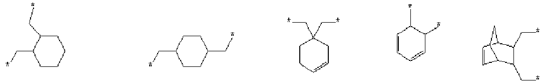

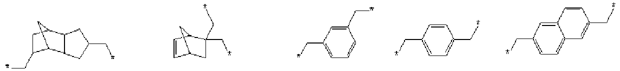

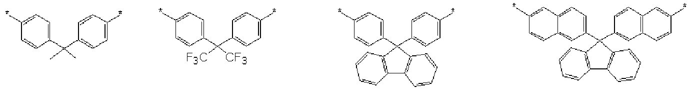

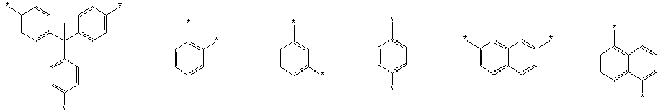

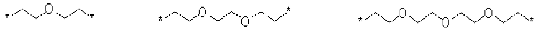

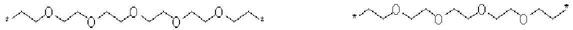

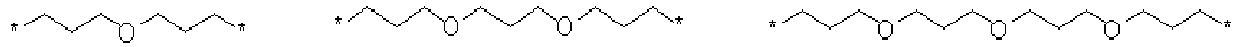

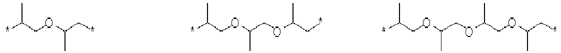

In the formulae, "*" represents an attachment point to the oxygen atom.

The R₂ in the general formulae (2) to (4) each independently represents, as described above, a hydrogen atom, an alkyl group having 1 to 6 carbon atoms, a hydroxy group, an alkoxy group having 1 to 6 carbon atoms, a halogen atom other than a fluorine atom (preferably a chlorine atom, a bromine atom, or an iodine atom), a cyano group, an amino group, or a nitro group.

In the general formula (4), R₃ represents a monovalent organic group having 1 to 30 carbon atoms. Specific examples include a methyl group, an ethyl group, a vinyl group, a 2,2,2-trifluoroethyl group, a propyl group, an isopropyl group, an allyl group, a 1-propenyl group, an isopropenyl group, a butyl group, an s-butyl group, a t-butyl group, an isobutyl group, a pentyl group, a cyclopentyl group, a hexyl group, a cyclohexyl group, a cyclohexenyl group, a decyl group, a dodecyl group, an icosanyl group, a norbornyl group, an adamantyl group, a phenyl group, a toluyl group, a xylyl group, a naphthyl group, a phenanthrenyl group, an anthracenyl group, a benzyl group, a fluorenyl group, a naphthylmethyl group, a norbornenyl group, triacontyl group, a 2-furanyl group, a 2-tetrahydrofuranyl group, an anisyl group, an acryloyl group, a methacryloyl group, an acetyl group, etc. When the R₃ has an aromatic ring, the aromatic ring may have a substituent thereon, and examples of the substituent include: halogen groups, such as fluorine, chlorine, bromine, and iodine; alkyloxy groups, such as a methoxy group and an ethoxy group; alkenyloxy groups, such as an allyloxy group; alkynyloxy groups, such as a propargyloxy group; etc. A hydrogen atom on a methylene contained in these alkylene groups may be substituted with a fluorine atom.

When the polymer (A) contains such a structure, the surface tension of the composition for forming an organic film can be adjusted more sufficiently, and in addition, the compatibility of the polymer (A) to the solvent (C) can be further enhanced. As a result, the composition for forming an organic film according to this favorable embodiment makes it possible to form, by spin-coating, an organic film having better in-plane uniformity. It is also possible to make adjustments to achieve a desired property by adjusting appropriately multiple structures and terminal structures of the R₁.

"n" represents an average repeating unit number of 3 to 2,000, preferably 3 to 500, more preferably 5 to 300.

The polymer (A) may have only one kind of repeating unit as the repeating unit represented by the general formula (1), or may have a combination of two or more kinds of repeating units.

Specific examples of repeating units represented by the general formula (1) include the following, but are not limited thereto.

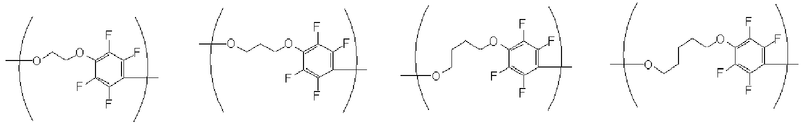

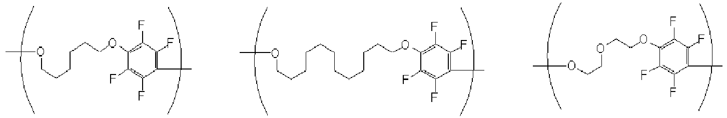

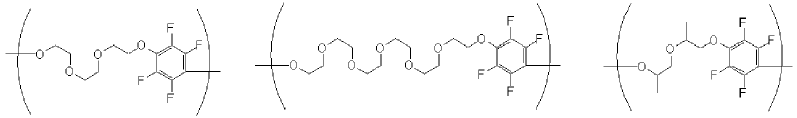

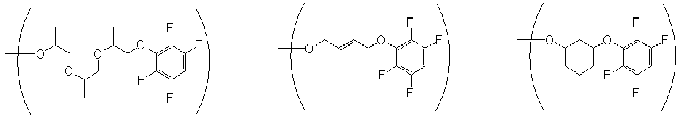

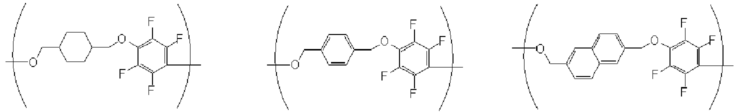

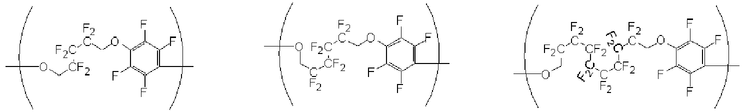

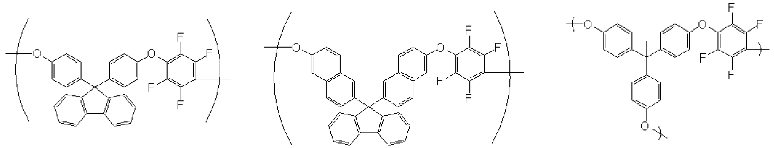

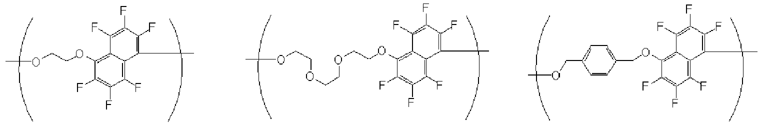

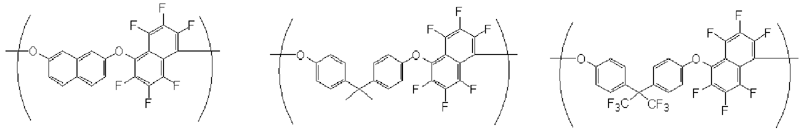

Specific examples of the polymer (A) represented by the general formula (2) include the following, but are not limited thereto. Note that in the following, "n" is not shown, but the following polymers each contain the above-described "n" of the repeating units in the parentheses.

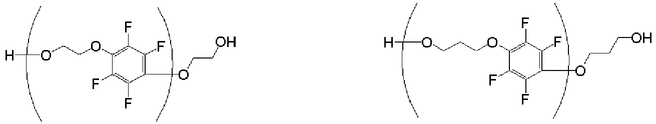

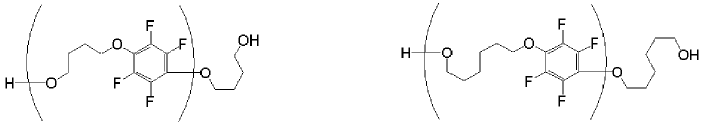

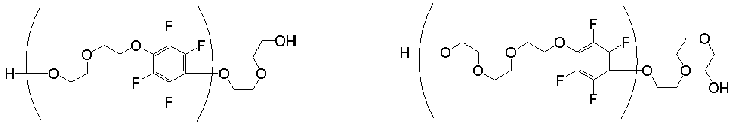

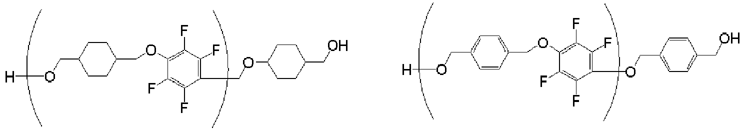

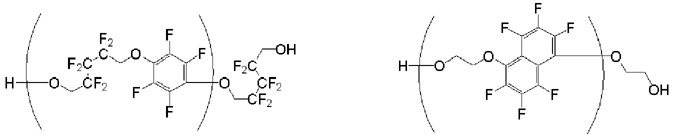

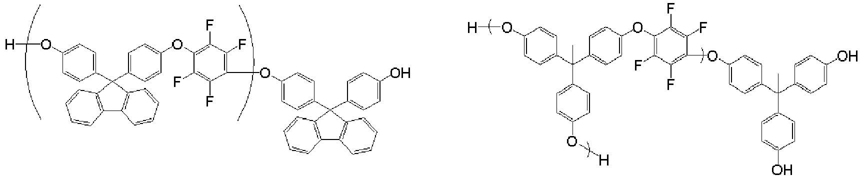

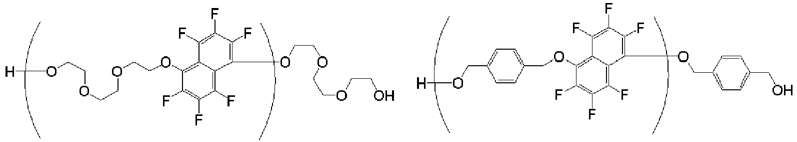

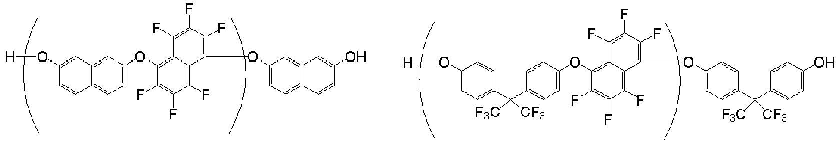

Specific examples of the polymer (A) represented by the general formula (3) include the following, but are not limited thereto. Note that in the following, "n" is not shown, but the following polymers each contain the above-described "n" of the repeating units in the parentheses.

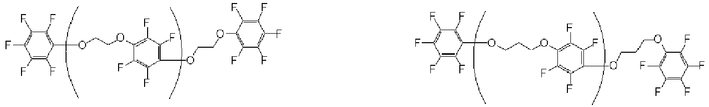

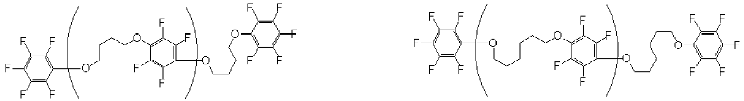

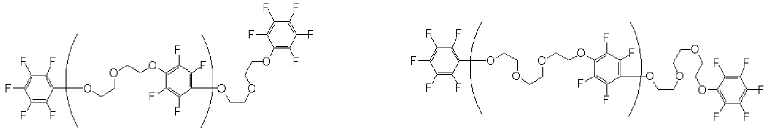

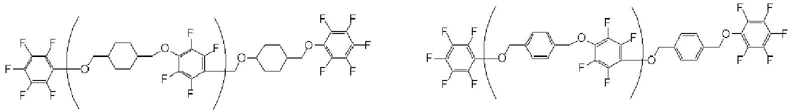

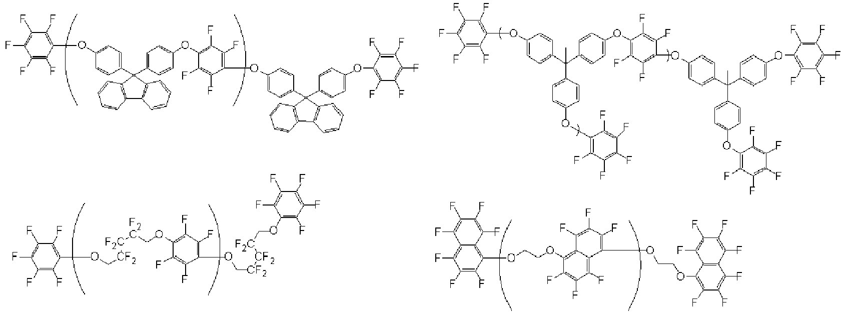

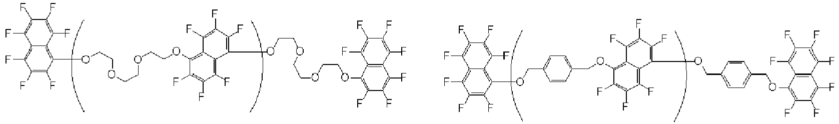

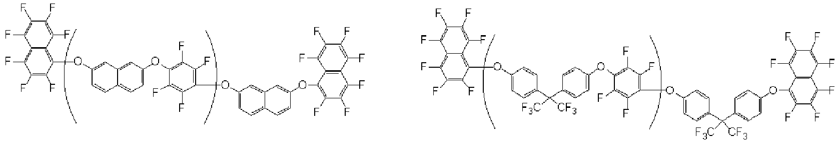

Specific examples of the polymer (A) represented by the general formula (4) include the following, but are not limited thereto. Note that in the following, "n" is not shown, but the following polymers each contain the above-described "n" of the repeating units in the parentheses.

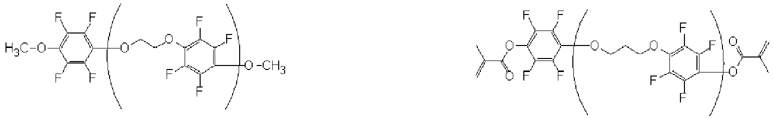

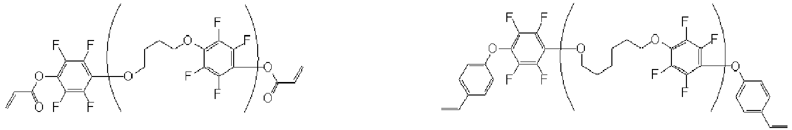

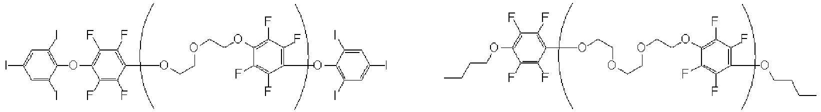

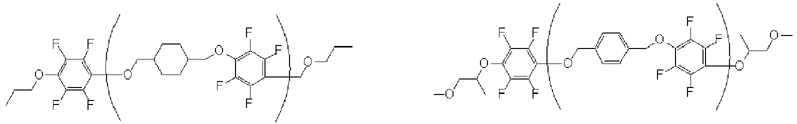

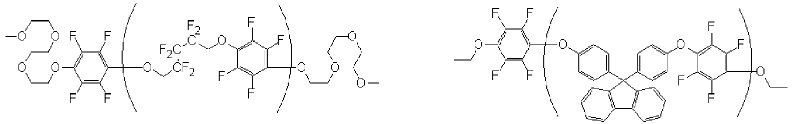

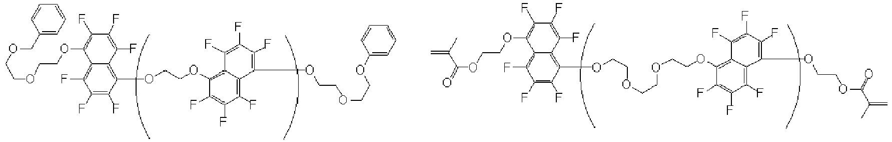

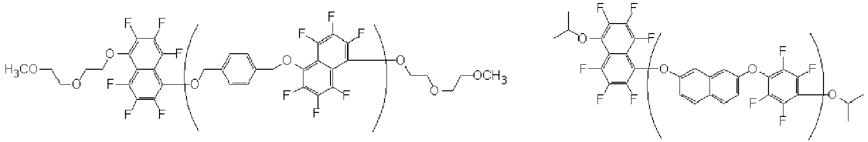

The properties of the polymer (A) can be adjusted as necessary by the choice of the structures of the R₁, R₂, and R₃. In particular, it is possible to control the polarity of the polymer (A) to adjust film-formability and solvent solubility thereof.

The polymer (A) preferably has a weight-average molecular weight of 300 to 200,000, more preferably 300 to 50,000, and further preferably 500 to 40,000. The average number "n" of repeating units is preferably 3 to 2,000, further preferably 3 to 500. When the polymer (A) has a weight-average molecular weight of 300 or more, it is possible to suppress sufficiently the degradation of a blending effect due to volatilization and so forth, and a sufficient blending effect can be achieved. Meanwhile, when the polymer (A) has a weight-average molecular weight of 200,000 or less, there is no risk of flowability being degraded and so forth, and it is possible to achieve a composition for forming an organic film having excellent filling and planarizing properties. The weight-average molecular weight of the polymer (A) can be determined, for example, as a weight-average molecular weight (Mw) measured in terms of polystyrene by gel permeation chromatography (GPC) using tetrahydrofuran as an eluent (solvent).

Examples of a method for manufacturing a polymer having a repeating unit represented by the general formula (1) include a method, shown below, of obtaining a polymer by an etherification reaction or the like between hexafluorobenzene or octafluoronaphthalene and a diol having R₁ as a partial structure in the presence of a base catalyst.

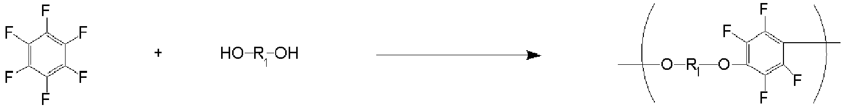

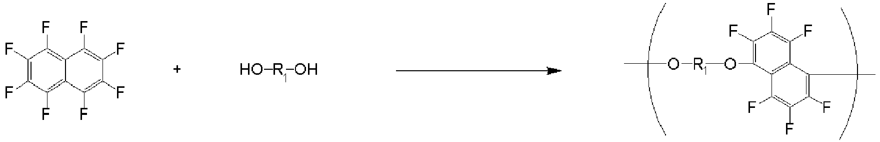

In the formulae, R₁ is as defined above.

Examples of the base catalyst of the etherification reaction shown above include: inorganic basic compounds, such as sodium hydrogen carbonate, sodium carbonate, potassium carbonate, calcium carbonate, cesium carbonate, sodium hydroxide, potassium hydroxide, sodium hydride, and potassium phosphate; and organic amine compounds, such as triethylamine, pyridine, and N-methylmorpholine. One of these base catalysts may be used or a combination of two or more kinds thereof may be used. The catalyst is preferably used in an amount of 0.1 to 20 mol, more preferably 0.2 to 10 mol, relative to the hydroxy groups, which are substituents of the raw material.

A solvent used in this event is not particularly limited as long as the solvent is inactive to the reaction. Examples thereof include: ether solvents, such as diethyl ether, tetrahydrofuran, and dioxane; aromatic solvents, such as benzene, toluene, and xylene; acetonitrile; dimethyl sulfoxide; N,N-dimethylformamide; N-methylpyrrolidone; and water. One of these solvents may be used, or a mixture of two or more kinds thereof may be used. These solvents can be used within a range of 0 to 2,000 parts by mass relative to 100 parts by mass of the reaction raw material. The reaction temperature is preferably from -50°C to approximately the boiling point of the solvent, further preferably room temperature to 150°C. The reaction time is appropriately selected from 0.1 to 100 hours, for example.

If necessary, the obtained polymer can be purified by a conventional method, such as liquid-liquid separation, crystallization, concentration under reduced pressure, dialysis, and ultrafiltration, depending on the properties of the polymer. Furthermore, if necessary, the metal content can be reduced by passing the polymer through a commercially available demetallization filter.

Examples of methods for the reaction include: a method in which hexafluorobenzene or octafluoronaphthalene and a diol are charged in a solvent at once; a method in which each of or a mixture of hexafluorobenzene or octafluoronaphthalene and a diol is dispersed or dissolved, and the resultant is charged by adding dropwise; a method in which one of hexafluorobenzene or octafluoronaphthalene and a diol is dispersed or dissolved in a solvent, and then the other, dispersed or dissolved in a solvent, is charged by adding dropwise; etc. In addition, in a case where multiple kinds of diol are charged, the diols may be mixed together beforehand and then subjected to a reaction, or the diols may be subjected to a reaction individually in succession. In a case where a catalyst is used, examples of methods include: a method in which the catalyst is charged at once with the hexafluorobenzene or octafluoronaphthalene and the diol; a method in which the catalyst is dispersed or dissolved beforehand, and then added dropwise; etc. After completion of the reaction, the reaction product may be diluted in an organic solvent in order to remove unreacted raw materials, the catalyst, etc. present in the system, and then a crystal may be precipitated by liquid-liquid separation washing or with a poor solvent and obtained as a powder. Alternatively, after the dilution in the organic solvent, solvent substitution to a desired organic solvent may be performed, and the polymer may be collected as a solution. Furthermore, the polymer may also be dissolved in a desired organic solvent and collected as a solution after being collected as a powder by crystallization or the like.

The organic solvent used when the liquid-liquid separation washing is performed is not particularly limited, as long as it is capable of dissolving the target product and being separated into two layers when mixed with water. Examples of the organic solvent include: hydrocarbons, such as hexane, heptane, benzene, toluene, and xylene; esters, such as ethyl acetate, n-butyl acetate, and propylene glycol methyl ether acetate; ketones, such as methyl ethyl ketone, methyl amyl ketone, cyclohexanone, and methyl isobutyl ketone; ethers, such as diethyl ether, diisopropyl ether, methyl-tert-butyl ether, and ethylcyclopentylmethyl ether; chlorinated solvents, such as methylene chloride, chloroform, dichloroethane, and trichloroethylene; mixtures thereof; and the like. As the water used for washing in this event, generally, what is called deionized water or ultrapure water may be used. The washing may be performed once or more, preferably approximately once to five times, because washing ten times or more does not always produce the full washing effects thereof.

In the liquid-liquid separation washing, the washing may be performed with a basic aqueous solution to remove acidic components in the system. Specific examples of the base include hydroxides of alkaline metals, carbonates of alkaline metals, hydroxides of alkali earth metals, carbonates of alkali earth metals, ammonia, organic ammonium, etc.

Further, in the liquid-liquid separation washing, the washing may be performed with an acidic aqueous solution to remove metal impurities or basic components in the system. Specific examples of the acid include: inorganic acids, such as hydrochloric acid, hydrobromic acid, sulfuric acid, nitric acid, phosphoric acid, and heteropoly acid; organic acids, such as oxalic acid, fumaric acid, maleic acid, trifluoroacetic acid, methanesulfonic acid, benzenesulfonic acid, p-toluenesulfonic acid, and trifluoromethanesulfonic acid; etc.

The liquid-liquid separation washing may be performed with any one of the basic aqueous solution and the acidic aqueous solution, or can be performed with a combination of the two. The liquid-liquid separation washing is preferably performed with the basic aqueous solution and the acidic aqueous solution in this order from the viewpoint of removing the metal impurities.

After the liquid-liquid separation washing with the basic aqueous solution and/or acidic aqueous solution, washing with neutral water may be successively performed. This washing may be performed once or more, preferably approximately once to five times. As the neutral water, deionized water, ultrapure water, or the like mentioned above may be used. The washing may be performed once or more, but if the washing is not performed sufficiently, the basic components and the acidic components may not be removed in some cases. The washing is performed preferably approximately once to five times because washing ten times or more does not always produce the full washing effects.

Further, the reaction product after the liquid-liquid separation operation can also be collected as a powder by concentrating and drying of the solvent under reduced pressure or normal pressure or by crystallizing the reaction product. Alternatively, the reaction product can be retained in a solution state with an appropriate concentration to improve the workability in preparing a composition for forming an organic film. The concentration at this point is preferably 0.1 to 50 mass%, more preferably 0.5 to 30 mass%. With such a concentration, the viscosity is hardly increased, preventing degradation of the workability; in addition, since the amount of the solvent is not excessive, the solution can be prepared economically.

The solvent in this event is not particularly limited, as long as it is capable of dissolving the reaction product. Specific examples of the solvent include: ketones, such as cyclohexanone and methyl-2-amyl ketone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate. One of these can be used or a mixture of two or more thereof can be used.

The polymer represented by the general formula (2) or (3) can be manufactured easily by, for example, adjusting the proportion of the hexafluorobenzene or octafluoronaphthalene and the diol having R₁ as a partial structure to be charged. Specifically, when the number of moles of the hexafluorobenzene or octafluoronaphthalene to be charged is "x" and the number of moles of the diol having R₁ as a partial structure to be charged is "y", in the case of the synthesis of the polymer represented by the general formula (2), the charging ratio of the diol having R₁ as a partial structure to the hexafluorobenzene or octafluoronaphthalene can be made high, that is, the charging ratio can be x < y. In this case, an unreacted alcohol can be retained on an end by allowing the diol component to be excessive. Similarly, in the case of the synthesis of the polymer represented by the general formula (3), the charging ratio of the hexafluorobenzene or octafluoronaphthalene to the diol having R₁ as a partial structure can be made high, that is, the charging ratio can be x > y. In this case, the polymer is end-capped with hexafluorobenzene or octafluoronaphthalene.

### [Method for Manufacturing Polymer Represented by General Formula (2): Case Where Charging Ratio Is x < y]

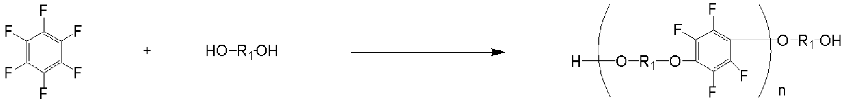

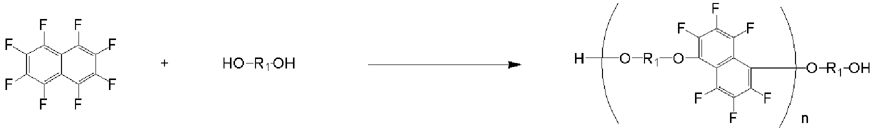

In the formulae, R₁ and "n" are as defined above.

### [Method for Manufacturing Polymer Represented by General Formula (3): Case Where Charging Ratio Is x > y]

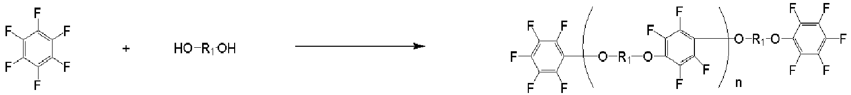

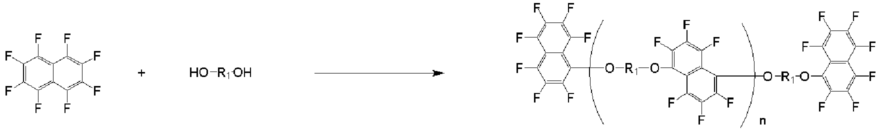

In the formulae, R₁ and "n" are as defined above.

Furthermore, in the case of the synthesis of the compound represented by the general formula (4), there is, for example, a method of further etherifying an end of the polymer represented by the general formula (3) with an alcohol or carboxylic acid having R₃ as a substituent. Alternatively, there is a method of etherifying a diol having R₁ as a partial structure and an alcohol or carboxylic acid having R₃ as a substituent, and hexafluorobenzene or octafluoronaphthalene at once. When the ingredients are charged at once, it is necessary to control the charging ratio strictly, and from an industrial aspect, the preferable method is the method of manufacturing the polymer represented by the general formula (3), and then end-capping the polymer with an alcohol or carboxylic acid having R₃ as a substituent.

### [End-Capping Polymer Represented by General Formula (3)]

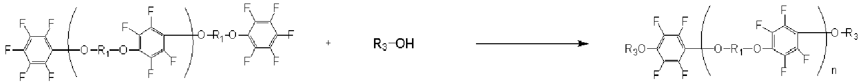

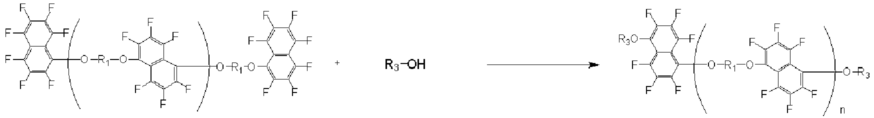

In the formulae, R₁, R₃, and "n" are as defined above.

### [Charging at Once]

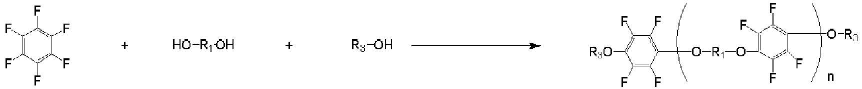

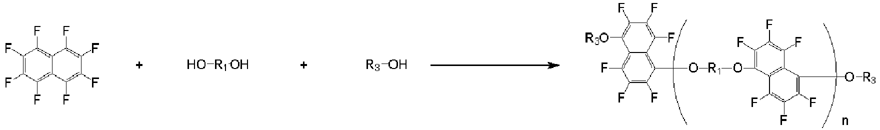

In the formulae, R₁, R₃, and "n" are as defined above.

The methods for manufacturing the polymer represented by the general formula (2) and the polymer represented by the general formula (3) can be performed according to the methods described in the method for manufacturing the polymer having the repeating unit represented by (1) described above just by adjusting the charging ratio of the hexafluorobenzene or octafluoronaphthalene and the diol having R₁ as a partial structure in accordance with the desired structure. The reaction method and the method for collecting the polymer can be performed according to the methods described in the method for manufacturing the polymer having the repeating unit represented by the general formula (1) described above.

Regarding the method for manufacturing the polymer represented by the general formula (4), when the ingredients are to be charged at once, the method can be performed according to the manufacturing method, reaction method and polymer-collecting method for the polymer having the repeating unit represented by the general formula (1), except that the alcohol or carboxylic acid having R₃ as a substituent is additionally used simultaneously with the diol having R₁ as a partial structure. When the end-capping of the polymer represented by the general formula (3) is to be performed, the following methods are possible: a method in which, after once collecting the polymer represented by the general formula (3), the alcohol or carboxylic acid having R₃ as a substituent is allowed to react in the same manner as in the method for manufacturing the polymer having the repeating unit represented by the general formula (1); and a method in which the reaction with the diol having R₁ as a partial structure is completed at the time of the reaction when manufacturing the polymer represented by the general formula (3), and then the alcohol or carboxylic acid, having R₃ as a substituent, to be used for end-capping is charged, thus, performing the reaction in one pot. Either reaction method can be performed according to the manufacturing method, reaction method, and method for collecting the polymer having the repeating unit represented by the general formula (1), except that the substances are different.

### [(B) Resin for Forming Organic Film]

The resin (B) for forming an organic film contained in the inventive composition for forming an organic film is not particularly limited as long as the resin is a resin or compound that has sufficient film-formability in spin-coating and curability. From the viewpoints of etching resistance, optical characteristics, heat resistance, etc., a resin or compound including an aromatic skeleton is preferable.

Examples of the aromatic skeleton include benzene, naphthalene, anthracene, pyrene, indene, fluorene, furan, pyrrole, thiophene, phosphole, pyrazole, oxazole, isoxazole, thiazole, pyridine, pyrazine, pyrimidine, pyridazine, triazine, carbazole, etc. In particular, benzene, naphthalene, fluorene, and carbazole are particularly preferable.

Examples of the resin (B) for forming an organic film used in the present invention include resins containing the following structures, disclosed in JP 2012-001687 A and JP 2012-077295 A. 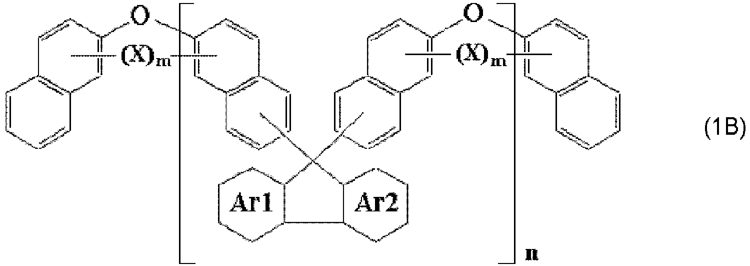 In the formula (1B), the cyclic structures Ar1 and Ar2 each independently represent a benzene ring or a naphthalene ring. X represents a single bond or an alkylene group having 1 to 20 carbon atoms. "m" represents 0 or 1. "n" represents any natural number that provides a molecular weight of 100,000 or less. Note that the definitions of the symbols in the formula apply only in this formula. 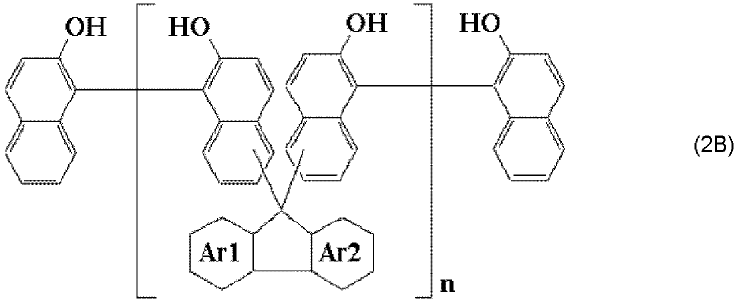 In the formula (2B), the cyclic structures Ar1 and Ar2 each independently represent a benzene ring or a naphthalene ring. "n" represents any natural number that provides a weight-average molecular weight of 100,000 or less as measured by gel permeation chromatography in terms of polystyrene. Note that the definitions of the symbols in the formula apply only in this formula.

Further examples of the resin (B) for forming an organic film used in the present invention include resins containing the following structures, disclosed in JP 2004-264710 A, JP 2005-043471 A, JP 2005-250434 A, JP 2007-293294 A, and JP 2008-065303 A. 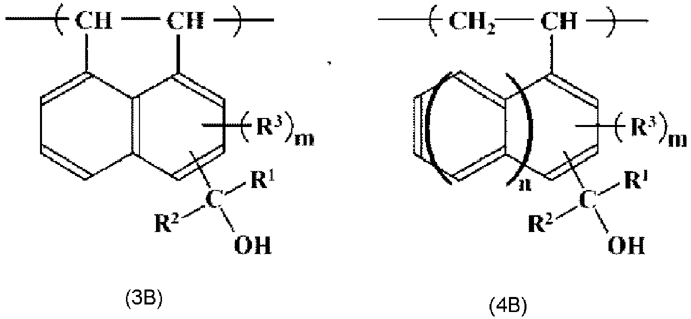 In the formula (3B) and the formula (4B), R¹ and R² each independently represent a hydrogen atom, an alkyl group having 1 to 3 carbon atoms, or an aryl group; R³ represents an alkyl group having 1 to 3 carbon atoms, a vinyl group, an allyl group, or an aryl group that is optionally substituted; "n" represents 0 or 1; and "m" represents 0, 1, or 2. Note that the definitions of the symbols in the formulae apply only in these formulae.

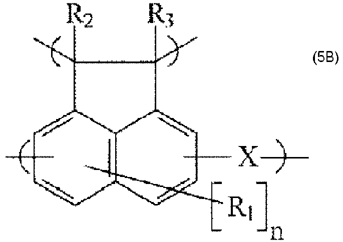

In the formula (5B), R₁ represents a monovalent atom other than a hydrogen atom or a monovalent group; and "n" represents an integer of 0 to 4. Here, when "n" is 2 to 4, the multiple R₁'s may be identical to or different from each other. R₂ and R₃ each independently represent a monovalent atom or group. X represents a divalent group. Note that the definitions of the symbols in the formula apply only in this formula. 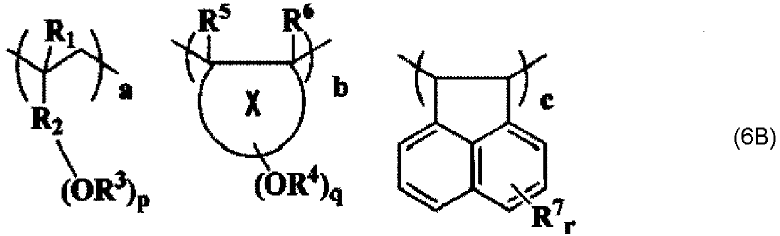 In the formula (6B), R₁ represents a hydrogen atom or a methyl group. R₂ represents a single bond, a linear, branched, or cyclic alkylene group having 1 to 20 carbon atoms, or an arylene group having 6 to 10 carbon atoms, and may have any of ether, ester, lactone, and amide. R³ and R⁴ each represent a hydrogen atom or a glycidyl group. X represents any polymer of a hydrocarbon including an indene skeleton, a cycloolefin having 3 to 10 carbon atoms, and maleimide, and may have any of ether, ester, lactone, and carboxylic anhydride. R⁵ and R⁶ each represent a hydrogen atom, a fluorine atom, a methyl group, or a trifluoromethyl group. R⁷ represents a hydrogen atom, a linear, branched, or cyclic alkyl group having 1 to 6 carbon atoms, a hydroxy group, or an alkoxycarbonyl group. "p" and "q" each represent an integer of 1 to 4. "r" represents an integer of 0 to 4. "a", "b", and "c" each satisfy 0.5 ≤ a+b+c ≤ 1, 0 ≤ a ≤ 0.8, 0 ≤ b ≤ 0.8, 0.1 ≤ a+b ≤ 0.8, and 0.1 ≤ c ≤ 0.8. Note that the definitions of the symbols in the formula apply only in this formula. 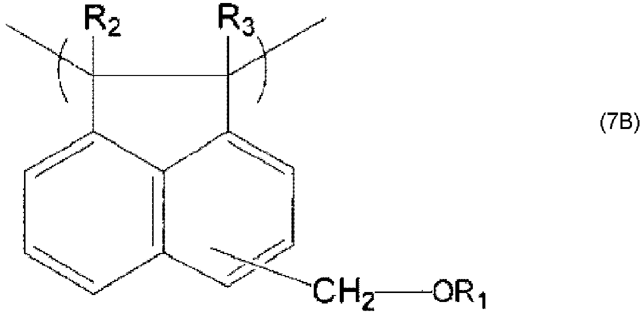 In the formula (7B), R₁ represents a hydrogen atom or a monovalent organic group; and R₂ and R₃ each independently represent a monovalent atom or a monovalent organic group. Note that the definitions of the symbols in the formula apply only in this formula.

Specific examples of the resin (B) for forming an organic film used in the present invention also include resins containing the following structures, disclosed in JP 2004-205685 A, JP 2007-171895 A, and JP 2009-014816 A.

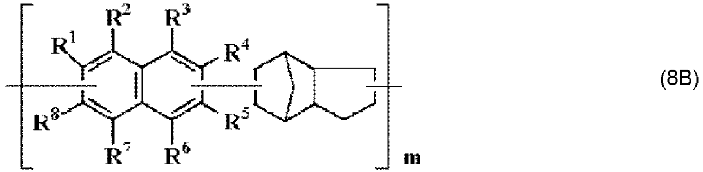

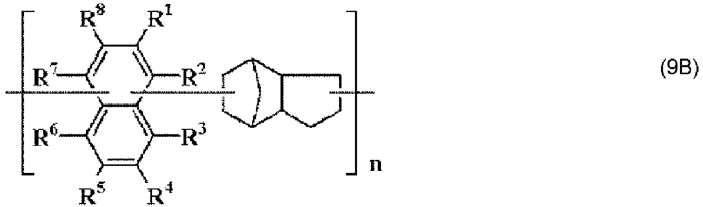

In the formula (8B) and the formula (9B), R¹ to R⁸ each independently represent a hydrogen atom, a hydroxy group, an alkyl group having 1 to 6 carbon atoms and optionally being substituted, an alkoxy group having 1 to 6 carbon atoms and optionally being substituted, an alkoxycarboxy group having 2 to 6 carbon atoms and optionally being substituted, an aryl group having 6 to 10 carbon atoms and optionally being substituted, a hydroxyalkyl group having 1 to 6 carbon atoms, an isocyanate group, or a glycidyl group. "m" and "n" each represent a positive integer. Note that the definitions of the symbols in the formulae apply only in these formulae.

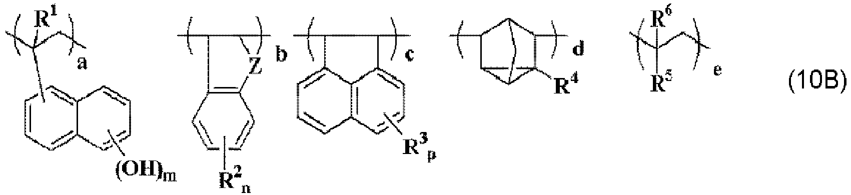

In the formula (10B), R¹ and R⁶ each independently represent a hydrogen atom or a methyl group. R², R³, and R⁴ each independently represent a hydrogen atom, an alkyl group having 1 to 4 carbon atoms, an alkoxy group, a hydroxy group, an acetoxy group, an alkoxycarbonyl group, or an aryl group having 6 to 10 carbon atoms; R⁵ represents a condensed polycyclic hydrocarbon group having 13 to 30 carbon atoms, -O-R⁷, -C(=O)-O-R⁷, -O-C(=O)-R⁷, or -C(=O)-NR⁸-R⁷; "m" represents 1 or 2; "n" represents an integer of 0 to 4; and "p" represents an integer of 0 to 6. R⁷ represents an organic group having 7 to 30 carbon atoms; R⁸ represents a hydrogen atom or a hydrocarbon group having 1 to 6 carbon atoms. Z represents a methylene group, -O-, -S-, or -NH-. "a", "b", "c", "d", and "e" each satisfy 0 < a < 1.0, 0 ≤ b ≤ 0.8, 0 ≤ c ≤ 0.8, 0 ≤ d ≤ 0.8, 0 ≤ e ≤ 0.8, and 0 < b+c+d+e < 1.0. Note that the definitions of the symbols in the formula apply only in this formula.

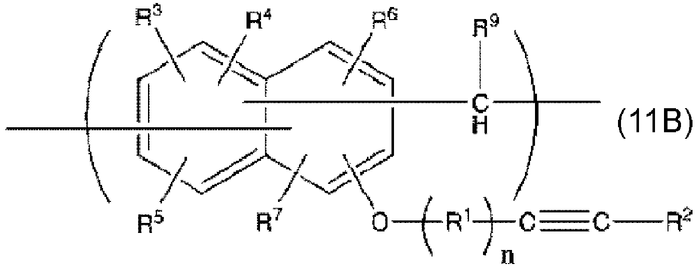

In the formula (11B), "n" represents 0 or 1. R¹ represents a methylene group that is optionally substituted, an alkylene group having 2 to 20 carbon atoms and optionally being substituted, or an arylene group having 6 to 20 carbon atoms and optionally being substituted. R² represents a hydrogen atom, an alkyl group having 1 to 20 carbon atoms and optionally being substituted, or an aryl group having 6 to 20 carbon atoms and optionally being substituted. R³ to R⁷ each independently represent a hydroxy group, an alkyl group having 1 to 6 carbon atoms and optionally being substituted, an alkoxy group having 1 to 6 carbon atoms and optionally being substituted, an alkoxycarbonyl group having 2 to 10 carbon atoms and optionally being substituted, an aryl group having 6 to 14 carbon atoms and optionally being substituted, or a glycidyl ether group having 2 to 6 carbon atoms and optionally being substituted. R⁹ represents a hydrogen atom, a linear, branched, or cyclic alkyl group having 1 to 10 carbon atoms, a linear, branched, or cyclic alkyl ether group having 1 to 10 carbon atoms, or an aryl group having 6 to 10 carbon atoms. Note that the definitions of the symbols in the formula apply only in this formula.

Examples of the resin represented by the formula (11B) include the following resins.

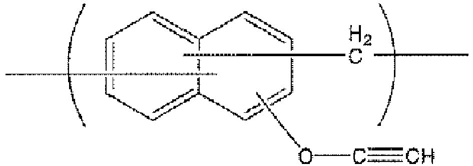

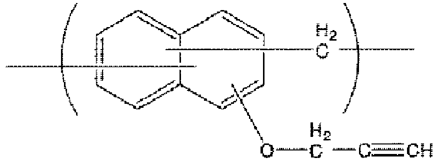

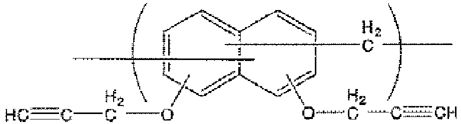

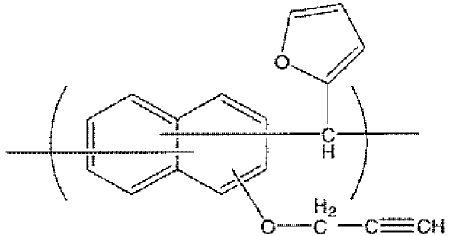

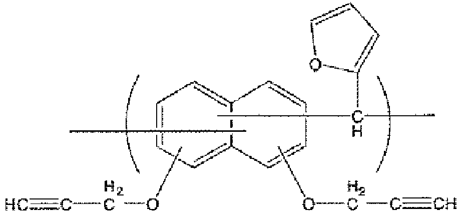

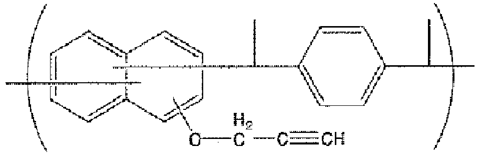

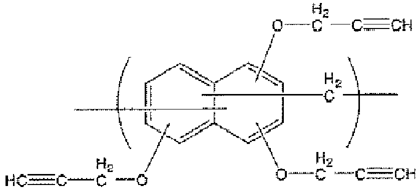

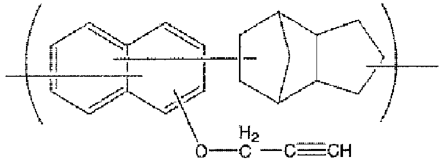

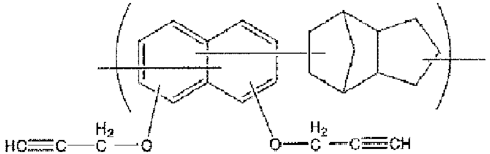

Examples of the resin (B) for forming an organic film used in the present invention also include resins containing the following structures, disclosed in JP 2007-199653 A, JP 2008-274250 A, and JP 2010-122656 A. 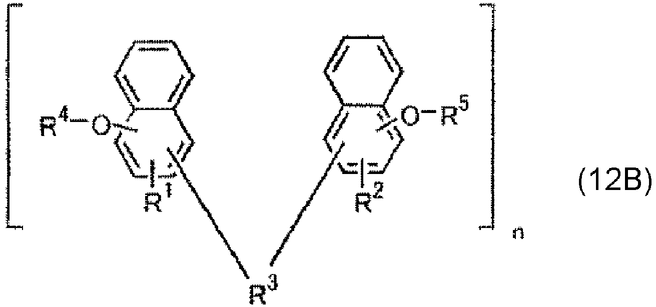 In the formula (12B), R¹ and R² are identical to or different from each other and each independently represent a hydrogen atom, a linear, branched, or cyclic alkyl group having 1 to 10 carbon atoms, an aryl group having 6 to 10 carbon atoms, or an alkenyl group having 2 to 10 carbon atoms; R³ represents a single bond or a linear, branched, or cyclic alkylene group having 1 to 30 carbon atoms, and optionally has a bridged cyclic hydrocarbon group, a double bond, a heteroatom, or an aromatic group having 6 to 30 carbon atoms; R⁴ and R⁵ each independently represent a hydrogen atom or a glycidyl group; and "n" represents an integer of 1 to 4. Note that the definitions of the symbols in the formula apply only in this formula.

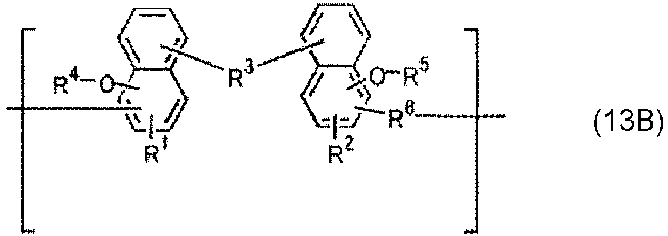

In the formula (13B), R¹ and R² are identical to or different from each other and each independently represent a hydrogen atom, a linear, branched, or cyclic alkyl group having 1 to 10 carbon atoms, an aryl group having 6 to 10 carbon atoms, or an alkenyl group having 2 to 10 carbon atoms; R³ represents a single bond or a linear, branched, or cyclic alkylene group having 1 to 30 carbon atoms, and optionally has a bridged cyclic hydrocarbon group, a double bond, a heteroatom, or an aromatic group having 6 to 30 carbon atoms; R⁴ and R⁵ each independently represent a hydrogen atom or a glycidyl group; and R⁶ represents a single bond or a linear or branched alkylene group having 1 to 10 carbon atoms. Note that the definitions of the symbols in the formula apply only in this formula.

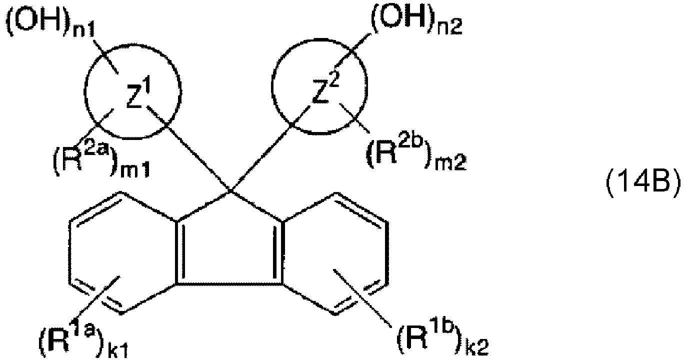

In the formula (14B), the ring Z¹ and the ring Z² each represent a condensed polycyclic aromatic hydrocarbon ring; and R^{1a}, R^{1b}, R^{2a}, and R^{2b} are identical to or different from each other and each represent a substituent. "k1" and "k2" may be identical to or different from each other and each represent 0 or an integer of 1 to 4; "m1" and "m2" each independently represent 0 or an integer of 1 or more; and "n1" and "n2" each independently represent 0 or an integer of 1 or more. Here, n1+n2 ≥ 1. Note that the definitions of the symbols in the formula apply only in this formula.

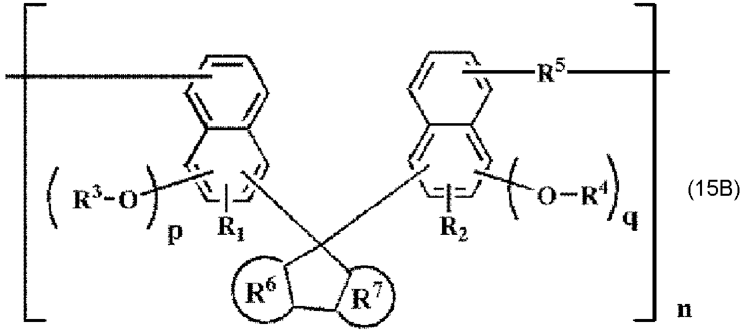

In the formula (15B), R₁ and R₂ are identical to or different from each other, and each represent a hydrogen atom, a linear, branched, or cyclic alkyl group having 1 to 10 carbon atoms, an aryl group having 6 to 10 carbon atoms, or an alkenyl group having 2 to 10 carbon atoms. R³ and R⁴ each independently represent a hydrogen atom or a glycidyl group; R⁵ represents a single bond or a linear or branched alkylene group having 1 to 10 carbon atoms; and R⁶ and R⁷ each independently represent a benzene ring or a naphthalene ring. "p" and "q" each independently represent 1 or 2. "n" satisfies 0 < n ≤ 1. Note that the definitions of the symbols in the formula apply only in this formula.

Examples of the resin represented by the formula (15B) include the following resins.

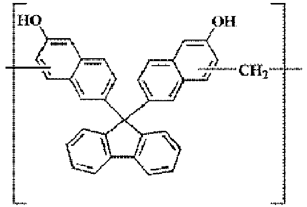

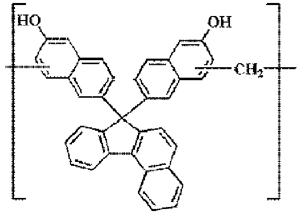

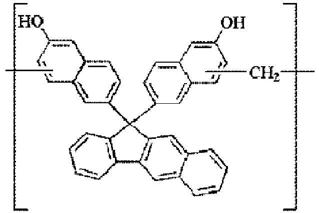

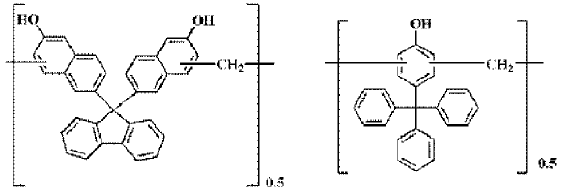

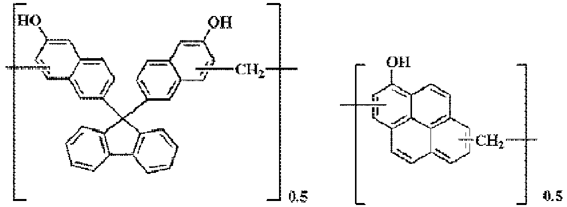

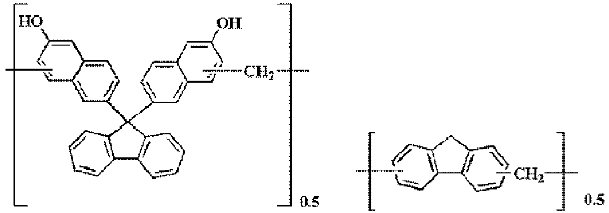

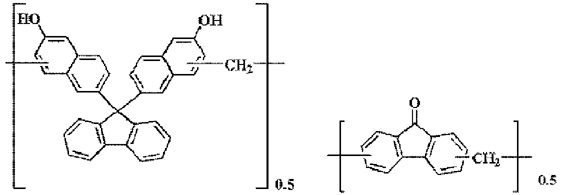

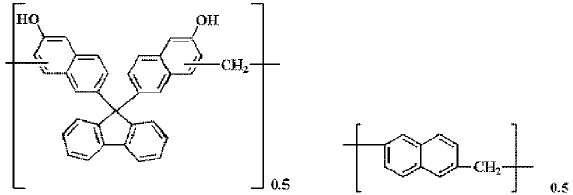

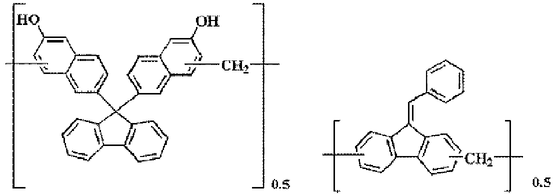

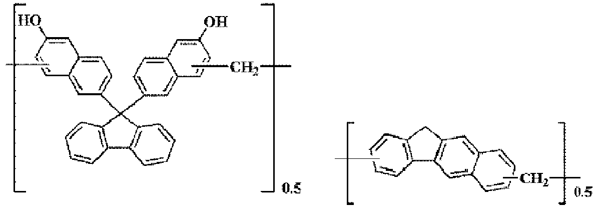

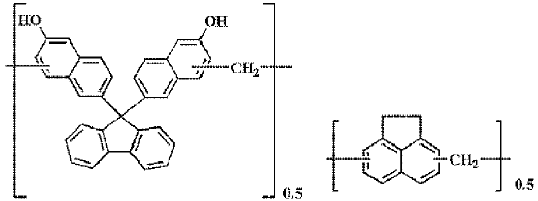

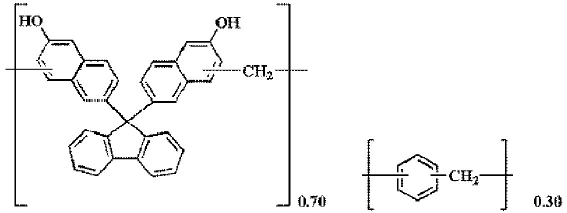

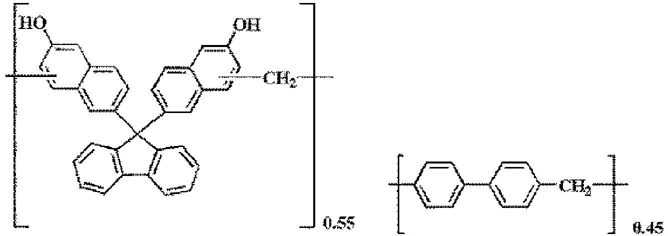

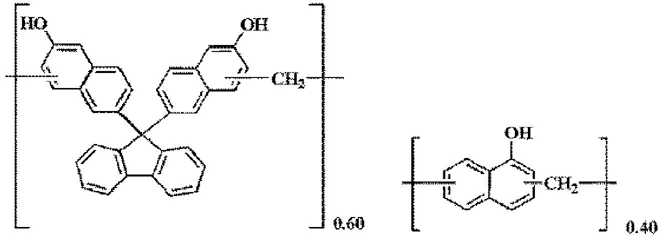

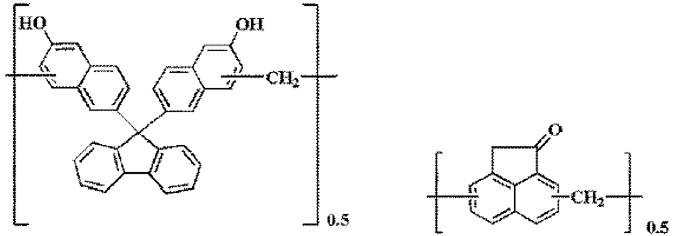

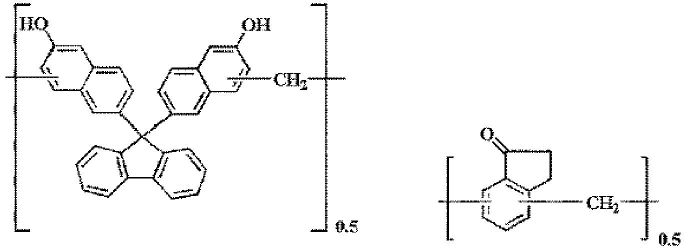

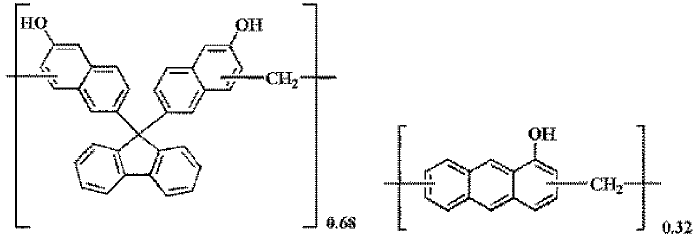

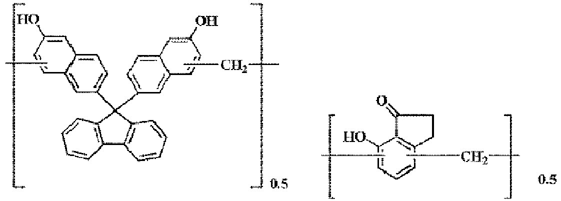

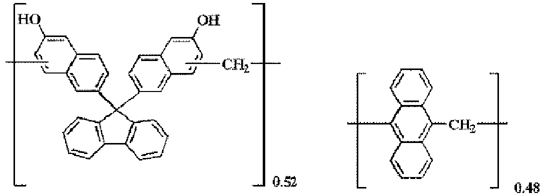

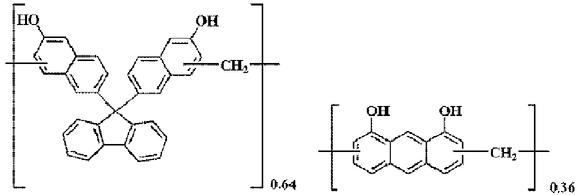

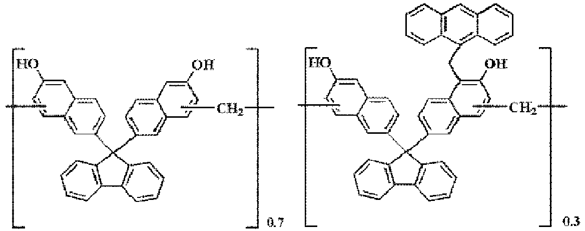

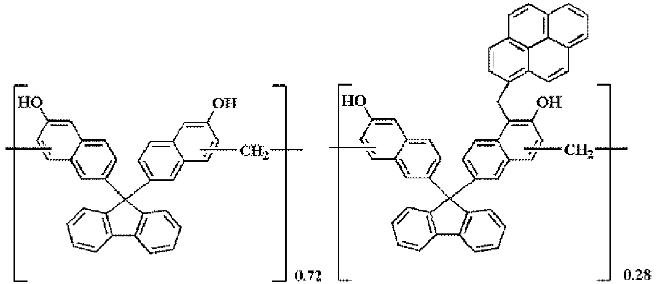

Examples of the resin (B) for forming an organic film used in the present invention also include resins containing the following structure, disclosed in JP 2012-214720 A.

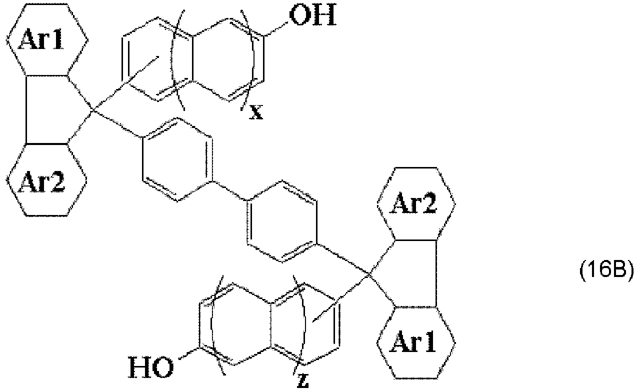

In the formula (16B), the cyclic structures Ar1 and Ar2 each independently represent a benzene ring or a naphthalene ring. "x" and "z" each independently represent 0 or 1. Note that the definitions of the symbols in the formula apply only in this formula.

Examples of the resin (B) for forming an organic film used in the present invention also include resins disclosed in JP 2014-029435 A.

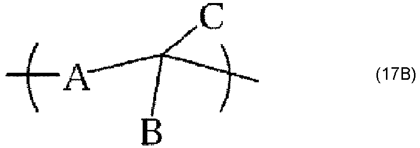

In the formula (17B), A represents a structure having carbazole, B represents a structure having an aromatic ring, and C represents a hydrogen atom, an alkyl group, or a structure having an aromatic ring, B and C optionally constituting a ring with each other. One to four carboxyl groups, a salt thereof, or a carboxylic acid ester group is contained in the structure of A, B, and C combined. Note that the definitions of the symbols in the formula apply only in this formula.

Examples of the resin (B) for forming an organic film used in the present invention also include polymers disclosed in WO 2012/077640 A1, the polymers containing a unit structure represented by the following formula (18B) and a unit structure represented by the following formula (19B), where the ratio of the unit structure represented by the formula (18B) to the unit structure represented by the formula (19B) is 3 to 97 : 97 to 3 by molar ratio.

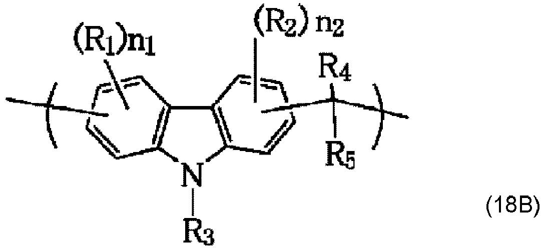

In the formula (18B), R₁ and R₂ each independently represent a hydrogen atom, a halogen atom, a nitro group, an amino group, a hydroxy group, an alkyl group having 1 to 10 carbon atoms, an alkenyl group having 2 to 10 carbon atoms, an aryl group having 6 to 40 carbon atoms, or a combination of the groups, optionally including an ether bond, a ketone bond, or an ester bond. R₃ represents a hydrogen atom, an alkyl group having 1 to 10 carbon atoms, an alkenyl group having 2 to 10 carbon atoms, an aryl group having 6 to 40 carbon atoms, or a combination of the groups, optionally including an ether bond, a ketone bond, or an ester bond. R₄ represents a hydrogen atom, or an aryl group or heterocyclic group having 6 to 40 carbon atoms and optionally being substituted with a halogen atom, a nitro group, an amino group, or a hydroxy group; R₅ represents a hydrogen atom, or an alkyl group having 1 to 10 carbon atoms, aryl group having 6 to 40 carbon atoms, or heterocyclic group optionally substituted with a halogen atom, a nitro group, an amino group or a hydroxy group; and R₄ and R₅ may form a ring with each other. "n1" and "n2" each independently represent an integer of 1 to 3. Note that the definitions of the symbols in the formula apply only in this formula.

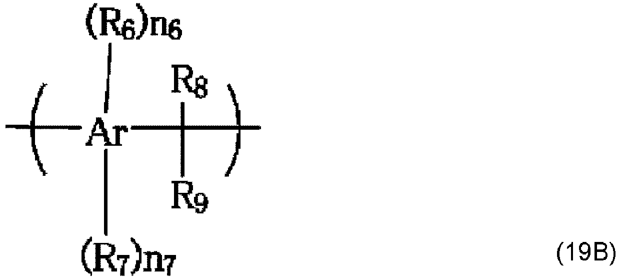

In the formula (19B), Ar represents an aromatic ring group having 6 to 20 carbon atoms; R₆ represents a hydroxy group; and R₇ represents a hydrogen atom, a halogen atom, a nitro group, an amino group, an alkyl group having 1 to 10 carbon atoms, an alkenyl group having 2 to 10 carbon atoms, an aryl group having 6 to 40 carbon atoms, or a combination of the groups, optionally including an ether bond, a ketone bond, or an ester bond. R₈ represents a hydrogen atom, or an aryl group or heterocyclic group having 6 to 40 carbon atoms and optionally substituted with a halogen atom, a nitro group, an amino group, or a hydroxy group; R₉ represents a hydrogen atom, or an alkyl group having 1 to 10 carbon atoms, an aryl group having 6 to 40 carbon atoms, or a heterocyclic group optionally substituted with a halogen atom, a nitro group, an amino group, or a hydroxy group; and R₈ and R₉ may form a ring with each other. "n6" represents an integer of 1 to "p", "n7" represents an integer of p-n6. Here, "p" is the maximum number of substituents with which the aromatic ring group Ar can be substituted. Note that the definitions of the symbols in the formula apply only in this formula.

Examples of the resin (B) for forming an organic film used in the present invention also include polymers containing a unit structure represented by the following formula (20B), disclosed in WO 2010/147155 A1.

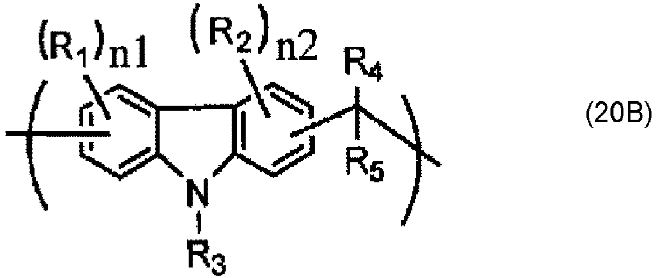

In the formula (20B), R₁ and R₂ are each independently selected from the group consisting of a hydrogen atom, a halogen group, a nitro group, an amino group, a hydroxy group, alkyl groups having 1 to 10 carbon atoms, alkenyl groups having 2 to 10 carbon atoms, aryl groups having 6 to 40 carbon atoms, and combinations thereof, the alkyl groups, the alkenyl groups, or the aryl groups optionally containing an ether bond, a ketone bond, or an ester bond; R₃ is selected from the group consisting of a hydrogen atom, alkyl groups having 1 to 10 carbon atoms, alkenyl groups having 2 to 10 carbon atoms, aryl groups having 6 to 40 carbon atoms, and combinations thereof, the alkyl groups, the alkenyl groups, or the aryl groups optionally containing an ether bond, a ketone bond, or an ester bond; R₄ represents an aryl group or heterocyclic group having 6 to 40 carbon atoms and optionally substituted with a halogen group, a nitro group, an amino group, or a hydroxy group; R₅ represents a hydrogen atom or an alkyl group having 1 to 10 carbon atoms or an aryl group or heterocyclic group having 6 to 40 carbon atoms and optionally substituted with a halogen group, a nitro group, an amino group, or a hydroxy group; R₄ and R₅ optionally form a ring together with the carbon atom bonded to R₄ and R₅; and "n1" and "n2" each independently represent an integer of 1 to 3. Note that the definitions of the symbols in the formula apply only in this formula.

Examples of the resin (B) for forming an organic film used in the present invention also include: novolak resins obtained by a reaction between one or more phenols, such as phenol, cresol, xylenol, catechol, resorcinol, hydroquinone, pyrogallol, hydroxyquinol, and phloroglucinol, and one or more aldehyde sources, such as formaldehyde, paraformaldehyde, and trioxane, in the presence of an acid catalyst; and resins containing a repeating unit structure represented by the following formula (21B), disclosed in WO 2012/176767 A1.

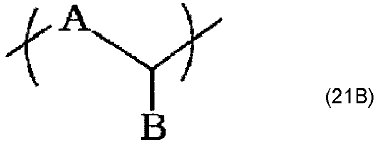

In the formula (21B), A represents a hydroxy group-substituted phenylene group derived from polyhydroxybenzene; and B represents a monovalent condensed aromatic hydrocarbon ring group in which two to six benzene rings are condensed. Note that the definitions of the symbols in the formula apply only in this formula.

Examples of the resin (B) for forming an organic film used in the present invention also include novolak resins having a fluorene or tetrahydrospirobiindene structure, disclosed in JP 2005-128509 A, JP 2006-259249 A, JP 2006-259482 A, JP 2006-293298 A, and JP 2007-316282 A; and resins containing a repeating unit structure represented by the following formula (22B-1) or (22B-2).

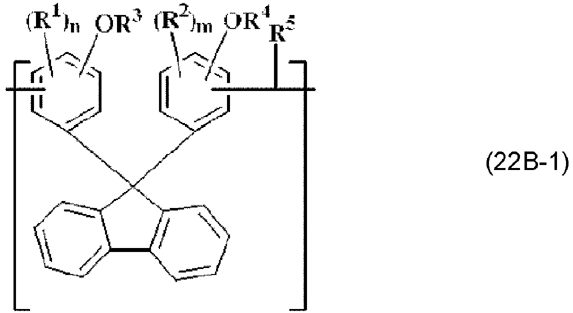

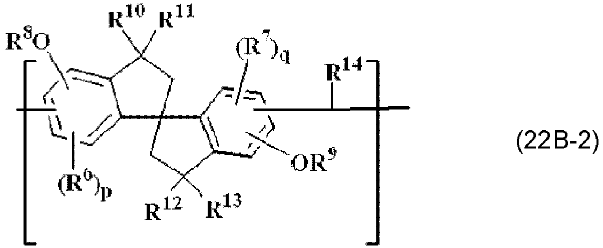

In the formula (22B-1) and the formula (22B-2), R¹, R², R⁶, and R⁷ each independently represent a hydrogen atom, a linear, branched, or cyclic alkyl group having 1 to 10 carbon atoms, an aryl group having 6 to 10 carbon atoms, an allyl group, or a halogen atom; R³, R⁴, R⁸, and R⁹ each independently represent a hydrogen atom, a linear, branched, or cyclic alkyl group having 1 to 6 carbon atoms, a linear, branched, or cyclic alkenyl group having 2 to 6 carbon atoms, an aryl group having 6 to 10 carbon atoms, or a glycidyl group; and R⁵ and R¹⁴ each independently represent a hydrogen atom, a linear, branched, or cyclic alkyl group having 1 to 10 carbon atoms, or an aryl group having 6 to 10 carbon atoms. "n", "m", "p", and "q" each represent an integer of 1 to 3. R¹⁰ to R¹³ each independently represent a hydrogen atom, a halogen atom, a hydroxy group, a linear, branched, or cyclic alkyl group having 1 to 6 carbon atoms, or a linear, branched, or cyclic alkoxy group having 1 to 6 carbon atoms. Note that the definitions of the symbols in the formulae apply only in these formulae.

Examples of the resin (B) for forming an organic film used in the present invention also include reaction products obtained by a method disclosed in JP 2012-145897 A. More specific examples also include polymers obtained by condensing one or more compounds represented by the following general formula (23B-1) and/or (23B-2) and one or more compounds represented by the following general formula (24B-1) and/or (24B-2) and/or an equivalent thereof.

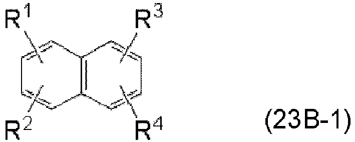

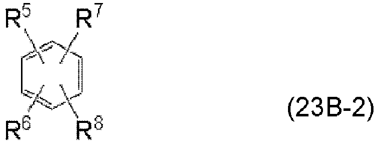

In the general formula (23B-1) and the general formula (23B-2), R¹ to R⁸ each independently represent a hydrogen atom, a halogen atom, a hydroxy group, an isocyanato group, a glycidyloxy group, a carboxyl group, an amino group, an alkoxy group having 1 to 30 carbon atoms, an alkoxycarbonyl group having 1 to 30 carbon atoms, an alkanoyloxy group having 1 to 30 carbon atoms, or a saturated or unsaturated organic group having 1 to 30 carbon atoms and optionally being substituted. Furthermore, any two substituents selected from each of R¹ to R⁴ or R⁵ to R⁸ may be bonded to each other within a molecule to form a cyclic substituent. Note that the definitions of the symbols in the formulae apply only in these formulae.

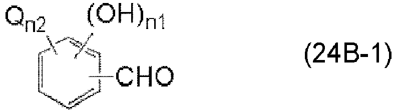

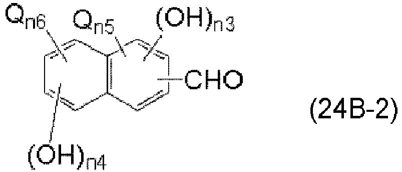

In the general formula (24B-1) and the general formula (24B-2), Q represents an organic group having 1 to 30 carbon atoms and optionally being substituted, and furthermore, any two Q's selected therefrom are optionally bonded with each other within a molecule to form a cyclic substituent. "n1" to "n6" each represent the number of each substituent, "n1" to "n6" are each independently 0, 1, or 2, and in the formula (24B-1), hydroxybenzaldehyde is excluded. Meanwhile, in the formula (24B-2), the relationships 0 ≤ n3+n5 ≤ 3, 0 ≤ n4+n6 ≤ 4, and 1 ≤ n3+n4 ≤ 4 are satisfied. Note that the definitions of the symbols in the formulae apply only in these formulae.

Further examples also include polymers obtained by condensing one or more compounds represented by the general formula (23B-1) and/or (23B-2), one or more compounds represented by the general formula (24B-1) and/or (24B-2) and/or an equivalent thereof, and one or more compounds represented by the following general formula (25B) and/or an equivalent thereof.

Y-CHO (25B)

In the formula (25B), Y represents a hydrogen atom or a monovalent organic group having 30 or fewer carbon atoms and optionally having a substituent, and the compound represented by the formula (25B) is different from the compound represented by the general formula (24B-1) and the compound represented by the general formula (24B-2). Note that the definition of the symbol in the formula applies only in this formula.

Examples of the resin (B) for forming an organic film used in the present invention also include compounds containing the following structure, disclosed in JP 2017-119671 A.

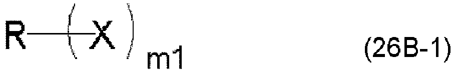

In the formula (26B-1), R represents a single bond or an organic group having 1 to 50 carbon atoms; X represents a group represented by any of the following general formulae (26B-2); and "m1" represents an integer that satisfies 2 ≤ m1 ≤ 10. Note that the definitions of the symbols in the formula apply only in this formula.

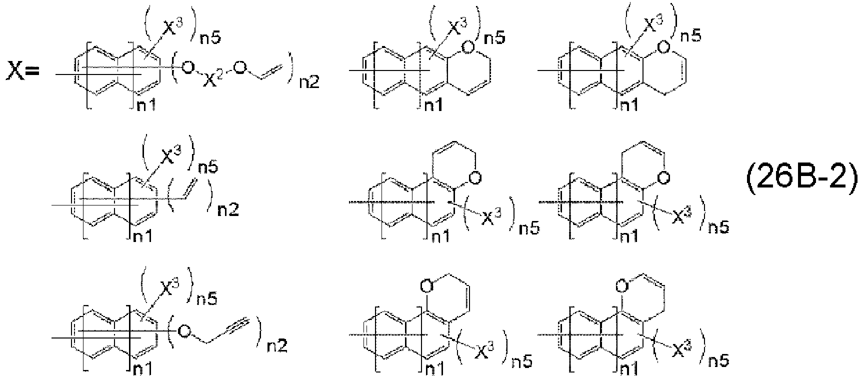

In the formulae, X² represents a divalent organic group having 1 to 10 carbon atoms; "n1" represents 0 or 1; "n2" represents 1 or 2; X³ represents a group represented by the following general formula (26B-3); and "n5" represents 0, 1, or 2. Note that the definitions of the symbols in the formulae apply only in these formulae. 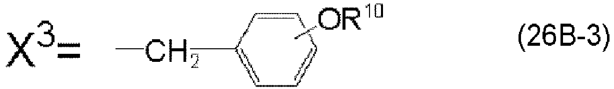 In the formula, R¹⁰ represents a hydrogen atom or a saturated or unsaturated hydrocarbon group having 1 to 10 carbon atoms, and a hydrogen atom on the benzene ring in the formula may be substituted with a methyl group or a methoxy group. Note that the definition of the symbol in the formula applies only in this formula.

Examples of the compounds containing the above-described structures include the following compounds.

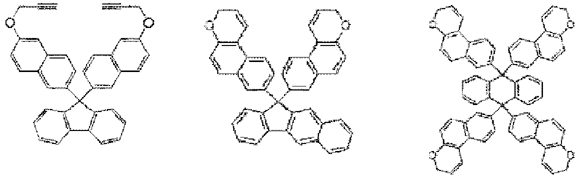

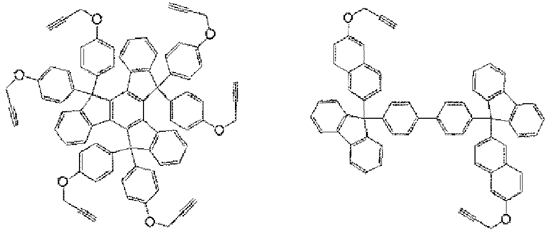

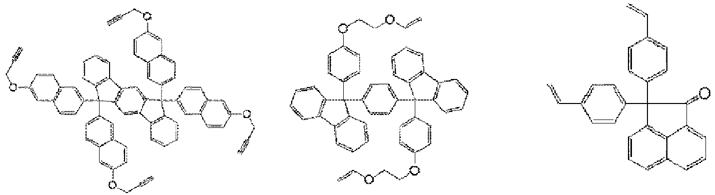

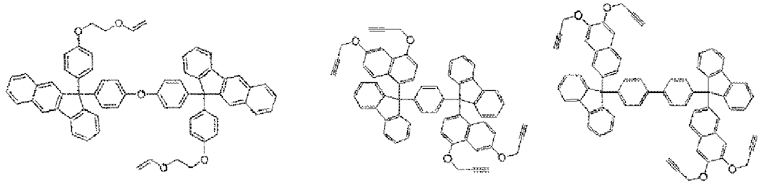

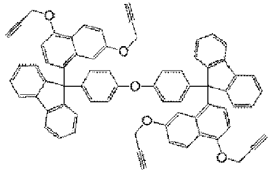

Examples of the resin (B) for forming an organic film used in the present invention also include polymers having a repeating unit represented by the following general formula (27B-1), disclosed in JP 2019-044022 A.

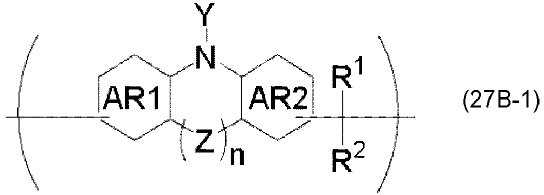

In the formula (27B-1), AR1 and AR2 each independently represent a benzene ring or naphthalene ring optionally having a substituent. R¹ and R² each independently represent a hydrogen atom or an organic group having 1 to 30 carbon atoms, and when R¹ and R² each represent an organic group, R¹ and R² are optionally bonded to each other within a molecule to form a cyclic organic group. "n" represents 0 or 1; when n = 0, AR1 and AR2 do not form a bridged structure between the aromatic rings of AR1 and AR2 via Z; when n = 1, AR1 and AR2 form a bridged structure between the aromatic rings of AR1 and AR2 via Z; and Z represents a single bond or one of the following formulae (27B-2). Y represents a group represented by the following formula (27B-3). Note that the definitions of the symbols in the formula apply only in this formula. 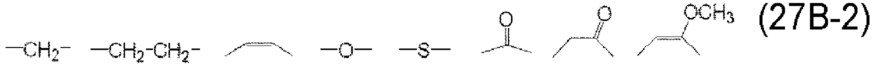 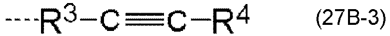 In the formula, R³ represents a single bond or a divalent organic group having 1 to 20 carbon atoms; R⁴ represents a hydrogen atom or a monovalent organic group having 1 to 20 carbon atoms; and a broken line represents an attachment point. Note that the definitions of the symbols in the formula apply only in this formula.

Examples of the polymers having a repeating unit represented by the general formula (27B-1) include the following polymers.

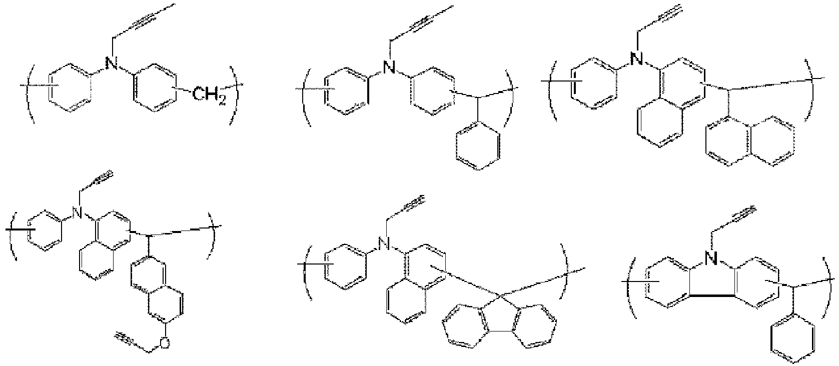

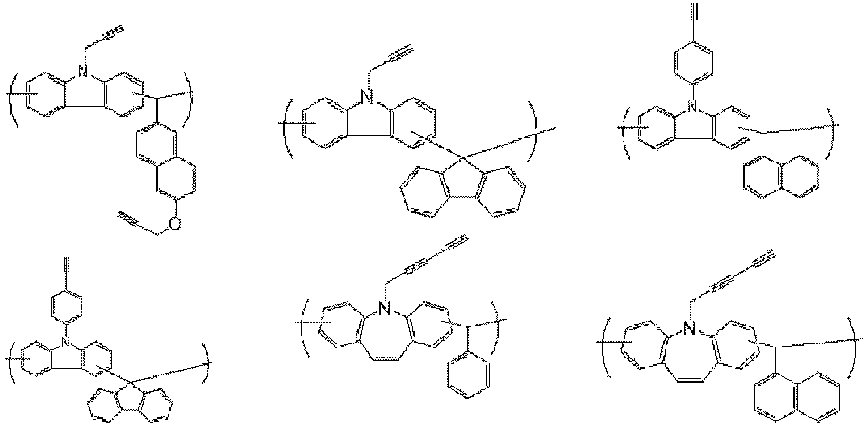

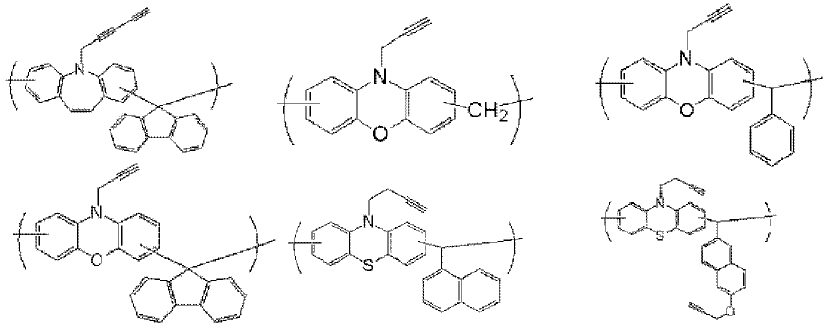

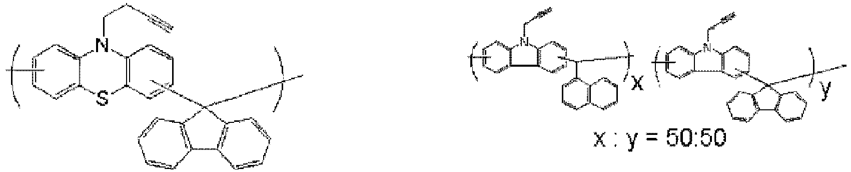

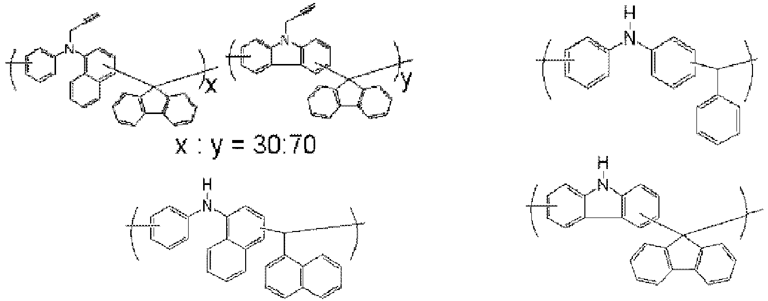

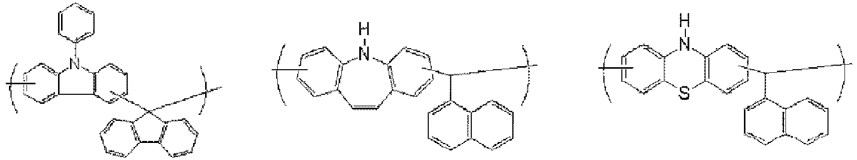

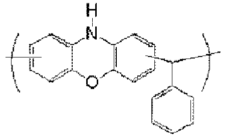

The resin (B) for forming an organic film may be synthesized by a known method, and a commercially available product may be used.

The amount of the resin (B) for forming an organic film to be contained is not particularly limited as long as sufficient film-formability can be achieved on spin-coating with the composition for forming an organic film, but the resin (B) for forming an organic film is preferably contained in an amount of 10 to 40 parts by mass, more preferably 10 to 30 parts by mass, and further preferably 10 to 25 parts by mass, based on 100 parts by mass of the composition for forming an organic film. For example, when a hole or trench, having a very high aspect ratio, of a 3D NAND memory architecture is to be filled with the composition for forming an organic film, the contained amount of the resin for forming an organic film needs to be large. However, on the other hand, such a composition for forming an organic film is highly viscous, and in-plane uniformity after spin-coating and filling property are degraded. Even when the resin (B) for forming an organic film is contained in such a proportion, the inventive composition for forming an organic film makes it possible to form an organic film having excellent in-plane uniformity and excellent filling property, and can therefore be applied suitably.

Meanwhile, the polymer (A) is preferably contained in an amount of 0.01 parts by mass to 5 parts by mass based on 100 parts by mass of the resin (B) for forming an organic film. A composition for forming an organic film containing the polymer in such an amount makes it possible to form an organic film with better in-plane uniformity.

### [(C) Solvent]

The solvent (C) usable for the inventive composition for forming an organic film is not particularly limited as long as the solvent can dissolve the resin (B) for forming an organic film and the polymer (A), and the solvent can preferably also dissolve the acid generator, crosslinking agent, surfactant, etc. described later. Specific examples include: ketones, such as 2-heptanone, cyclopentanone, and cyclohexanone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, γ-butyrolactone, and propylene glycol mono-tert-butyl ether acetate. One of the solvents may be used, or two or more thereof may be used in mixture. However, the solvent is not limited thereto.

In particular, preferable solvents are propylene glycol monomethyl ether acetate, propylene glycol monomethyl ether, 2-heptanone, cyclopentanone, cyclohexanone, γ-butyrolactone, and mixtures of two or more thereof.

The solvent (C) is preferably contained in an amount of 200 to 10,000 parts by mass, more preferably 300 to 5,000 parts by mass based on 100 parts by mass of the resin (B) for forming an organic film. When the amount is in such a range, the concentration is adjustable in accordance with the desired film thickness.

### [Other Components]

In addition, the inventive composition for forming an organic film can further contain, as an optional component, an acid generator or a crosslinking agent for further promoting the crosslinking reaction.

Acid generators include materials that generate an acid by thermal decomposition and materials that generate an acid by light irradiation, and any acid generator can be contained. Specific examples of the acid generator include those disclosed in paragraphs [0061] to [0085] of JP 2007-199653 A. One kind of the acid generator may be used, or two or more kinds thereof may be used in combination. When the acid generator is contained, the contained amount is preferably 0.05 to 50 parts by mass, more preferably 0.1 to 10 parts by mass based on 100 parts by mass of the resin (B) for forming an organic film. When the amount is as described, it is possible to promote the crosslinking reaction and form a dense film.

Specific examples of the crosslinking agent include those disclosed in paragraphs [0055] to [0060] of JP 2007-199653 A. One kind of the crosslinking agent may be used, or two or more kinds thereof may be used in combination. The crosslinking agent is preferably contained in an amount of 1 to 100 parts by mass, more preferably 5 to 50 parts by mass based on 100 parts by mass of the resin (B) for forming an organic film. When the amount is as described, it is possible to enhance curability and further suppress intermixing with an upper layer film.

The inventive composition for forming an organic film can also contain, as an optional component, a surfactant for further improving in-plane uniformity in spin-coating. Specific examples of the surfactant include those disclosed in paragraphs [0142] to [0147] of JP 2009-269953 A. One kind of the surfactant may be used, or two or more kinds thereof may be used in combination. When the surfactant is contained, the contained amount is preferably 0.01 to 10 parts by mass, more preferably 0.05 to 5 parts by mass based on 100 parts by mass of the composition for forming an organic film. When the amount is as described, it is possible to form an organic film excellent in in-plane uniformity.

The inventive composition for forming an organic film can further contain, as an optional component, a basic compound for enhancing storage stability. The basic compound serves as a quencher to an acid to prevent a very small amount of acid generated by the acid generator from promoting the crosslinking reaction. Specific examples of such a basic compound include those disclosed in paragraphs [0086] to [0090] of JP 2007-199653 A. One kind of the basic compound may be used, or two or more kinds thereof may be used in combination. When the basic compound is contained, the contained amount is preferably 0.05 to 50 parts by mass, more preferably 0.1 to 10 parts by mass based on 100 parts by mass of the resin (B) for forming an organic film. When the amount is as described, it is possible to improve the storage stability of the composition for forming an organic film.

As described above, the inventive composition for forming an organic film is excellent in film-formability (in-plane uniformity) on a substrate and filling property, and has excellent hump suppression property at the time of an EBR process. Accordingly, the inventive composition for forming an organic film is extremely useful as, for example, a resist underlayer film material (organic film material) for multilayer resist processes such as two-layer resist processes, three-layer resist processes using a silicon-containing resist middle layer film or a silicon-containing inorganic hard mask middle layer film, and four-layer resist processes using a silicon-containing resist middle layer film or silicon-containing inorganic hard mask middle layer film and an organic antireflective film or adhesive film.

### [Method for Forming Organic Film]

The present invention provides a method for forming an organic film to be used in a manufacturing process of a semiconductor device, the method including: spin-coating a substrate to be processed with the inventive composition for forming an organic film described above to obtain a coating film; and forming an organic film by heating the coating film at a temperature of 100°C or higher and 600°C or lower for 10 to 600 seconds to cure the coating film.

In this method for forming an organic film, firstly, the inventive composition for forming an organic film described above is applied onto a substrate to be processed by spin-coating. An excellent filling property can be obtained by using a spin-coating method.

Subsequently, an edge portion of the coating film can be removed in an EBR process. As explained earlier, the inventive composition for forming an organic film is excellent in hump suppression at the time of an EBR process. Therefore, in the inventive method for forming an organic film, the generation of humps can be suppressed even when an EBR process is performed.

Subsequently, the coating film is baked (heated) in order to promote the crosslinking reaction. Incidentally, the solvent in the composition can be evaporated by this baking, and therefore, mixing can be prevented even when a resist upper layer film or a silicon-containing resist middle layer film is formed on the organic film.

The baking is performed at a temperature of 100°C or higher and 600°C or lower for 10 to 600 seconds, preferably at a temperature of 200°C or higher and 500°C or lower for 10 to 300 seconds. Considering influence on device damage and wafer deformation, the upper limit of the heating temperature in a wafer process of lithography is 600°C or lower, preferably 500°C or lower. By performing the heat treatment under such conditions, the crosslinking reaction can be promoted, and it is possible to form an organic film that does not mix with a film formed thereon.

### [Patterning Process]

In the following, patterning processes using the inventive composition for forming an organic film will be described.

### [Three-Layer Resist Process Using Silicon-Containing Resist Middle Layer Film]

The present invention provides a patterning process including:
forming an organic film on a body to be processed by using the inventive composition for forming an organic film described above;
forming a silicon-containing resist middle layer film on the organic film by using a silicon-containing resist middle layer film material;
forming a resist upper layer film on the silicon-containing resist middle layer film by using a resist upper layer film material containing a photoresist composition;
forming a circuit pattern in the resist upper layer film;
transferring the pattern to the silicon-containing resist middle layer film by etching while using the resist upper layer film having the formed circuit pattern as a mask;
transferring the pattern to the organic film by etching while using the silicon-containing resist middle layer film having the transferred pattern as a mask; and
further forming the pattern in the body to be processed by etching while using the organic film having the transferred pattern as a mask.

The body to be processed is preferably a semiconductor device substrate or the semiconductor device substrate coated with any of a metal film, a metal carbide film, a metal oxide film, a metal nitride film, a metal oxycarbide film, and a metal oxynitride film, for example. The body to be processed is not particularly limited, but more specifically, may be a substrate made of Si, α-Si, p-Si, SiO₂, SiN, SiON, W, TiN, Al, etc.; the substrate coated with the above-mentioned metal film or the like as a layer to be processed; etc.

Examples of the layer to be processed include various Low-k films made of Si, SiO₂, SiON, SiN, p-Si, α-Si, W, W-Si, Al, Cu, Al-Si, or the like; and stopper films thereof. Generally, the layer can be formed to have a thickness of 50 to 10,000 nm, particularly preferably 100 to 5,000 nm. Note that when the layer to be processed is formed, the substrate and the layer to be processed are formed from different materials.

Incidentally, the metal constituting the body to be processed preferably contains silicon, titanium, tungsten, hafnium, zirconium, chromium, germanium, copper, silver, gold, aluminum, indium, gallium, arsenic, palladium, iron, tantalum, iridium, molybdenum, or an alloy thereof.

When forming an organic film on the body to be processed by using the inventive composition for forming an organic film, the inventive method for forming an organic film described above can be adopted, although the method is not limited thereto.

Subsequently, a resist middle layer film (silicon-containing resist middle layer film) is formed on the organic film by using a resist middle layer film material containing a silicon atom. As the resist middle layer film material containing a silicon atom, a polysiloxane-based middle layer film material is preferable. By imparting an antireflective effect to the silicon-containing resist middle layer film, reflection can be suppressed. Particularly, for 193-nm light exposure, when a material containing many aromatic groups and having high etching selectivity relative to the substrate is used as a composition for forming an organic film, the k-value and thus the substrate reflection are increased; in contrast, the reflection can be suppressed by imparting absorption to the silicon-containing resist middle layer film so as to have an appropriate k-value, and the substrate reflection can be reduced to 0.5% or less. As the silicon-containing resist middle layer film having an antireflective effect, a polysiloxane is preferably used which has anthracene for 248-nm or 157-nm light exposure, or a phenyl group or a light-absorbing group having a silicon-silicon bond for 193-nm light exposure in a pendant structure, and which is to be crosslinked by an acid or heat.

Subsequently, a resist upper layer film is formed on the silicon-containing resist middle layer film by using a resist upper layer film material containing a photoresist composition. The resist upper layer film material may be a positive type or a negative type, and a photoresist composition that is normally used can be used. After the spin-coating with the resist upper layer film material, pre-baking is preferably performed at 60 to 180°C for 10 to 300 seconds. Then, light exposure, post-exposure baking (PEB), and development are performed according to conventional methods to obtain a resist upper layer film pattern. Note that the thickness of the resist upper layer film is not particularly limited, but is preferably 30 to 500 nm, particularly preferably 50 to 400 nm.

Subsequently, a circuit pattern (resist upper layer film pattern) is formed in the resist upper layer film. The circuit pattern is preferably formed by a lithography using light having a wavelength of 10 nm or more and 300 nm or less, a direct writing with electron beam, nanoimprinting, or a combination thereof.

Examples of exposure light include high-energy beams having a wavelength of 300 nm or less, specifically, deep ultraviolet ray, KrF excimer laser beam (248 nm), ArF excimer laser beam (193 nm), F₂ laser beam (157 nm), Kr₂ laser beam (146 nm), Ar₂ laser beam (126 nm), soft X-ray (EUV) of 3 to 20 nm, electron beam (EB), ion beam, X-ray, etc.

Furthermore, the circuit pattern is preferably developed with an alkaline development or an organic solvent.

Subsequently, the pattern is transferred to the silicon-containing resist middle layer film by etching while using the resist upper layer film having the formed circuit pattern as a mask. The etching of the silicon-containing resist middle layer film performed while using the resist upper layer film pattern as a mask is preferably performed by using a fluorocarbon-based gas. Thus, the pattern (silicon-containing resist middle layer film pattern) is transferred to the silicon-containing resist middle layer film.

Subsequently, the pattern is transferred to the organic film by etching while using the silicon-containing resist middle layer film having the transferred pattern (silicon-containing resist middle layer film pattern) as a mask. The silicon-containing resist middle layer film exhibits etching resistance to oxygen gas or hydrogen gas, and therefore, the etching of the organic film performed while using the silicon-containing resist middle layer film pattern as a mask is preferably performed by using an etching gas mainly containing oxygen gas or hydrogen gas. Thus, the pattern (organic film pattern) is transferred to the organic film.

Subsequently, the pattern is transferred to (formed in) the body to be processed by etching while using the organic film having the transferred pattern (organic film pattern) as a mask. This etching of the body to be processed (layer to be processed) can be performed by a conventional method. For example, a body to be processed made of SiO₂, SiN, or silica low-dielectric insulating film is etched mainly with a fluorocarbon-based gas; and a body to be processed made of p-Si, Al, or W is etched mainly with a chlorine- or bromine-based gas. When the substrate is processed by etching with a fluorocarbon-based gas, the organic film pattern is removed when the substrate is processed. Meanwhile, when the substrate is processed by etching with a chlorine- or bromine-based gas, the organic film pattern needs to be removed by additional dry etching with a fluorocarbon-based gas after the substrate processing.

The organic film obtained by using the inventive composition for forming an organic film can be provided with excellent etching resistance when the body to be processed is etched as described above.

### [Four-Layer Resist Process Using Silicon-Containing Resist Middle Layer Film and Organic Antireflective Film or Adhesive Film]

The present invention also provides a patterning process including:
forming an organic film on a body to be processed by using the inventive composition for forming an organic film;
forming a silicon-containing resist middle layer film on the organic film by using a silicon-containing resist middle layer film material;
forming an organic antireflective film or an adhesive film on the silicon-containing resist middle layer film;
forming a resist upper layer film on the organic antireflective film or the adhesive film by using a resist upper layer film material containing a photoresist composition;
forming a circuit pattern in the resist upper layer film;
transferring the pattern to the organic antireflective film or the adhesive film and to the silicon-containing resist middle layer film by etching while using the resist upper layer film having the formed circuit pattern as a mask;
transferring the pattern to the organic film by etching while using the silicon-containing resist middle layer film having the transferred pattern as a mask; and
further forming the pattern in the body to be processed by etching while using the organic film having the transferred pattern as a mask.

This method can be performed in the same manner as the three-layer resist process using the silicon-containing resist middle layer film, except that the organic antireflective film (BARC) or the adhesive film is formed between the silicon-containing resist middle layer film and the resist upper layer film.

The organic antireflective film and the adhesive film can be formed by spin-coating by using a known organic antireflective film material.

### [Three-Layer Resist Process Using Inorganic Hard Mask Middle Layer Film]

The present invention also provides a patterning process including:
forming an organic film on a body to be processed by using the inventive composition for forming an organic film;
forming an inorganic hard mask middle layer film selected from the group consisting of a silicon oxide film, a silicon nitride film, and a silicon oxynitride film on the organic film;
forming a resist upper layer film on the inorganic hard mask middle layer film by using a resist upper layer film material containing a photoresist composition;
forming a circuit pattern in the resist upper layer film;
transferring the pattern to the inorganic hard mask middle layer film by etching while using the resist upper layer film having the formed circuit pattern as a mask;
transferring the pattern to the organic film by etching while using the inorganic hard mask middle layer film having the transferred pattern as a mask; and
further forming the pattern in the body to be processed by etching while using the organic film having the transferred pattern as a mask.

This method can be performed in the same manner as the three-layer resist process using the silicon-containing resist middle layer film, except that the inorganic hard mask middle layer film is formed instead of the silicon-containing resist middle layer film on the organic film.

The inorganic hard mask middle layer film selected from a silicon oxide film, a silicon nitride film, and a silicon oxynitride film (SiON film) can be formed, for example, by a CVD method, an ALD method, etc. Examples of methods for forming the silicon nitride film are disclosed in JP 2002-334869 A, WO 2004/066377 A1, etc. The inorganic hard mask middle layer film preferably has a thickness of 5 to 200 nm, more preferably 10 to 100 nm. As the inorganic hard mask middle layer film, a SiON film, which has a high function as an antireflective film, is the most preferably used.

### [Four-Layer Resist Process Using Inorganic Hard Mask Middle Layer Film and Organic Antireflective Film or Adhesive Film]

The present invention also provides a patterning process including:
forming an organic film on a body to be processed by using the above-described composition for forming an organic film;
forming an inorganic hard mask middle layer film selected from a silicon oxide film, a silicon nitride film, and a silicon oxynitride film on the organic film;
forming an organic antireflective film or an adhesive film on the inorganic hard mask middle layer film;
forming a resist upper layer film on the organic antireflective film or the adhesive film by using a resist upper layer film material containing a photoresist composition;
forming a circuit pattern in the resist upper layer film;
transferring the pattern to the organic antireflective film or the adhesive film and to the inorganic hard mask middle layer film by etching while using the resist upper layer film having the formed circuit pattern as a mask;
transferring the pattern to the organic film by etching while using the inorganic hard mask middle layer film having the transferred pattern as a mask; and
further transferring the pattern to the body to be processed by etching while using the organic film having the transferred pattern as a mask.

This method can be performed in the same manner as the three-layer resist process using the inorganic hard mask middle layer film, except that the organic antireflective film (BARC) or the adhesive film is formed between the inorganic hard mask middle layer film and the resist upper layer film.

Particularly, when a SiON film is used as the inorganic hard mask middle layer film, two antireflective films including the SiON film and the BARC make it possible to suppress the reflection even in liquid immersion exposure at a high NA exceeding 1.0. Another merit of forming the BARC is having an effect of reducing trailing of the resist upper layer film pattern immediately above the SiON film.

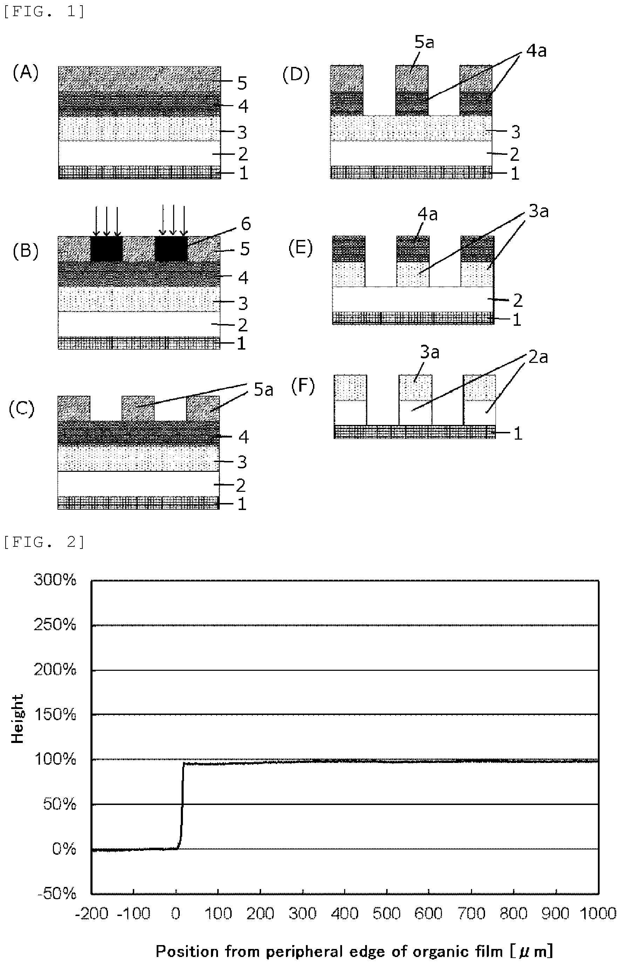

Here, an example of the inventive patterning processes according to a three-layer resist process is shown in FIG. 1 (A) to (F). In the case of a three-layer resist process, as shown in FIG. 1 (A), an organic film 3 is formed by using the inventive composition for forming an organic film on a layer 2 to be processed (body to be processed) formed on a substrate 1; then, a silicon-containing resist middle layer film 4 is formed on the organic film 3; and a resist upper layer film 5 is formed thereon. Next, as shown in FIG. 1 (B), an exposure portion 6 of the resist upper layer film 5 is exposed, and then PEB (post-exposure baking) is performed. Next, as shown in FIG. 1 (C), development is performed to form a resist upper layer film pattern 5a. Next, as shown in FIG. 1 (D), the silicon-containing resist middle layer film 4 is dry-etched by using a fluorocarbon-based gas while using the resist upper layer film pattern 5a as a mask, and thus, a silicon-containing resist middle layer film pattern 4a is formed. Next, the resist upper layer film pattern 5a is removed, then, as shown in FIG. 1 (E), the organic film 3 is etched with oxygen plasma while using the silicon-containing resist middle layer film pattern 4a as a mask, and thus, an organic film pattern 3a is formed. Furthermore, as shown in FIG. 1 (F), the silicon-containing resist middle layer film pattern 4a is removed, then the layer 2 to be processed is etched while using the organic film pattern 3a as a mask, and thus, a pattern 2a is formed.

In the patterning process of this example, by humps being suppressed when the organic film 3 is formed, during the dry etching of FIG. 1 (D), (E), and (F), it is possible to reduce defects that are generated due to humps of the organic film.

In a case where an inorganic hard mask middle layer film is formed, the silicon-containing resist middle layer film 4 can be changed to an inorganic hard mask middle layer film, and in a case where a BARC or an adhesive film is formed, the BARC or the adhesive film can be formed between the silicon-containing resist middle layer film 4 and the resist upper layer film 5. The etching of the BARC or the adhesive film may be performed continuously before the etching of the silicon-containing resist middle layer film 4; alternatively, after the BARC or the adhesive film alone is etched, the etching apparatus may be changed and so forth, and then the etching of the silicon-containing resist middle layer film 4 may be performed.

As described above, the inventive patterning processes make it possible to form a fine pattern in a body to be processed with high precision according to a multilayer resist process, and to suppress hump formation on an organic film, thus reducing defects derived from humps of the organic film.

### EXAMPLES

Hereinafter, the present invention will be further specifically described with reference to Synthesis Examples, Comparative Synthesis Examples, Examples, and Comparative Examples. However, the present invention is not limited thereto. Note that, specifically, the molecular weight was measured in the following manner. Weight-average molecular weight (Mw) and number-average molecular weight (Mn) on polystyrene basis were measured by gel permeation chromatography (GPC) using tetrahydrofuran as an eluent (solvent), and dispersity (Mw/Mn) was calculated therefrom.

### [Synthesis of Polymers (A1) to (A8)]

For the synthesis of polymers (A1) to (A8), used for the preparation of compositions (UDL) for forming an organic film, hexafluorobenzene or octafluoronaphthalene and, as alcohol and carboxylic acid components, the following compounds (a1) to (a11) were used.

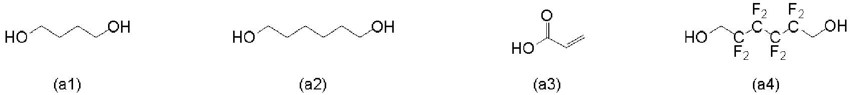

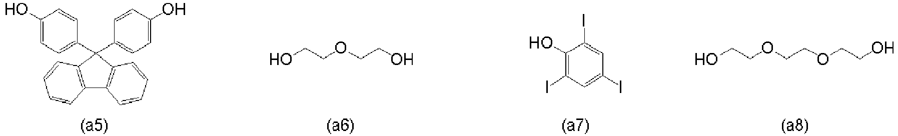

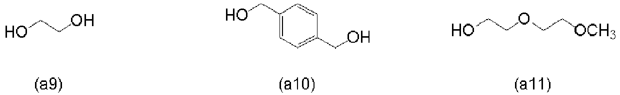

### [Synthesis Example 1] Synthesis of Polymer (A1)

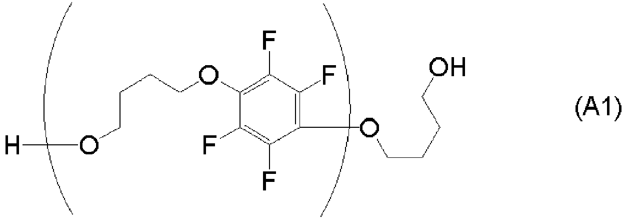

Under a nitrogen atmosphere, 4.96 g of the compound (a1) and 50.0 g of THF (tetrahydrofuran) were stirred in an ice bath to form a homogeneous solution. After that, 2.88 g of sodium hydride was added to the homogeneous solution, and the mixture was stirred for 1 hour. After that, 9.30 g of hexafluorobenzene was added dropwise to the mixture over 20 minutes, and a reaction was allowed to take place at room temperature for 24 hours. After the reaction, 50 g of pure water was added dropwise to the reaction product to quench the reaction. Subsequently, 100 ml of MIBK (methyl isobutyl ketone) was added to the reaction product to perform layer separation. Then, the separated lower layer was removed. The remaining organic layer was washed twice with 50 g of a 3.0% aqueous solution of nitric acid and five times with 50 g of pure water in this order, and the organic layer was evaporated under reduced pressure to dryness. To the residue, 50 g of THF was added, and 200 g of hexane was added dropwise while stirring to precipitate a glutinous cake-like precipitate. After leaving the resulting product to stand for some time, the transparent supernatant liquid was decanted. 50 g of THF was added again to form a homogeneous solution, and 200 g of hexane was added to precipitate a glutinous cake-like precipitate. After leaving the resulting product to stand, the supernatant liquid was decanted. To the residue, PGMEA (propylene glycol monomethyl ether acetate) was added, and distillation under reduced pressure and concentration adjustment were performed. Thus, a polymer (A1) was obtained as a solution in PGMEA having a polymer concentration of 30 wt%.

The weight-average molecular weight (Mw) and the dispersity (Mw/Mn) of the polymer (A1) were determined by GPC, and the following results were obtained.
(A1): Mw=3,300, Mw/Mn=3.32

### [Synthesis Example 2] Synthesis of Polymer (A2)

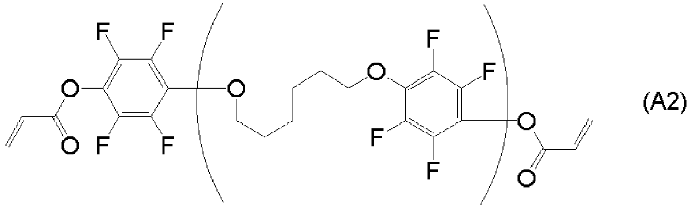

Under a nitrogen atmosphere, 5.32 g of the compound (a2) and 50.0 g of THF (tetrahydrofuran) were stirred in an ice bath to form a homogeneous solution. After that, 2.88 g of sodium hydride was added to the homogeneous solution, and the mixture was stirred for 1 hour. After that, 9.30 g of hexafluorobenzene was added dropwise to the mixture over 20 minutes, and a reaction was allowed to take place at room temperature for 16 hours. Then, 1.08 g of the compound (a3) was added dropwise, and a reaction was further allowed to take place for 8 hours. After the reaction, 50 g of pure water was added dropwise to the reaction product to quench the reaction. Subsequently, 100 ml of MIBK was added to the reaction product to perform layer separation. Then, the separated lower layer was removed. The remaining organic layer was washed once with 50 g of a 3.0% aqueous solution of sodium hydrogencarbonate, three times with 50 g of a 3.0% aqueous solution of nitric acid, and five times with 100 g of pure water in this order, and the organic layer was evaporated under reduced pressure to dryness. To the residue, 50 g of THF was added, and 200 g of hexane was added dropwise while stirring to precipitate a glutinous cake-like precipitate. After leaving the resulting product to stand for some time, the transparent supernatant liquid was decanted. 50 g of THF was added again to form a homogeneous solution, and 200 g of hexane was added to precipitate a glutinous cake-like precipitate. After leaving the resulting product to stand, the supernatant liquid was decanted. To the residue, PGMEA (propylene glycol monomethyl ether acetate) was added, and distillation under reduced pressure and concentration adjustment were performed. Thus, a polymer (A2) was obtained as a solution in PGMEA having a polymer concentration of 30 wt%.

The weight-average molecular weight (Mw) and the dispersity (Mw/Mn) of the polymer (A2) were determined by GPC, and the following results were obtained.
(A2): Mw=5,200, Mw/Mn=3.76

### [Synthesis Example 3] Synthesis of Polymer (A3)

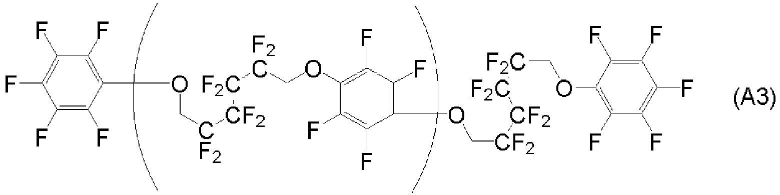

Under a nitrogen atmosphere, 11.79 g of the compound (a4) and 50.0 g of THF (tetrahydrofuran) were stirred in an ice bath to form a homogeneous solution. After that, 2.88 g of sodium hydride was added to the homogeneous solution, and the mixture was stirred for 1 hour. After that, 9.30 g of hexafluorobenzene was added dropwise to the mixture over 20 minutes, and a reaction was allowed to take place at room temperature for 24 hours. After the reaction, 50 g of pure water was added dropwise to the reaction product to quench the reaction. Subsequently, 100 ml of MIBK was added to the reaction product to perform layer separation. Then, the separated lower layer was removed. The remaining organic layer was washed twice with 50 g of a 3.0% aqueous solution of nitric acid and five times with 50 g of pure water in this order, and the organic layer was evaporated under reduced pressure to dryness. To the residue, 50 g of THF was added, and 200 g of hexane was added dropwise while stirring to precipitate a glutinous cake-like precipitate. After leaving the resulting product to stand for some time, the transparent supernatant liquid was decanted. 50 g of THF was added again to form a homogeneous solution, and 200 g of hexane was added to precipitate a glutinous cake-like precipitate. After leaving the resulting product to stand, the supernatant liquid was decanted. To the residue, PGMEA (propylene glycol monomethyl ether acetate) was added, and distillation under reduced pressure and concentration adjustment were performed. Thus, a polymer (A3) was obtained as a solution in PGMEA having a polymer concentration of 30 wt%.

The weight-average molecular weight (Mw) and the dispersity (Mw/Mn) of the polymer (A3) were determined by GPC, and the following results were obtained.
(A3): Mw=11,100, Mw/Mn=3.81

### [Synthesis Example 4] Synthesis of Polymer (A4)

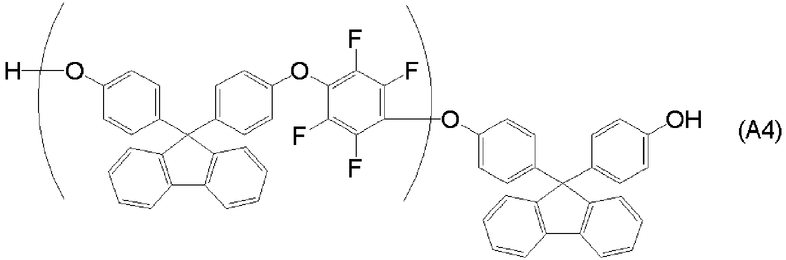

Under a nitrogen atmosphere, 19.27 g of the compound (a5) and 50.0 g of THF (tetrahydrofuran) were stirred in an ice bath to form a homogeneous solution. After that, 2.88 g of sodium hydride was added to the homogeneous solution, and the mixture was stirred for 1 hour. After that, 9.30 g of hexafluorobenzene was added dropwise to the mixture over 20 minutes, and a reaction was allowed to take place at room temperature for 24 hours. After the reaction, 50 g of pure water was added dropwise to the reaction product to quench the reaction. Subsequently, 100 ml of MIBK was added to the reaction product to perform layer separation. Then, the separated lower layer was removed. The remaining organic layer was washed twice with 50 g of a 3.0% aqueous solution of nitric acid and five times with 50 g of pure water in this order, and the organic layer was evaporated under reduced pressure to dryness. To the residue, 50 g of THF was added, and 200 g of hexane was added dropwise while stirring to precipitate a glutinous cake-like precipitate. After leaving the resulting product to stand for some time, the transparent supernatant liquid was decanted. 50 g of THF was added again to form a homogeneous solution, and 200 g of hexane was added to precipitate a glutinous cake-like precipitate. After leaving the resulting product to stand, the supernatant liquid was decanted. To the residue, PGMEA (propylene glycol monomethyl ether acetate) was added, and distillation under reduced pressure and concentration adjustment were performed. Thus, a polymer (A4) was obtained as a solution in PGMEA having a polymer concentration of 30 wt%.

The weight-average molecular weight (Mw) and the dispersity (Mw/Mn) of the polymer (A4) were determined by GPC, and the following results were obtained.
(A4): Mw=4,500, Mw/Mn=2.29

### [Synthesis Example 5] Synthesis of Polymer (A5)

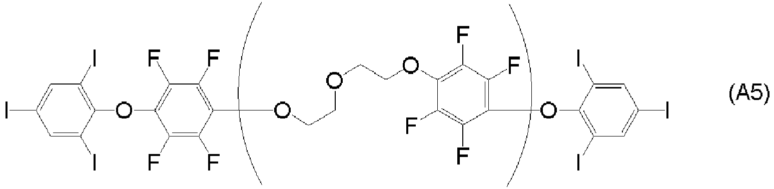

Under a nitrogen atmosphere, 4.78 g of the compound (a6) and 50.0 g of THF (tetrahydrofuran) were stirred in an ice bath to form a homogeneous solution. After that, 2.88 g of sodium hydride was added to the homogeneous solution, and the mixture was stirred for 1 hour. After that, 9.30 g of hexafluorobenzene was added dropwise to the mixture over 20 minutes, and a reaction was allowed to take place at room temperature for 16 hours. Then, 7.08 g of the compound (a7) was added dropwise, and a reaction was further allowed to take place for 8 hours. After the reaction, 50 g of pure water was added dropwise to the reaction product to quench the reaction. Subsequently, 100 ml of MIBK was added to the reaction product to perform layer separation. Then, the separated lower layer was removed. The remaining organic layer was washed twice with 50 g of a 3.0% aqueous solution of nitric acid and five times with 50 g of pure water in this order, and the organic layer was evaporated under reduced pressure to dryness. To the residue, 50 g of THF was added, and 200 g of hexane was added dropwise while stirring to precipitate a glutinous cake-like precipitate. After leaving the resulting product to stand for some time, the transparent supernatant liquid was decanted. 50 g of THF was added again to form a homogeneous solution, and 200 g of hexane was added to precipitate a glutinous cake-like precipitate. After leaving the resulting product to stand, the supernatant liquid was decanted. To the residue, PGMEA (propylene glycol monomethyl ether acetate) was added, and distillation under reduced pressure and concentration adjustment were performed. Thus, a polymer (A5) was obtained as a solution in PGMEA having a polymer concentration of 30 wt%.

The weight-average molecular weight (Mw) and the dispersity (Mw/Mn) of the polymer (A5) were determined by GPC, and the following results were obtained.
(A5): Mw=7,700, Mw/Mn=2.94

### [Synthesis Example 6] Synthesis of Polymer (A6)

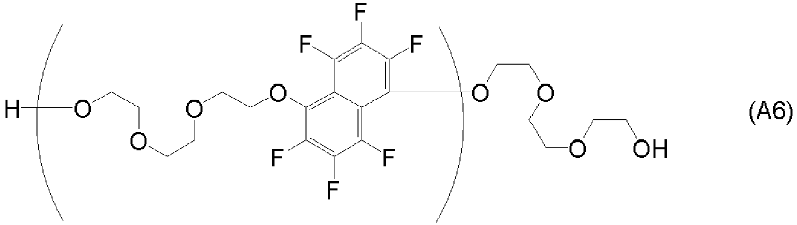

Under a nitrogen atmosphere, 8.26 g of the compound (a8) and 50.0 g of THF (tetrahydrofuran) were stirred in an ice bath to form a homogeneous solution. After that, 2.88 g of sodium hydride was added to the homogeneous solution, and the mixture was stirred for 1 hour. After that, a mixed solution of 13.60 g of octafluoronaphthalene and 10.0 g of THF was added dropwise to the mixture over 20 minutes, and a reaction was allowed to take place at room temperature for 24 hours. After the reaction, 50 g of pure water was added dropwise to the reaction product to quench the reaction. Subsequently, 100 ml of MIBK was added to the reaction product to perform layer separation. Then, the separated lower layer was removed. The remaining organic layer was washed twice with 50 g of a 3.0% aqueous solution of sodium hydroxide, three times with 50 g of a 3.0% aqueous solution of nitric acid, and five times with 100 g of pure water in this order, and the organic layer was evaporated under reduced pressure to dryness. To the residue, 50 g of THF was added, and 200 g of hexane was added dropwise while stirring to precipitate a glutinous cake-like precipitate. After leaving the resulting product to stand for some time, the transparent supernatant liquid was decanted. 50 g of THF was added again to form a homogeneous solution, and 200 g of hexane was added to precipitate a glutinous cake-like precipitate. After leaving the resulting product to stand, the supernatant liquid was decanted. To the residue, PGMEA (propylene glycol monomethyl ether acetate) was added, and distillation under reduced pressure and concentration adjustment were performed. Thus, a polymer (A6) was obtained as a solution in PGMEA having a polymer concentration of 30 wt%.

The weight-average molecular weight (Mw) and the dispersity (Mw/Mn) of the polymer (A6) were determined by GPC, and the following results were obtained.
(A6): Mw=6,300, Mw/Mn=3.19

### [Synthesis Example 7] Synthesis of Polymer (A7)

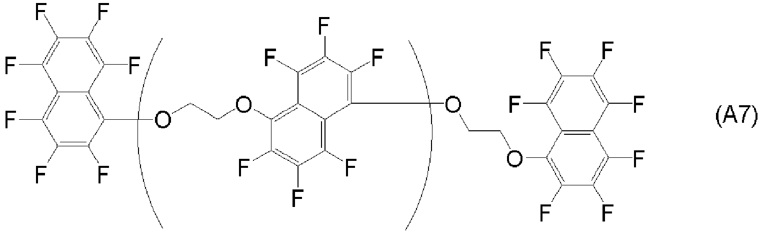

Under a nitrogen atmosphere, 2.79 g of the compound (a9) and 50.0 g of THF (tetrahydrofuran) were stirred in an ice bath to form a homogeneous solution. After that, 2.88 g of sodium hydride was added to the homogeneous solution, and the mixture was stirred for 1 hour. After that, a mixed solution of 13.60 g of octafluoronaphthalene and 10.0 g of THF was added dropwise to the mixture over 20 minutes, and a reaction was allowed to take place at room temperature for 24 hours. After the reaction, 50 g of pure water was added dropwise to the reaction product to quench the reaction. Subsequently, 100 ml of MIBK was added to the reaction product to perform layer separation. Then, the separated lower layer was removed. The remaining organic layer was washed twice with 50 g of a 3.0% aqueous solution of nitric acid and five times with 50 g of pure water in this order, and the organic layer was evaporated under reduced pressure to dryness. To the residue, 50 g of THF was added, and 200 g of hexane was added dropwise while stirring to precipitate a glutinous cake-like precipitate. After leaving the resulting product to stand for some time, the transparent supernatant liquid was decanted. 50 g of THF was added again to form a homogeneous solution, and 200 g of hexane was added to precipitate a glutinous cake-like precipitate. After leaving the resulting product to stand, the supernatant liquid was decanted. To the residue, PGMEA (propylene glycol monomethyl ether acetate) was added, and distillation under reduced pressure and concentration adjustment were performed. Thus, a polymer (A7) was obtained as a solution in PGMEA having a polymer concentration of 30 wt%.

The weight-average molecular weight (Mw) and the dispersity (Mw/Mn) of the polymer (A7) were determined by GPC, and the following results were obtained.
(A7): Mw=12,800, Mw/Mn=3.31

### [Synthesis Example 8] Synthesis of Polymer (A8)

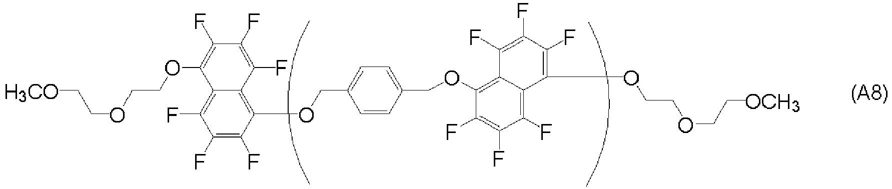

Under a nitrogen atmosphere, 6.22 g of the compound (a10) and 50.0 g of THF (tetrahydrofuran) were stirred in an ice bath to form a homogeneous solution. After that, 2.88 g of sodium hydride was added to the homogeneous solution, and the mixture was stirred for 1 hour. After that, a mixed solution of 13.60 g of octafluoronaphthalene and 10.0 g of THF was added dropwise to the mixture over 20 minutes, and a reaction was allowed to take place at room temperature for 16 hours. Then, 1.80 g of the compound (a11) was added dropwise, and a reaction was further allowed to take place for 8 hours. After the reaction, 50 g of pure water was added dropwise to the reaction product to quench the reaction. Subsequently, 100 ml of MIBK was added to the reaction product to perform layer separation. Then, the separated lower layer was removed. The remaining organic layer was washed three times with 50 g of a 2.0% aqueous solution of nitric acid and five times with 100 g of pure water in this order, and the organic layer was evaporated under reduced pressure to dryness. To the residue, 50 g of THF was added, and 200 g of hexane was added dropwise while stirring to precipitate a glutinous cake-like precipitate. After leaving the resulting product to stand for some time, the transparent supernatant liquid was decanted. 50 g of THF was added again to form a homogeneous solution, and 200 g of hexane was added to precipitate a glutinous cake-like precipitate. After leaving the resulting product to stand, the supernatant liquid was decanted. To the residue, PGMEA (propylene glycol monomethyl ether acetate) was added, and distillation under reduced pressure and concentration adjustment were performed. Thus, a polymer (A8) was obtained as a solution in PGMEA having a polymer concentration of 30 wt%.

The weight-average molecular weight (Mw) and the dispersity (Mw/Mn) of the polymer (A8) were determined by GPC, and the following results were obtained.
(A8): Mw=14,300, Mw/Mn=4.04

### [Synthesis of Comparative Polymers (R1) to (R5)]

For the synthesis of comparative polymers (R1) to (R5), used for the preparation of comparative compositions (comparative UDL) for forming an organic film, the following monomers (r1) to (r6) were used.

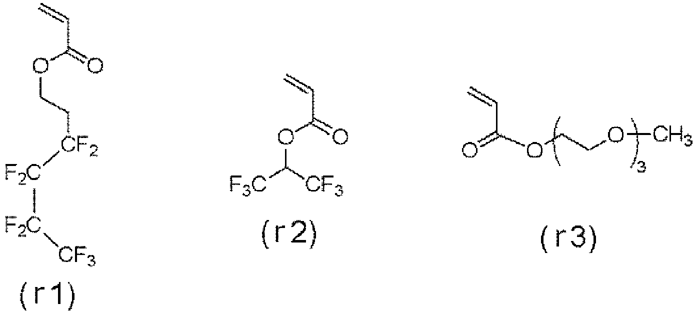

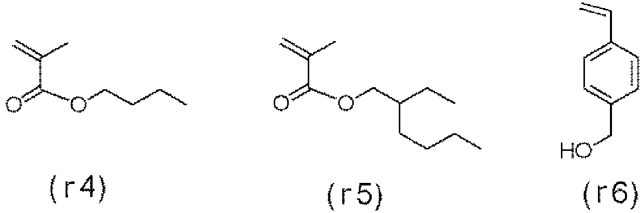

### [Comparative Synthesis Example 1] Synthesis of Comparative Polymer (R1)

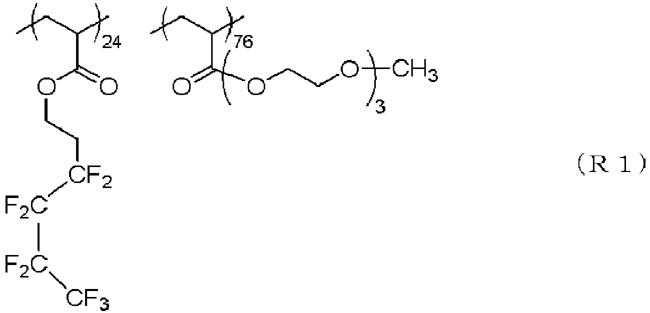

Under a nitrogen atmosphere, 6.0 g of propylene glycol monomethyl ether acetate (PGMEA) was heated and stirred at 80°C. A mixture of 3.44 g (0.011 mol) of the monomer (r1), 7.46 g (0.034 mol) of the monomer (r3), 0.473 g of dimethyl 2,2-azobis(2-methylpropionate), and 34 g of PGMEA was added dropwise thereto over 4 hours. The mixture was further heated and stirred for 16 hours, and then cooled to room temperature. Thus, a solution of the target comparative polymer (R1) in PGMEA was obtained.

The weight-average molecular weight (Mw) and the dispersity (Mw/Mn) of the comparative polymer (R1) were determined by GPC, and the following results were obtained.
(R1): Mw=9,500, Mw/Mn=1.20

### [Comparative Synthesis Example 2] Synthesis of Comparative Polymer (R2)

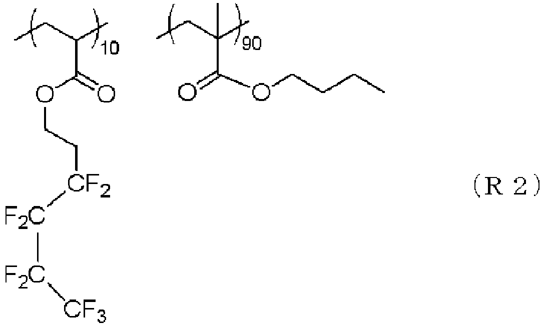

Under a nitrogen atmosphere, 6.0 g of propylene glycol monomethyl ether acetate (PGMEA) was heated and stirred at 80°C. A mixture of 1.43 g (0.005 mol) of the monomer (r1), 5.76 g (0.041 mol) of the monomer (r4), 0.473 g of dimethyl 2,2-azobis(2-methylpropionate), and 34 g of PGMEA was added dropwise thereto over 4 hours. The mixture was further heated and stirred for 16 hours, and then cooled to room temperature. Thus, a solution of the target comparative polymer (R2) in PGMEA was obtained.

The weight-average molecular weight (Mw) and the dispersity (Mw/Mn) of the comparative polymer (R2) were determined by GPC, and the following results were obtained.
(R2): Mw=5,800, Mw/Mn=1.42

### [Comparative Synthesis Example 3] Synthesis of Comparative Polymer (R3)

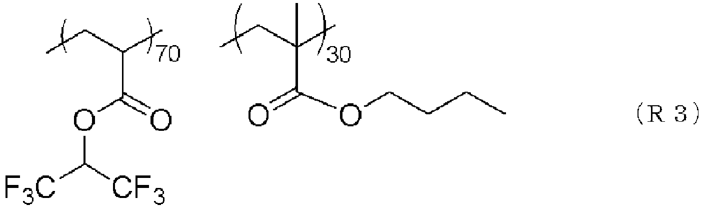

Under a nitrogen atmosphere, 6.0 g of propylene glycol monomethyl ether acetate (PGMEA) was heated and stirred at 80°C. A mixture of 7.00 g (0.032 mol) of the monomer (r2), 1.92 g (0.014 mol) of the monomer (r4), 0.473 g of dimethyl 2,2-azobis(2-methylpropionate), and 34 g of PGMEA was added dropwise thereto over 4 hours. The mixture was further heated and stirred for 16 hours, and then cooled to room temperature. Thus, a solution of the target comparative polymer (R3) in PGMEA was obtained.

The weight-average molecular weight (Mw) and the dispersity (Mw/Mn) of the comparative polymer (R3) were determined by GPC, and the following results were obtained.
(R3): Mw=6,200, Mw/Mn=1.33

### [Comparative Synthesis Example 4] Synthesis of Comparative Polymer (R4)

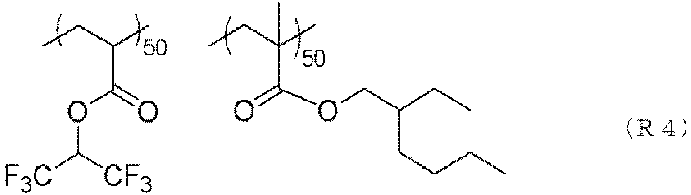

Under a nitrogen atmosphere, 6.0 g of propylene glycol monomethyl ether acetate (PGMEA) was heated and stirred at 80°C. A mixture of 5.00 g (0.023 mol) of the monomer (r2), 3.20 g (0.023 mol) of the monomer (r5), 0.473 g of dimethyl 2,2-azobis(2-methylpropionate), and 34 g of PGMEA was added dropwise thereto over 4 hours. The mixture was further heated and stirred for 16 hours, and then cooled to room temperature. Thus, a solution of the target comparative polymer (R4) in PGMEA was obtained.

The weight-average molecular weight (Mw) and the dispersity (Mw/Mn) of the comparative polymer (R4) were determined by GPC, and the following results were obtained.
(R4): Mw=8,300, Mw/Mn=1.33

### [Comparative Synthesis Example 5] Synthesis of Comparative Polymer (R5)

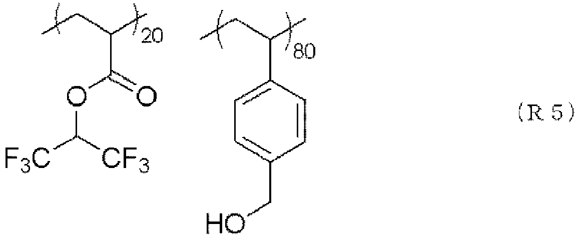

Under a nitrogen atmosphere, 6.0 g of propylene glycol monomethyl ether acetate (PGMEA) was heated and stirred at 80°C. A mixture of 2.00 g (0.009 mol) of the monomer (r2), 5.41 g (0.036 mol) of the monomer (r6), 0.473 g of dimethyl 2,2-azobis(2-methylpropionate), and 34 g of PGMEA was added dropwise thereto over 4 hours. The mixture was further heated and stirred for 16 hours, and then cooled to room temperature. Thus, a solution of the target comparative polymer (R5) in PGMEA was obtained.

The weight-average molecular weight (Mw) and the dispersity (Mw/Mn) of the comparative polymer (R5) were determined by GPC, and the following results were obtained.
(R5): Mw=3,800, Mw/Mn=1.44

### [Resins for Forming Organic Film]

B1: a resin represented by the following formula (B1)
B2: a resin represented by the following formula (B2)
B3: a compound represented by the following formula (B3)
B4: a compound represented by the following formula (B4)
B5: a resin represented by the following formula (B5)
B6: a resin represented by the following formula (B6)

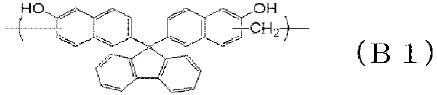

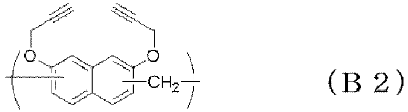

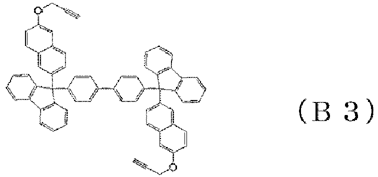

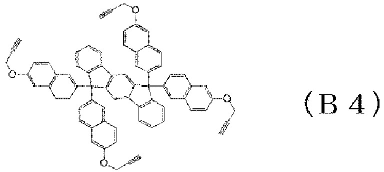

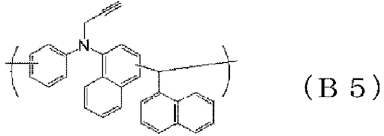

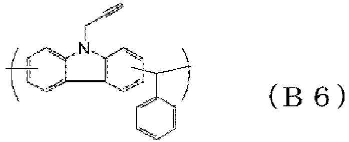

### [Solvents]

(C1): propylene glycol monomethyl ether acetate
(C2): propylene glycol monoethyl ether

### [Preparation of Compositions (UDL-1 to -59 and Comparative UDL-1 to -11) for Forming Organic Film]

One of the polymers (A1) to (A8) or one of the comparative polymers (R1) to (R5), and one of the resins (B1) to (B6) for forming an organic film were dissolved in the solvent (C1) or a mixed solvent of the solvent (C1) and the solvent (C2) in the proportions shown in Tables 1 to 3. Then, the obtained mixture was filtered through a 0.1-µm filter made of a fluorinated resin to prepare each of compositions (resist underlayer film materials: UDL-1 to -59 and comparative UDL-1 to -11) for forming an organic film.

**[Table 1]**

| Composition for forming organic film | Resin for forming organic film | | Polymer | | Solvent 1 | | Solvent 2 | |
|---|---|---|---|---|---|---|---|---|
| | Type | Parts by mass | Type | Parts by mass | Type | Parts by mass | Type | Parts by mass |
| UDL-1 | (B1) | 10.00 | (A1) | 0.10 | (C1) | 89.90 | | |
| UDL-2 | (B1) | 10.00 | (A2) | 0.10 | (C1) | 89.90 | | |
| UDL-3 | (B1) | 10.00 | (A3) | 0.10 | (C1) | 89.90 | | |
| UDL-4 | (B1) | 10.00 | (A4) | 0.10 | (C1) | 89.90 | | |
| UDL-5 | (B1) | 10.00 | (A5) | 0.10 | (C1) | 89.90 | | |
| UDL-6 | (B1) | 10.00 | (A6) | 0.10 | (C1) | 89.90 | | |
| UDL-7 | (B1) | 10.00 | (A7) | 0.10 | (C1) | 89.90 | | |
| UDL-8 | (B1) | 10.00 | (A8) | 0.10 | (C1) | 89.90 | | |
| UDL-9 | (B1) | 10.00 | (A1) | 0.10 | (C1) | 62.93 | (C2) | 26.97 |
| UDL-10 | (B1) | 10.00 | (A2) | 0.10 | (C1) | 62.93 | (C2) | 26.97 |
| UDL-11 | (B1) | 10.00 | (A3) | 0.10 | (C1) | 62.93 | (C2) | 26.97 |
| UDL-12 | (B1) | 10.00 | (A4) | 0.10 | (C1) | 62.93 | (C2) | 26.97 |
| UDL-13 | (B1) | 10.00 | (A5) | 0.10 | (C1) | 62.93 | (C2) | 26.97 |
| UDL-14 | (B1) | 10.00 | (A6) | 0.10 | (C1) | 62.93 | (C2) | 26.97 |
| UDL-15 | (B1) | 10.00 | (A7) | 0.10 | (C1) | 62.93 | (C2) | 26.97 |
| UDL-16 | (B1) | 10.00 | (A8) | 0.10 | (C1) | 62.93 | (C2) | 26.97 |
| UDL-17 | (B1) | 10.00 | (A1) | 1.00 | (C1) | 89.00 | | |
| UDL-18 | (B1) | 10.00 | (A1) | 0.50 | (C1) | 89.50 | | |
| UDL-19 | (B1) | 10.00 | (A1) | 0.001 | (C1) | 90.00 | | |
| UDL-20 | (B2) | 10.00 | (A1) | 0.10 | (C1) | 89.90 | | |
| UDL-21 | (B2) | 10.00 | (A2) | 0.10 | (C1) | 89.90 | | |
| UDL-22 | (B2) | 10.00 | (A3) | 0.10 | (C1) | 89.90 | | |
| UDL-23 | (B2) | 10.00 | (A4) | 0.10 | (C1) | 89.90 | | |
| UDL-24 | (B2) | 10.00 | (A5) | 0.10 | (C1) | 89.90 | | |
| UDL-25 | (B2) | 10.00 | (A6) | 0.10 | (C1) | 89.90 | | |
| UDL-26 | (B2) | 10.00 | (A7) | 0.10 | (C1) | 89.90 | | |
| UDL-27 | (B2) | 10.00 | (A8) | 0.10 | (C1) | 89.90 | | |
| UDL-28 | (B3) | 10.00 | (A1) | 0.10 | (C1) | 89.90 | | |
| UDL-29 | (B3) | 10.00 | (A2) | 0.10 | (C1) | 89.90 | | |
| UDL-30 | (B3) | 10.00 | (A3) | 0.10 | (C1) | 89.90 | | |
| UDL-31 | (B3) | 10.00 | (A4) | 0.10 | (C1) | 89.90 | | |

**[Table 2]**

| Composition for forming organic film | Resin for forming organic film | | Polymer | | Solvent 1 | | Solvent 2 | |
|---|---|---|---|---|---|---|---|---|
| | Type | Parts by mass | Type | Parts by mass | Type | Parts by mass | Type | Parts by mass |
| UDL-32 | (B3) | 10.00 | (A5) | 0.10 | (C1) | 89.90 | | |
| UDL-33 | (B3) | 10.00 | (A6) | 0.10 | (C1) | 89.90 | | |
| UDL-34 | (B3) | 10.00 | (A7) | 0.10 | (C1) | 89.90 | | |
| UDL-35 | (B3) | 10.00 | (A8) | 0.10 | (C1) | 89.90 | | |
| UDL-36 | (B4) | 10.00 | (A1) | 0.10 | (C1) | 89.90 | | |
| UDL-37 | (B4) | 10.00 | (A2) | 0.10 | (C1) | 89.90 | | |
| UDL-38 | (B4) | 10.00 | (A3) | 0.10 | (C1) | 89.90 | | |
| UDL-39 | (B4) | 10.00 | (A4) | 0.10 | (C1) | 89.90 | | |
| UDL-40 | (B4) | 10.00 | (A5) | 0.10 | (C1) | 89.90 | | |
| UDL-41 | (B4) | 10.00 | (A6) | 0.10 | (C1) | 89.90 | | |
| UDL-42 | (B4) | 10.00 | (A7) | 0.10 | (C1) | 89.90 | | |
| UDL-43 | (B4) | 10.00 | (A8) | 0.10 | (C1) | 89.90 | | |
| UDL-44 | (B5) | 10.00 | (A1) | 0.10 | (C1) | 89.90 | | |
| UDL-45 | (B5) | 10.00 | (A2) | 0.10 | (C1) | 89.90 | | |
| UDL-46 | (B5) | 10.00 | (A3) | 0.10 | (C1) | 89.90 | | |
| UDL-47 | (B5) | 10.00 | (A4) | 0.10 | (C1) | 89.90 | | |
| UDL-48 | (B5) | 10.00 | (A5) | 0.10 | (C1) | 89.90 | | |
| UDL-49 | (B5) | 10.00 | (A6) | 0.10 | (C1) | 89.90 | | |
| UDL-50 | (B5) | 10.00 | (A7) | 0.10 | (C1) | 89.90 | | |
| UDL-51 | (B5) | 10.00 | (A8) | 0.10 | (C1) | 89.90 | | |
| UDL-52 | (B6) | 10.00 | (A1) | 0.10 | (C1) | 89.90 | | |
| UDL-53 | (B6) | 10.00 | (A2) | 0.10 | (C1) | 89.90 | | |
| UDL-54 | (B6) | 10.00 | (A3) | 0.10 | (C1) | 89.90 | | |
| UDL-55 | (B6) | 10.00 | (A4) | 0.10 | (C1) | 89.90 | | |
| UDL-56 | (B6) | 10.00 | (A5) | 0.10 | (C1) | 89.90 | | |
| UDL-57 | (B6) | 10.00 | (A6) | 0.10 | (C1) | 89.90 | | |
| UDL-58 | (B6) | 10.00 | (A7) | 0.10 | (C1) | 89.90 | | |
| UDL-59 | (B6) | 10.00 | (A8) | 0.10 | (C1) | 89.90 | | |

**[Table 3]**

| Composition for forming organic film | Resin for forming organic film | | Polymer | | Solvent 1 | | Solvent 2 | |
|---|---|---|---|---|---|---|---|---|
| | Type | Parts by mass | Type | Parts by mass | Type | Parts by mass | Type | Parts by mass |
| Comparative UDL-1 | (B1) | 10.00 | (R1) | 0.10 | (C1) | 89.90 | | |
| Comparative UDL-2 | (B2) | 10.00 | (R2) | 0.10 | (C1) | 89.90 | | |
| Comparative UDL-3 | (B3) | 10.00 | (R3) | 0.10 | (C1) | 89.90 | | |
| Comparative UDL-4 | (B4) | 10.00 | (R4) | 0.10 | (C1) | 89.90 | | |
| Comparative UDL-5 | (B5) | 10.00 | (R5) | 0.10 | (C1) | 89.90 | | |
| Comparative UDL-6 | (B1) | 10.00 | | | (C1) | 90.00 | | |
| Comparative UDL-7 | (B2) | 10.00 | | | (C1) | 90.00 | | |
| Comparative UDL-8 | (B3) | 10.00 | | | (C1) | 90.00 | | |
| Comparative UDL-9 | (B4) | 10.00 | | | (C1) | 90.00 | | |
| Comparative UDL-10 | (B5) | 10.00 | | | (C1) | 90.00 | | |
| Comparative UDL-11 | (B6) | 10.00 | | | (C1) | 90.00 | | |

### [Preparation of Silicon Wafers Having Organic Film Formed Thereon By Using Compositions (UDL-1 to -59 and Comparative UDL-1 to -11) for Forming Organic Film]

Using a coater/developer "CLEAN TRACK LITHIUS Pro AP" of Tokyo Electron Ltd., each of the compositions (UDL-1 to -59 and comparative UDL-1 to -11) for forming an organic film prepared above was respectively discharged in an amount of 2 ml onto a silicon wafer at the center and baked. Then, the wafer was rotated at a rotational rate to achieve the average film thickness shown in Tables 4 to 6 to spread the composition, and thus, a coating film was obtained. While rotating the silicon wafer at a rate of 1,000 rpm, the remover-discharging nozzle was moved at a speed of 5 mm/s from the periphery of the silicon wafer to a position 3 mm from the center while discharging a remover (mixed solution of propylene glycol monomethyl ether acetate and propylene glycol monomethyl ether (30:70, mass ratio)) at a discharge rate of 2 ml/s, and the remover was further discharged at that position for 5 seconds at a discharge rate of 2 ml/s (EBR process). After that, the discharging of the discharged liquid was terminated, and the wafer was further rotated at a rate of 1,000 rpm for 30 seconds. Next, the silicon wafer, having the coating film formed thereon, was heated at 350°C for 60 seconds to cure the coating film. Thus, silicon wafers having an organic film formed were obtained.

### [Solvent Resistance Evaluation: Examples 1-1 to 1-59 and Comparative Examples 1-1 to 1-11]

The film thickness of each of the organic films formed on the silicon wafers by the above-described method by using each of the compositions (UDL-1 to -59 and comparative UDL-1 to -11) for forming an organic film was measured. Subsequently, a PGMEA solvent was dispensed thereon, the wafer was left to stand for 30 seconds, spin-dried, and baked at 100°C for 60 seconds to evaporate the PGMEA, and then the film thickness of the organic film was measured. The absolute value of the value determined by [(X₁-X)/X]×100 was obtained as a film thickness change rate (%), where X is the film thickness before dispensing the PGMEA solvent, and X₁ is the film thickness after the PGMEA solvent was dispensed. When the film thickness change rate was lower than 0.5%, the composition was evaluated as "Good", and when 0.5% or higher, "Poor". Tables 4 to 6 show the results.

### [In-Plane Uniformity Evaluation: Examples 1-1 to 1-59 and Comparative Examples 1-1 to 1-11]

Regarding each of the organic films formed on the silicon wafers by the above-described method by using each of the compositions (UDL-1 to -59 and comparative UDL-1 to -11) for forming an organic film, the film thickness within a radius of 145 mm from the center was measured. The value determined by (Xₘₐₓ-Xₘᵢₙ)/X_{average} was obtained as in-plane uniformity (%), where Xₘₐₓ is the maximum value of the measured film thickness, Xₘᵢₙ is the minimum value of the film thickness, and X_{average} is the average film thickness. When the in-plane uniformity was less than 2%, the composition was evaluated as A (very good), when 2% or more to less than 3%, B (good), and when 3% or more, C (poor). Tables 4 to 6 show the results.

**[Table 4]**

| | Composition for forming organic film | Average film thickness | Solvent resistance | In-plane uniformity |
|---|---|---|---|---|
| Example 1-1 | UDL-1 | 500 nm | Good | A |
| Example 1-2 | UDL-2 | 500 nm | Good | A |
| Example 1-3 | UDL-3 | 500 nm | Good | A |
| Example 1-4 | UDL-4 | 500 nm | Good | A |
| Example 1-5 | UDL-5 | 500 nm | Good | A |
| Example 1-6 | UDL-6 | 500 nm | Good | A |
| Example 1-7 | UDL-7 | 500 nm | Good | A |
| Example 1-8 | UDL-8 | 500 nm | Good | A |
| Example 1-9 | UDL-9 | 500 nm | Good | A |
| Example 1-10 | UDL-10 | 500 nm | Good | A |
| Example 1-11 | UDL-11 | 500 nm | Good | A |
| Example 1-12 | UDL-12 | 500 nm | Good | A |
| Example 1-13 | UDL-13 | 500 nm | Good | A |
| Example 1-14 | UDL-14 | 500 nm | Good | A |
| Example 1-15 | UDL-15 | 500 nm | Good | A |
| Example 1-16 | UDL-16 | 500 nm | Good | A |
| Example 1-17 | UDL-17 | 500 nm | Good | B |
| Example 1-18 | UDL-18 | 500 nm | Good | A |
| Example 1-19 | UDL-19 | 500 nm | Good | B |
| Example 1-20 | UDL-20 | 500 nm | Good | A |
| Example 1-21 | UDL-21 | 500 nm | Good | A |
| Example 1-22 | UDL-22 | 500 nm | Good | A |
| Example 1-23 | UDL-23 | 500 nm | Good | A |
| Example 1-24 | UDL-24 | 500 nm | Good | A |
| Example 1-25 | UDL-25 | 500 nm | Good | A |
| Example 1-26 | UDL-26 | 500 nm | Good | A |
| Example 1-27 | UDL-27 | 500 nm | Good | A |
| Example 1-28 | UDL-28 | 500 nm | Good | A |
| Example 1-29 | UDL-29 | 500 nm | Good | A |
| Example 1-30 | UDL-30 | 500 nm | Good | A |
| Example 1-31 | UDL-31 | 500 nm | Good | A |

**[Table 5]**

| | Composition for forming organic film | Average film thickness | Solvent resistance | In-plane uniformity |
|---|---|---|---|---|
| Example 1-32 | UDL-32 | 500 nm | Good | A |
| Example 1-33 | UDL-33 | 500 nm | Good | A |
| Example 1-34 | UDL-34 | 500 nm | Good | A |
| Example 1-35 | UDL-35 | 500 nm | Good | A |
| Example 1-36 | UDL-36 | 500 nm | Good | A |
| Example 1-37 | UDL-37 | 500 nm | Good | A |
| Example 1-38 | UDL-38 | 500 nm | Good | A |
| Example 1-39 | UDL-39 | 500 nm | Good | A |
| Example 1-40 | UDL-40 | 500 nm | Good | A |
| Example 1-41 | UDL-41 | 500 nm | Good | A |
| Example 1-42 | UDL-42 | 500 nm | Good | A |
| Example 1-43 | UDL-43 | 500 nm | Good | A |
| Example 1-44 | UDL-44 | 500 nm | Good | A |
| Example 1-45 | UDL-45 | 500 nm | Good | A |
| Example 1-46 | UDL-46 | 500 nm | Good | A |
| Example 1-47 | UDL-47 | 500 nm | Good | A |
| Example 1-48 | UDL-48 | 500 nm | Good | A |
| Example 1-49 | UDL-49 | 500 nm | Good | A |
| Example 1-50 | UDL-50 | 500 nm | Good | A |
| Example 1-51 | UDL-51 | 500 nm | Good | A |
| Example 1-52 | UDL-52 | 500 nm | Good | A |
| Example 1-53 | UDL-53 | 500 nm | Good | A |
| Example 1-54 | UDL-54 | 500 nm | Good | A |
| Example 1-55 | UDL-55 | 500 nm | Good | A |
| Example 1-56 | UDL-56 | 500 nm | Good | A |
| Example 1-57 | UDL-57 | 500 nm | Good | A |
| Example 1-58 | UDL-58 | 500 nm | Good | A |
| Example 1-59 | UDL-59 | 500 nm | Good | A |

**[Table 6]**

| | Composition for forming organic film | Average film thickness | Solvent resistance | In-plane uniformity |
|---|---|---|---|---|
| Comparative Example 1-1 | Comparative UDL-1 | 500 nm | Good | A |
| Comparative Example 1-2 | Comparative UDL-2 | 500 nm | Good | A |
| Comparative Example 1-3 | Comparative UDL-3 | 500 nm | Good | A |
| Comparative Example 1-4 | Comparative UDL-4 | 500 nm | Good | A |
| Comparative Example 1-5 | Comparative UDL-5 | 500 nm | Good | A |
| Comparative Example 1-6 | Comparative UDL-6 | 500 nm | Good | C |
| Comparative Example 1-7 | Comparative UDL-7 | 500 nm | Good | C |
| Comparative Example 1-8 | Comparative UDL-8 | 500 nm | Good | C |
| Comparative Example 1-9 | Comparative UDL-9 | 500 nm | Good | C |
| Comparative Example 1-10 | Comparative UDL-10 | 500 nm | Good | C |
| Comparative Example 1-11 | Comparative UDL-11 | 500 nm | Good | C |

### [Hump Suppression Property Evaluation: Examples 2-1 to 2-59 and Comparative Examples 2-1 to 2-5]

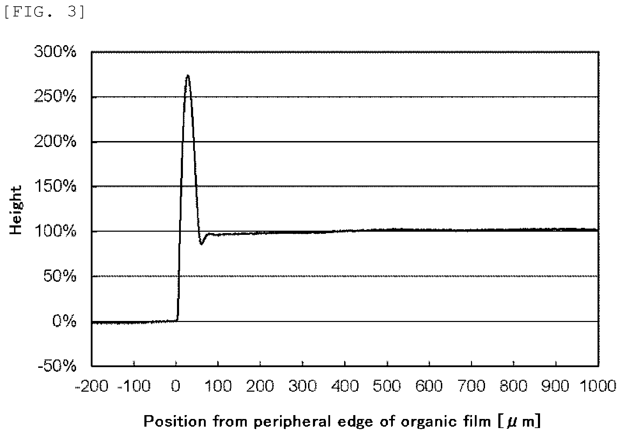

Regarding each of the organic films formed on the silicon wafers by the above-described method by using each of the compositions (UDL-1 to -59 and comparative UDL-1 to -5) for forming an organic film, the change in height as the position changes from the peripheral edge of the organic film towards the center of the silicon wafer to a position of 1,000 um was measured by using Alpha-Step D-600 (a stylus profiler) manufactured by KLA corporation. The height of the silicon wafer was set to 0, and when the maximum height was less than 110% of the film thickness as shown in FIG. 2, the composition was evaluated as A (very good), when the maximum height was 110% or more to less than 150%, B (good), and when a region where the height was 150% or more occurred as shown in FIG. 3, C (poor). Tables 7 to 9 show the results.

### [Filling Property Evaluation: Examples 2-1 to 2-59 and Comparative Examples 2-1 to 2-5]

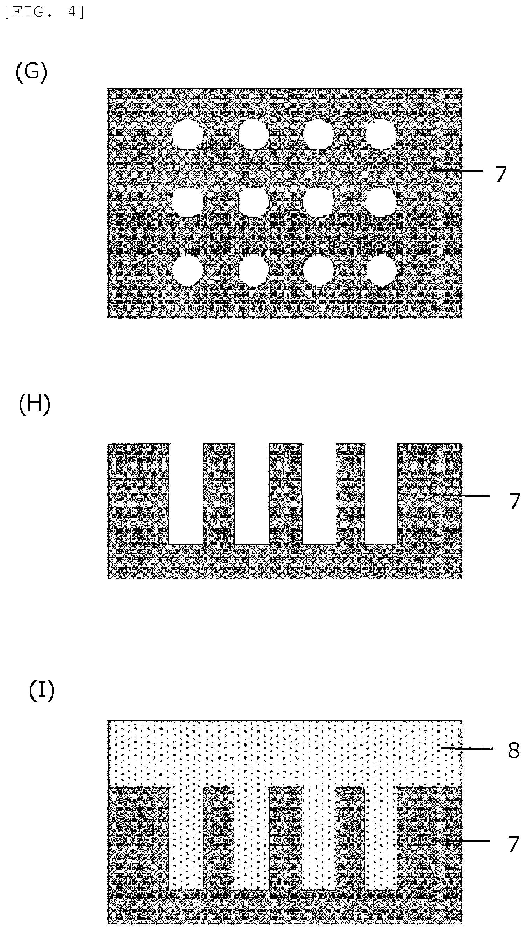

As shown in FIG. 4, an organic film 8 was formed on an SiO₂ wafer substrate having a dense hole pattern (hole diameter 0.2 um, hole depth 1.0 um, distance between the centers of two adjacent holes 0.4 µm) by using each of the compositions (UDL-1 to -59 and comparative UDL-1 to -5) for forming an organic film respectively by the same method as that described above. The substrate used was a base substrate (SiO₂ wafer substrate) 7 having the dense hole pattern shown in FIG. 4 (G) (downward view) and (H) (cross-sectional view). The cross-sectional shape of each of the obtained wafer substrates was observed using a scanning electron microscope (SEM), and it was observed whether or not the inside of the holes was filled with the organic film without gaps. When a composition for forming an organic film having poor filling property is used, gaps are generated inside the holes. When a composition for forming an organic film having a desirable filling property is used in the present evaluation, the inside of the holes is filled with the organic film 8 without gaps, as shown in FIG. 4 (I). The composition was evaluated as "Good" when no gaps were generated, and when gaps were generated, as "Poor". Tables 7 to 9 show the results.

**[Table 7]**

| | Composition for forming organic film | Hump suppression evaluation | Filling property evaluation |
|---|---|---|---|
| Example 2-1 | UDL-1 | A | Good |
| Example 2-2 | UDL-2 | B | Good |
| Example 2-3 | UDL-3 | B | Good |
| Example 2-4 | UDL-4 | B | Good |
| Example 2-5 | UDL-5 | B | Good |
| Example 2-6 | UDL-6 | A | Good |
| Example 2-7 | UDL-7 | B | Good |
| Example 2-8 | UDL-8 | A | Good |
| Example 2-9 | UDL-9 | A | Good |
| Example 2-10 | UDL-10 | B | Good |
| Example 2-11 | UDL-11 | B | Good |
| Example 2-12 | UDL-12 | B | Good |
| Example 2-13 | UDL-13 | B | Good |
| Example 2-14 | UDL-14 | A | Good |
| Example 2-15 | UDL-15 | B | Good |
| Example 2-16 | UDL-16 | A | Good |
| Example 2-17 | UDL-17 | A | Good |
| Example 2-18 | UDL-18 | A | Good |
| Example 2-19 | UDL-19 | A | Good |
| Example 2-20 | UDL-20 | A | Good |
| Example 2-21 | UDL-21 | B | Good |
| Example 2-22 | UDL-22 | B | Good |
| Example 2-23 | UDL-23 | B | Good |
| Example 2-24 | UDL-24 | B | Good |
| Example 2-25 | UDL-25 | A | Good |
| Example 2-26 | UDL-26 | B | Good |
| Example 2-27 | UDL-27 | A | Good |
| Example 2-28 | UDL-28 | A | Good |
| Example 2-29 | UDL-29 | B | Good |
| Example 2-30 | UDL-30 | B | Good |
| Example 2-31 | UDL-31 | B | Good |

**[Table 8]**

| | Composition for forming organic film | Hump suppression evaluation | Filling property evaluation |
|---|---|---|---|
| Example 2-32 | UDL-32 | B | Good |
| Example 2-33 | UDL-33 | A | Good |
| Example 2-34 | UDL-34 | B | Good |
| Example 2-35 | UDL-35 | A | Good |
| Example 2-36 | UDL-36 | A | Good |
| Example 2-37 | UDL-37 | B | Good |
| Example 2-38 | UDL-38 | B | Good |
| Example 2-39 | UDL-39 | B | Good |
| Example 2-40 | UDL-40 | B | Good |
| Example 2-41 | UDL-41 | A | Good |
| Example 2-42 | UDL-42 | B | Good |
| Example 2-43 | UDL-43 | A | Good |
| Example 2-44 | UDL-44 | A | Good |
| Example 2-45 | UDL-45 | B | Good |
| Example 2-46 | UDL-46 | B | Good |
| Example 2-47 | UDL-47 | B | Good |
| Example 2-48 | UDL-48 | B | Good |
| Example 2-49 | UDL-49 | A | Good |
| Example 2-50 | UDL-50 | B | Good |
| Example 2-51 | UDL-51 | A | Good |
| Example 2-52 | UDL-52 | A | Good |
| Example 2-53 | UDL-53 | B | Good |
| Example 2-54 | UDL-54 | B | Good |
| Example 2-55 | UDL-55 | B | Good |
| Example 2-56 | UDL-56 | B | Good |
| Example 2-57 | UDL-57 | A | Good |
| Example 2-58 | UDL-58 | B | Good |
| Example 2-59 | UDL-59 | A | Good |

**[Table 9]**

| | Composition for forming organic film | Hump suppression evaluation | Filling property evaluation |
|---|---|---|---|
| Comparative Example 2-1 | Comparative UDL-1 | C | Poor |
| Comparative Example 2-2 | Comparative UDL-2 | C | Poor |
| Comparative Example 2-3 | Comparative UDL-3 | C | Poor |
| Comparative Example 2-4 | Comparative UDL-4 | C | Poor |
| Comparative Example 2-5 | Comparative UDL-5 | A | Poor |

As shown in Tables 4, 5, 7, and 8, it was confirmed that the inventive compositions (UDL-1 to -59) for forming an organic film were excellent in all of solvent resistance, in-plane uniformity, hump suppression property, and filling property.

On the other hand, as shown in Tables 6 and 9, it was confirmed that comparative UDL-1 to -11, not containing the inventive composition for forming an organic film, had a poor result in one or more of in-plane uniformity, hump suppression property, and filling property.

### [Patterning Test: Examples 3-1 to 3-59]

An organic film was formed respectively on an SiO₂ wafer substrate by using each of the compositions (UDL-1 to -59) for forming an organic film by the same method as that described above. Subsequently, the silicon-containing resist middle layer film material (SOG1) described below was applied thereto, and baking was performed at 200°C for 60 seconds to form a 35-nm thick silicon-containing resist middle layer film. Subsequently, the monolayer resist for ArF described below was applied thereto as a resist upper layer film material and baked at 105°C for 60 seconds to form a 100-nm thick photoresist film. Subsequently, the liquid immersion top coat composition (TC-1) described below was applied to the photoresist film and baked at 90°C for 60 seconds to form a 50-nm thick top coat.

As the silicon-containing resist middle layer film material (SOG1), a 2% solution of the following polymer in propylene glycol ethyl ether was prepared.

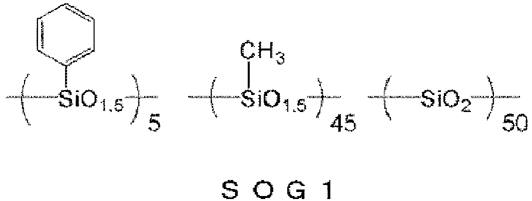

The resist upper layer film material (monolayer resist for ArF) was prepared in the following manner. A polymer (RP1), an acid generator (PAG1), and a basic compound (Amine1) were dissolved, each in the proportion shown in Table 10, in a solvent containing 0.1% by mass of FC-430 (manufactured by Sumitomo 3M Limited). Then, the obtained mixture was filtered through a 0.1-µm filter made of a fluororesin. Thus, the resist upper layer film material (monolayer resist for ArF) was prepared.

**[Table 10]**

| | Polymer (parts by mass) | Acid generator (parts by mass) | Basic compound (parts by mass) | Solvent (parts by mass) |
|---|---|---|---|---|
| Monolayer resist for ArF | RP1 (100) | PAG1 (6.6) | Amine1 (0.8) | PGMEA (2, 500) |

The polymer (RP1), the acid generator (PAG1), and the basic compound (Amine1) are shown below.

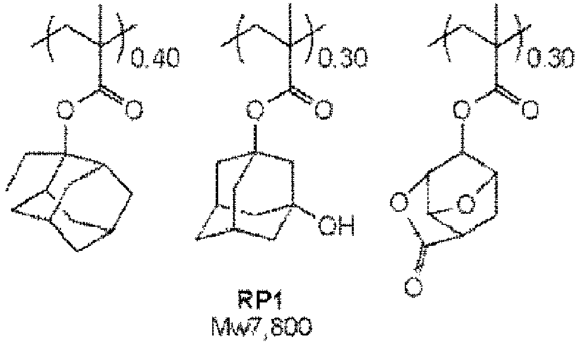

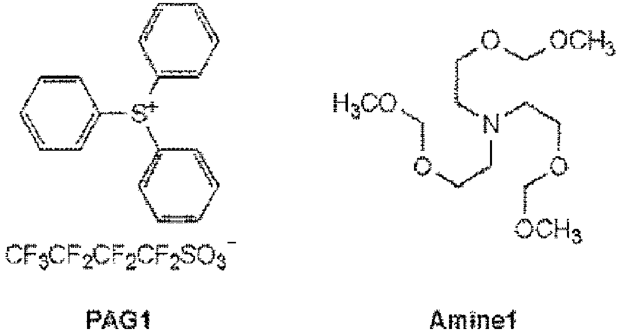

The liquid immersion top coat composition (TC-1) was prepared in the following manner. Firstly, a polymer (PP1) was dissolved in an organic solvent at the proportion shown in Table 11. Then, the obtained mixture was filtered through a 0.1-µm filter made of a fluororesin. Thus, the liquid immersion top coat composition was obtained.

**[Table 11]**

| | Polymer (parts by mass) | Organic solvent (parts by mass) |
|---|---|---|
| TC-1 | PP1 (100) | Diisoamyl ether (2,700) |
| | | 2-methyl-1-butanol (270) |

The polymer (PP1) is shown below.

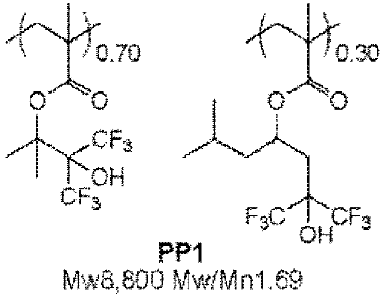

Then, the resist upper layer film was subjected to pattern exposure with an ArF liquid immersion exposure apparatus (NSR-S610C manufactured by Nikon Corporation, NA: 1.30, σ: 0.98/0.65, 35° s-polarized dipole illumination, 6% halftone phase shift mask). After that, the resist upper layer film was baked at 100°C for 60 seconds (PEB), and then developed with a 2.38% by mass aqueous solution of tetramethylammonium hydroxide (TMAH) for 30 seconds. Thus, a 55 nm 1:1 positive line-and-space pattern (a resist upper layer film pattern) was obtained.

Subsequently, the silicon-containing resist middle layer film was dry-etched (the pattern was transferred) by using an etching apparatus Telius manufactured by Tokyo Electron Ltd. while using the resist upper layer film pattern as a mask to obtain a silicon-containing resist middle layer film pattern.

Subsequently, the organic film was dry-etched (the pattern was transferred) while using the obtained silicon-containing resist middle layer film pattern as a mask to obtain an organic film pattern.

Subsequently, the SiO₂ wafer substrate (SiO₂ film) was dry-etched (the pattern was transferred) while using the obtained organic film pattern as a mask.

The etching conditions were as follows.

### Conditions in transferring resist upper layer film pattern to silicon-containing resist middle layer film

Chamber pressure: 10.0 Pa
RF-power: 1,500 W
CF₄ gas flow rate: 75 mL/min
O₂ gas flow rate: 15 mL/min
Time: 15 sec

### Conditions in transferring silicon-containing resist middle layer film pattern to organic film

Chamber pressure: 2.0 Pa
RF-power: 500 W
Ar gas flow rate: 75 mL/min
O₂ gas flow rate: 45 mL/min
Time: 120 sec

### Conditions in transferring organic film pattern to SiO₂ wafer substrate

Chamber pressure: 2.0 Pa
RF-power: 2,200 W
C₅F₁₂ gas flow rate: 20 mL/min
C₂F₆ gas flow rate: 10 mL/min
Ar gas flow rate: 300 mL/min
O₂ gas flow rate: 60 mL/min
Time: 90 sec

The cross section of the obtained pattern was observed with an electron microscope (S-4700) manufactured by Hitachi, Ltd. The results are shown in Tables 12 and 13.

**[Table 12]**

| | Composition for forming organic film | Profile after etching for transferring to substrate |
|---|---|---|
| Example 3-1 | UDL-1 | Good |
| Example 3-2 | UDL-2 | Good |
| Example 3-3 | UDL-3 | Good |
| Example 3-4 | UDL-4 | Good |
| Example 3-5 | UDL-5 | Good |
| Example 3-6 | UDL-6 | Good |
| Example 3-7 | UDL-7 | Good |
| Example 3-8 | UDL-8 | Good |
| Example 3-9 | UDL-9 | Good |
| Example 3-10 | UDL-10 | Good |
| Example 3-11 | UDL-11 | Good |
| Example 3-12 | UDL-12 | Good |
| Example 3-13 | UDL-13 | Good |
| Example 3-14 | UDL-14 | Good |
| Example 3-15 | UDL-15 | Good |
| Example 3-16 | UDL-16 | Good |
| Example 3-17 | UDL-17 | Good |
| Example 3-18 | UDL-18 | Good |
| Example 3-19 | UDL-19 | Good |
| Example 3-20 | UDL-20 | Good |
| Example 3-21 | UDL-21 | Good |
| Example 3-22 | UDL-22 | Good |
| Example 3-23 | UDL-23 | Good |
| Example 3-24 | UDL-24 | Good |
| Example 3-25 | UDL-25 | Good |
| Example 3-26 | UDL-26 | Good |
| Example 3-27 | UDL-27 | Good |
| Example 3-28 | UDL-28 | Good |
| Example 3-29 | UDL-29 | Good |
| Example 3-30 | UDL-30 | Good |
| Example 3-31 | UDL-31 | Good |

**[Table 13]**

| | Composition for forming organic film | Profile after etching for transferring to substrate |
|---|---|---|
| Example 3-32 | UDL-32 | Good |
| Example 3-33 | UDL-33 | Good |
| Example 3-34 | UDL-34 | Good |
| Example 3-35 | UDL-35 | Good |
| Example 3-36 | UDL-36 | Good |
| Example 3-37 | UDL-37 | Good |
| Example 3-38 | UDL-38 | Good |
| Example 3-39 | UDL-39 | Good |
| Example 3-40 | UDL-40 | Good |
| Example 3-41 | UDL-41 | Good |
| Example 3-42 | UDL-42 | Good |
| Example 3-43 | UDL-43 | Good |
| Example 3-44 | UDL-44 | Good |
| Example 3-45 | UDL-45 | Good |
| Example 3-46 | UDL-46 | Good |
| Example 3-47 | UDL-47 | Good |
| Example 3-48 | UDL-48 | Good |
| Example 3-49 | UDL-49 | Good |
| Example 3-50 | UDL-50 | Good |
| Example 3-51 | UDL-51 | Good |
| Example 3-52 | UDL-52 | Good |
| Example 3-53 | UDL-53 | Good |
| Example 3-54 | UDL-54 | Good |
| Example 3-55 | UDL-55 | Good |
| Example 3-56 | UDL-56 | Good |
| Example 3-57 | UDL-57 | Good |
| Example 3-58 | UDL-58 | Good |
| Example 3-59 | UDL-59 | Good |

As shown in Tables 12 and 13, in Examples 3-1 to 3-59, where the inventive compositions (UDL-1 to -59) for forming an organic film were used, the resist upper layer film pattern was successfully transferred to the SiO₂ wafer substrate in the end in every case. Thus, it was confirmed that the inventive composition for forming an organic film can be used suitably for fine processing using a multilayer resist method.

From the above, the inventive composition for forming an organic film has excellent film-formability, high filling property, and excellent hump suppression property, and therefore, is extremely useful as an organic film material used in a multilayer resist process. Furthermore, the inventive patterning processes, using the composition, make it possible to fill holes and trenches having very high aspect ratios without gaps, form a fine pattern with high precision, and form a hump-suppressed organic film, and therefore, make it possible to efficiently manufacture semiconductor devices and the like.

The present description includes the following embodiments.
[1] A composition for forming an organic film, comprising:
   (A) a polymer having a repeating unit represented by the following general formula (1);
   (B) a resin for forming an organic film; and
   (C) a solvent, 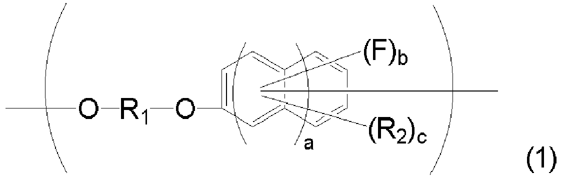
   wherein R₁ represents a divalent organic group having 2 to 30 carbon atoms including an aliphatic moiety or an aromatic moiety, each R₂ independently represents a hydrogen atom, an alkyl group having 1 to 6 carbon atoms, a hydroxy group, an alkoxy group having 1 to 6 carbon atoms, a halogen atom other than a fluorine atom, a cyano group, an amino group, or a nitro group, and "a" represents 0 or 1, "b" representing 1 to 4 and "c" representing 0 to 3 when "a" is 0, or "b" representing 1 to 6 and "c" representing 0 to 5 when "a" is 1.
[2] The composition for forming an organic film according to [1], wherein the polymer (A) contains one or more compounds represented by any of the following general formulae (2) to (4), 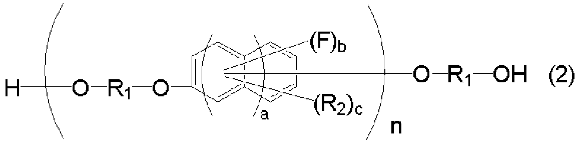 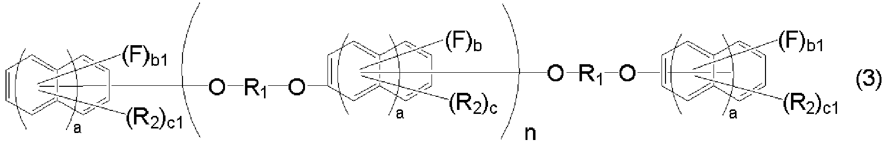 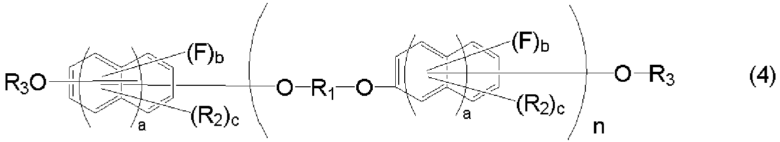 wherein R₁ and R₂ are as defined above; R₃ represents a monovalent organic group having 1 to 30 carbon atoms; "a" represents 0 or 1; "b" representing 1 to 4, "b1" representing 1 to 5, "c" representing 0 to 3, and "c1" representing 0 to 4 when "a" is 0, or "b" representing 1 to 6, "b1" representing 1 to 7, "c" representing 0 to 5, and "c1" representing 0 to 6 when "a" is 1; and "n" represents an average repeating unit number of 3 to 2,000.
[3] The composition for forming an organic film according to [1] or [2], wherein the polymer (A) is contained in an amount of 0.01 parts by mass to 5 parts by mass based on 100 parts by mass of the resin (B) for forming an organic film.
[4] A method for forming an organic film to be used in a manufacturing process of a semiconductor device, the method comprising:
   spin-coating a substrate to be processed with the composition for forming an organic film according to any one of [1] to [3] to obtain a coating film; and
   forming an organic film by heating the coating film at a temperature of 100°C or higher and 600°C or lower for 10 to 600 seconds to cure the coating film.
[5] A patterning process comprising:
   forming an organic film on a body to be processed by using the composition for forming an organic film according to any one of [1] to [3];
   forming a silicon-containing resist middle layer film on the organic film by using a silicon-containing resist middle layer film material;
   forming a resist upper layer film on the silicon-containing resist middle layer film by using a resist upper layer film material comprising a photoresist composition;
   forming a circuit pattern in the resist upper layer film;
   transferring the pattern to the silicon-containing resist middle layer film by etching while using the resist upper layer film having the formed circuit pattern as a mask;
   transferring the pattern to the organic film by etching while using the silicon-containing resist middle layer film having the transferred pattern as a mask; and
   further forming the pattern in the body to be processed by etching while using the organic film having the transferred pattern as a mask.
[6] A patterning process comprising:
   forming an organic film on a body to be processed by using the composition for forming an organic film according to any one of [1] to [3];
   forming a silicon-containing resist middle layer film on the organic film by using a silicon-containing resist middle layer film material;
   forming an organic antireflective film or an adhesive film on the silicon-containing resist middle layer film;
   forming a resist upper layer film on the organic antireflective film or the adhesive film by using a resist upper layer film material comprising a photoresist composition;
   forming a circuit pattern in the resist upper layer film;
   transferring the pattern to the organic antireflective film or the adhesive film and to the silicon-containing resist middle layer film by etching while using the resist upper layer film having the formed circuit pattern as a mask;
   transferring the pattern to the organic film by etching while using the silicon-containing resist middle layer film having the transferred pattern as a mask; and
   further forming the pattern in the body to be processed by etching while using the organic film having the transferred pattern as a mask.
[7] A patterning process comprising:
   forming an organic film on a body to be processed by using the composition for forming an organic film according to any one of [1] to [3];
   forming an inorganic hard mask middle layer film selected from the group consisting of a silicon oxide film, a silicon nitride film, and a silicon oxynitride film on the organic film;
   forming a resist upper layer film on the inorganic hard mask middle layer film by using a resist upper layer film material comprising a photoresist composition;
   forming a circuit pattern in the resist upper layer film;
   transferring the pattern to the inorganic hard mask middle layer film by etching while using the resist upper layer film having the formed circuit pattern as a mask;
   transferring the pattern to the organic film by etching while using the inorganic hard mask middle layer film having the transferred pattern as a mask; and
   further forming the pattern in the body to be processed by etching while using the organic film having the transferred pattern as a mask.
[8] A patterning process comprising:
   forming an organic film on a body to be processed by using the composition for forming an organic film according to any one of [1] to [3];
   forming an inorganic hard mask middle layer film selected from the group consisting of a silicon oxide film, a silicon nitride film, and a silicon oxynitride film on the organic film;
   forming an organic antireflective film or an adhesive film on the inorganic hard mask middle layer film;
   forming a resist upper layer film on the organic antireflective film or the adhesive film by using a resist upper layer film material comprising a photoresist composition;
   forming a circuit pattern in the resist upper layer film;
   transferring the pattern to the organic antireflective film or the adhesive film and to the inorganic hard mask middle layer film by etching while using the resist upper layer film having the formed circuit pattern as a mask;
   transferring the pattern to the organic film by etching while using the inorganic hard mask middle layer film having the transferred pattern as a mask; and
   further forming the pattern in the body to be processed by etching while using the organic film having the transferred pattern as a mask.
[9] The patterning process according to [7] or [8], wherein the inorganic hard mask middle layer film is formed by a CVD method or an ALD method.
[10] The patterning process according to any one of [5] to [9], wherein the circuit pattern is formed by a lithography using light having a wavelength of 10 nm or more and 300 nm or less, a direct writing with electron beam, nanoimprinting, or a combination thereof.
[11] The patterning process according to any one of [5] to [10], wherein the circuit pattern is developed with an alkaline development or an organic solvent.
[12] The patterning process according to any one of [5] to [11], wherein the body to be processed is a semiconductor device substrate or the semiconductor device substrate coated with any of a metal film, a metal carbide film, a metal oxide film, a metal nitride film, a metal oxycarbide film, and a metal oxynitride film.
[13] The patterning process according to [12], wherein the metal constituting the body to be processed contains silicon, titanium, tungsten, hafnium, zirconium, chromium, germanium, copper, silver, gold, aluminum, indium, gallium, arsenic, palladium, iron, tantalum, iridium, molybdenum, or an alloy thereof.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A composition for forming an organic film, comprising:
(A) a polymer having a repeating unit represented by the following general formula (1);
(B) a resin for forming an organic film; and
(C) a solvent, 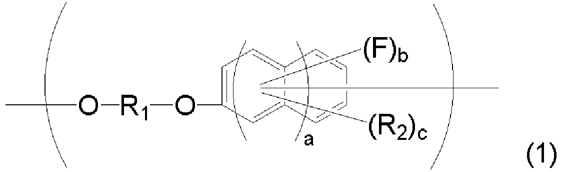 wherein R₁ represents a divalent organic group having 2 to 30 carbon atoms including an aliphatic moiety or an aromatic moiety, each R₂ independently represents a hydrogen atom, an alkyl group having 1 to 6 carbon atoms, a hydroxy group, an alkoxy group having 1 to 6 carbon atoms, a halogen atom other than a fluorine atom, a cyano group, an amino group, or a nitro group, and "a" represents 0 or 1, "b" representing 1 to 4 and "c" representing 0 to 3 when "a" is 0, or "b" representing 1 to 6 and "c" representing 0 to 5 when "a" is 1.

2. The composition for forming an organic film according to claim 1, wherein the polymer (A) contains one or more compounds represented by any of the following general formulae (2) to (4), 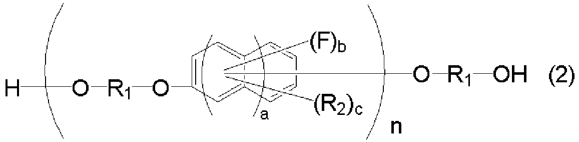 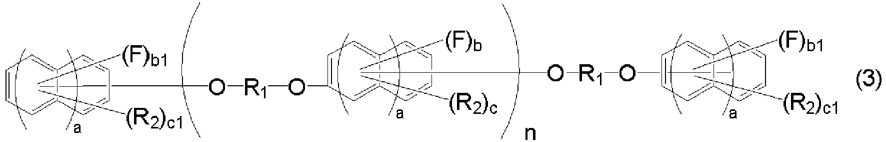 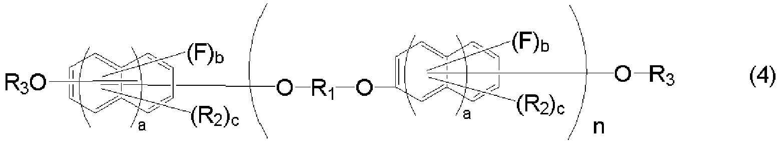 wherein R₁ and R₂ are as defined above; R₃ represents a monovalent organic group having 1 to 30 carbon atoms; "a" represents 0 or 1; "b" representing 1 to 4, "b1" representing 1 to 5, "c" representing 0 to 3, and "c1" representing 0 to 4 when "a" is 0, or "b" representing 1 to 6, "b1" representing 1 to 7, "c" representing 0 to 5, and "c1" representing 0 to 6 when "a" is 1; and "n" represents an average repeating unit number of 3 to 2,000.

3. The composition for forming an organic film according to claim 1 or 2, wherein the polymer (A) is contained in an amount of 0.01 parts by mass to 5 parts by mass based on 100 parts by mass of the resin (B) for forming an organic film.

4. A method for forming an organic film to be used in a manufacturing process of a semiconductor device, the method comprising:
spin-coating a substrate to be processed with the composition for forming an organic film according to any one of claims 1 to 3 to obtain a coating film; and
forming an organic film by heating the coating film at a temperature of 100°C or higher and 600°C or lower for 10 to 600 seconds to cure the coating film.

5. A patterning process comprising:
forming an organic film on a body to be processed by using the composition for forming an organic film according to any one of claims 1 to 3;
forming a silicon-containing resist middle layer film on the organic film by using a silicon-containing resist middle layer film material;
forming a resist upper layer film on the silicon-containing resist middle layer film by using a resist upper layer film material comprising a photoresist composition;
forming a circuit pattern in the resist upper layer film;
transferring the pattern to the silicon-containing resist middle layer film by etching while using the resist upper layer film having the formed circuit pattern as a mask;
transferring the pattern to the organic film by etching while using the silicon-containing resist middle layer film having the transferred pattern as a mask; and
further forming the pattern in the body to be processed by etching while using the organic film having the transferred pattern as a mask.

6. A patterning process comprising:
forming an organic film on a body to be processed by using the composition for forming an organic film according to any one of claims 1 to 3;
forming a silicon-containing resist middle layer film on the organic film by using a silicon-containing resist middle layer film material;
forming an organic antireflective film or an adhesive film on the silicon-containing resist middle layer film;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and to the silicon-containing resist middle layer film by etching while using the resist upper layer film having the formed circuit pattern as a mask;
transferring the pattern to the organic film by etching while using the silicon-containing resist middle layer film having the transferred pattern as a mask; and
further forming the pattern in the body to be processed by etching while using the organic film having the transferred pattern as a mask.

7. A patterning process comprising:
forming an organic film on a body to be processed by using the composition for forming an organic film according to any one of claims 1 to 3;
forming an inorganic hard mask middle layer film selected from the group consisting of a silicon oxide film, a silicon nitride film, and a silicon oxynitride film on the organic film;
forming a resist upper layer film on the inorganic hard mask middle layer film by using a resist upper layer film material comprising a photoresist composition;
forming a circuit pattern in the resist upper layer film;
transferring the pattern to the inorganic hard mask middle layer film by etching while using the resist upper layer film having the formed circuit pattern as a mask;
transferring the pattern to the organic film by etching while using the inorganic hard mask middle layer film having the transferred pattern as a mask; and
further forming the pattern in the body to be processed by etching while using the organic film having the transferred pattern as a mask.

8. A patterning process comprising:
forming an organic film on a body to be processed by using the composition for forming an organic film according to any one of claims 1 to 3;
forming an inorganic hard mask middle layer film selected from the group consisting of a silicon oxide film, a silicon nitride film, and a silicon oxynitride film on the organic film;
forming an organic antireflective film or an adhesive film on the inorganic hard mask middle layer film;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and to the inorganic hard mask middle layer film by etching while using the resist upper layer film having the formed circuit pattern as a mask;
transferring the pattern to the organic film by etching while using the inorganic hard mask middle layer film having the transferred pattern as a mask; and
further forming the pattern in the body to be processed by etching while using the organic film having the transferred pattern as a mask.

9. The patterning process according to claim 7 or 8, wherein the inorganic hard mask middle layer film is formed by a CVD method or an ALD method.

10. The patterning process according to any one of claims 5 to 9, wherein the circuit pattern is formed by a lithography using light having a wavelength of 10 nm or more and 300 nm or less, a direct writing with electron beam, nanoimprinting, or a combination thereof.

11. The patterning process according to any one of claims 5 to 10, wherein the circuit pattern is developed with an alkaline development or an organic solvent.

12. The patterning process according to any one of claims 5 to 11, wherein the body to be processed is a semiconductor device substrate or the semiconductor device substrate coated with any of a metal film, a metal carbide film, a metal oxide film, a metal nitride film, a metal oxycarbide film, and a metal oxynitride film.

13. The patterning process according to claim 12, wherein the metal constituting the body to be processed contains silicon, titanium, tungsten, hafnium, zirconium, chromium, germanium, copper, silver, gold, aluminum, indium, gallium, arsenic, palladium, iron, tantalum, iridium, molybdenum, or an alloy thereof.
